# EUROPEAN PATENT APPLICATION

(11) **EP 3 846 199 A1**
(43) Date of publication of application: **07.07.2021**
(21) Application number: 19853759.9
(22) Date of filing: 23.08.2019
(51) Int. Cl.: H01L 21/768, G09F 9/30, H01L 21/3205, H01L 23/522, H01L 29/786

(54) **THIN FILM TRANSISTOR ARRAY**

(30) Priority: 30.08.2018 JP 2018161979
(71) Applicant: Toppan Printing Co., Ltd., Tokyo 110-0016 (JP)
(72) Inventor: ISHIZAKI, Mamoru, (JP); MOROSAWA, Katsuhiko, (JP)
(74) Representative: Plasseraud IP
(86) International application number: PCT/JP2019/033101
(87) International publication number: WO 2020/045297

(57) **Abstract**

The present invention provides a thin film transistor array with reduced power consumption. The thin film transistor array includes column wirings, row wirings, capacitor wirings, and a plurality of pixels arranged in a matrix in a first and second directions and including respective thin film transistors and other components. The plurality of pixels form an M column by N row effective region. The thin film transistors include source electrodes connected to the column wirings, gate electrodes connected to the row wirings, drain electrodes connected to pixel electrodes, and capacitor electrodes connected to the capacitor wirings. Each row wiring has a length extending across M pixels arranged in the second direction, while each column wiring has a length extending across N/2 pixels arranged in the first direction, and each capacitor wiring has a length extending across N pixels arranged in the first direction.

## Description

### [Technical Field]

The present invention relates to thin film transistor arrays. The thin film transistor arrays according to the present invention can be used in display devices. Furthermore, the thin film transistor arrays according to the present invention are suitable for low power consumption applications.

### [Background Art]

Transistors using semiconductor substrates, or amorphous silicon (a-Si) or polysilicon (poly-Si) thin film transistor (TFT) arrays using glass substrates based on integrated circuit technology have been produced for application to liquid crystal displays or other displays. TFTs serve as switches. Specifically, when a TFT is turned on by a selected voltage applied to a row wiring (gate wiring), a signal voltage provided to a column wiring (source wiring) is written into a pixel electrode connected to the drain electrode. The write voltage is held by a storage capacitor provided between the drain electrode or the pixel electrode and a capacitor electrode. (In the case of TFT arrays, since the source and the drain are interchangeable depending on the polarity of a write voltage, the names "source" and "drain" cannot be assigned to electrodes based on functions thereof. Therefore, for the sake of convenience, one is described as source, while the other is described as drain. In the present invention, an electrode connected to a wiring is termed a source, and one connected to a pixel electrode is termed a drain.)

Technical development of TFT arrays has occurred along with development of liquid crystal displays using liquid crystal as a display medium. In recent years, electronic paper displays have been developed by combining thin film transistor arrays with electrophoretic media, and are expected to serve as display devices with lower power consumption than liquid crystal displays. This is because such electrophoretic type electronic paper retains a display even after driving is competed and there is no need for continuous driving, whereas generally used liquid crystal displays can display data only while being driven and thus are required to be driven continuously to retain the displayed data.

Furthermore, there has been proposed a technique in which electronic paper is combined with RFID, that is an object recognition technique, to provide displays on containers (PTL 1). By displaying the content stored in the RFID device on a display, the data can be visually recognized.

### [Citation List]

### [Patent Literature]

PTL 1: JP 2003-233786 A

### [Summary of the invention]

### [Technical Problem]

Such display devices can be categorized into a type that rewrites data using power from an integral battery, and a type that rewrites data by converting radio waves, from the reader/writer that rewrites data in the RFID device, into electrical power and using the converted electrical power. Either of these types has an issue of reducing power consumption during rewriting. In the case of display devices incorporating batteries, the batteries are required to be frequently changed if power consumption is high. In the case of display devices using electrical power from RF waves, if power consumption is high, rewriting can be performed only in a short range where the radio wave intensity is high.

The present invention has been made in light of the circumstances of the conventional art and aims to provide a thin film transistor array with reduced power consumption.

### [Solution to problem]

An aspect of the present invention for solving the above issues is a thin film transistor array comprising: an insulating substrate; a plurality of column wirings extending in a first direction on the insulating substrate, a plurality of row wirings extending in a second direction that is perpendicular to the first direction, and a plurality of capacitor wirings extending in the first direction; and a plurality of pixels arranged in a matrix in the first direction and the second direction, the pixels including respective thin film transistors, pixel electrodes, and capacitor electrodes. In the thin film transistor array, the plurality of pixels form a rectangular effective region of an M column by N row (M and M are natural numbers) matrix structure in which N pixels are arranged in the first direction and M pixels are arranged in the second direction; the thin film transistors include respective gate electrodes, source electrodes, and drain electrodes; the source electrodes are connected to respective the column wirings; the gate electrodes are connected to the respective row wirings; the pixel electrodes are connected to the respective pixel electrodes; the capacitor electrodes are connected to the respective capacitor wirings; the row wirings each have a length extending across the M pixels arranged in the second direction in the effective region; the column wirings each have a length extending across the N/2 pixels arranged in the first direction in the effective region; and the capacitor wirings each have a length extending across the N pixels arranged in the first direction in the effective region, the length being different from the length of each of the column wirings.

### [Advantageous Effects of the Invention]

According to the present invention, there is provided a thin film transistor array with reduced power consumption. Specifically, by applying the present invention to display devices, power consumption can be reduced when rewriting data in the display devices, and the frequency of battery replacement can be reduced in display devices having integral batteries. Furthermore, the range at which data in display devices of the type converting RF waves into electrical power can be rewritten can be increased.

### [Brief Description of the Drawings]

Fig. 1A is a plan view illustrating an example of a thin film transistor array according to a first embodiment of the present invention.
Fig. 1B is a plan view illustrating an example of a thin film transistor array according to the first embodiment of the present invention.
Fig. 2A is a plan view illustrating an example of a thin film transistor array according to a second embodiment of the present invention.
Fig. 2B is a plan view illustrating an example of a thin film transistor array according to the second embodiment of the present invention.
Fig. 3A is a plan view illustrating an example of a thin film transistor array according to a third embodiment of the present invention.
Fig. 3B is a plan view illustrating an example of a thin film transistor array according to the third embodiment of the present invention.
Fig. 4A is a cross-sectional view illustrating an example of electrostatic capacitance between electrodes.
Fig. 4B is a cross-sectional view illustrating an example of electrostatic capacitance between electrodes.
Fig. 4C is a cross-sectional view illustrating an example of electrostatic capacitance between electrodes.
Fig. 4D is a cross-sectional view illustrating an example of electrostatic capacitance between electrodes.
Fig. 5A is a plan view illustrating an example of power supply to a thin film transistor array according to the first embodiment.
Fig. 5B is a plan view illustrating an example of power supply to a thin film transistor array according to the first embodiment.
Fig. 5C is a plan view illustrating an example of power supply to a thin film transistor array according to the first embodiment.
Fig. 5D is a plan view illustrating an example of power supply to a thin film transistor array according to the first embodiment.
Fig. 6 is a set of diagrams including plan and cross-sectional views illustrating a manufacturing process of a thin film transistor array according to the first embodiment.
Fig. 7 is a set of diagrams including plan and cross-sectional views illustrating a manufacturing process of a thin film transistor array according to the first embodiment.
Fig. 8 is a set of diagrams including plan and cross-sectional views illustrating a manufacturing process of a thin film transistor array according to the first embodiment.
Fig. 9 is a set of diagrams including plan and cross-sectional views illustrating a manufacturing process of a thin film transistor array according to the first embodiment.
Fig. 10 is a set of diagrams including plan and cross-sectional views illustrating a manufacturing process of a thin film transistor array according to the first embodiment.
Fig. 11 is a set of diagrams including plan and cross-sectional views illustrating a manufacturing process of a thin film transistor array according to the first embodiment.
Fig. 12 is a set of diagrams including plan and cross-sectional views illustrating a manufacturing process of a thin film transistor array according to the first embodiment.
Fig. 13 is a set of diagrams including plan and cross-sectional views illustrating a manufacturing process of a thin film transistor array according to the first embodiment.
Fig. 14 is a set of diagrams including plan and cross-sectional views illustrating a manufacturing process of a thin film transistor array according to the first embodiment.
Fig. 15 is a set of diagrams including plan and cross-sectional views illustrating a manufacturing process of a thin film transistor array according to the first embodiment.
Fig. 16 is a set of diagrams including plan and cross-sectional views illustrating a manufacturing process of a thin film transistor array according to the first embodiment.
Fig. 17 is a set of diagrams including plan and cross-sectional views illustrating a manufacturing process of a thin film transistor array according to the first embodiment.
Fig. 18 is a set of diagrams including plan and cross-sectional views illustrating a manufacturing process of a thin film transistor array according to the first embodiment.
Fig. 19 is a set of diagrams including plan and cross-sectional views illustrating a manufacturing process of a thin film transistor array according to the first embodiment.
Fig. 20 is a set of diagrams including plan and cross-sectional views illustrating a manufacturing process of a thin film transistor array according to the first embodiment.
Fig. 21 is a set of diagrams including plan and cross-sectional views illustrating a manufacturing process of a thin film transistor array according to the first embodiment.
Fig. 22 is a set of diagrams including plan and cross-sectional views illustrating a manufacturing process of a thin film transistor array according to the first embodiment.
Fig. 23 is a set of diagrams including plan and cross-sectional views illustrating a manufacturing process of a thin film transistor array according to the first embodiment.
Fig. 24 is a set of diagrams including plan and cross-sectional views illustrating a manufacturing process of a thin film transistor array according to the first embodiment.
Fig. 25 is a set of diagrams including plan and cross-sectional views illustrating a manufacturing process of a thin film transistor array according to the first embodiment.
Fig. 26 is a set of diagrams including plan and cross-sectional views illustrating a manufacturing process of a thin film transistor array according to the first embodiment.
Fig. 27A is a plan view illustrating an example of power supply to a thin film transistor array according to the second embodiment.
Fig. 27B is a plan view illustrating an example of power supply to a thin film transistor array according to the second embodiment.
Fig. 27C is a plan view illustrating an example of power supply to a thin film transistor array according to the second embodiment.
Fig. 27D is a plan view illustrating an example of power supply to a thin film transistor array according to the second embodiment.
Fig. 28 is a set of diagrams including plan and cross-sectional views illustrating a manufacturing process of a thin film transistor array according to the second embodiment.
Fig. 29 is a set of diagrams including plan and cross-sectional views illustrating a manufacturing process of a thin film transistor array according to the second embodiment.
Fig. 30A is a plan view illustrating an example of power supply to a thin film transistor array according to the third embodiment.
Fig. 30B is a plan view illustrating an example of power supply to a thin film transistor array according to the third embodiment.
Fig. 30C is a plan view illustrating an example of power supply to a thin film transistor array according to the third embodiment.
Fig. 30D is a plan view illustrating an example of power supply to a thin film transistor array according to the third embodiment.
Fig. 31 is a set of diagrams including plan and cross-sectional views illustrating a manufacturing process of a thin film transistor array according to the third embodiment.
Fig. 32 is a set of diagrams including plan and cross-sectional views illustrating a manufacturing process of a thin film transistor array according to the third embodiment.
Fig. 33 is a diagram illustrating calculation of voltage waveforms, current waveforms and electrical energy in column wirings.
Fig. 34 is a diagram illustrating calculation of voltage waveforms, current waveforms and electrical energy in row wirings.
Fig. 35 is a diagram illustrating calculation of voltage waveforms, current waveforms and electrical energy in a pixel TFT.
Fig. 36 is a plan view illustrating an example of a thin film transistor array according to conventional art.
Fig. 37 is a plan view illustrating an example of power supply to thin film transistors illustrated in Fig 36.
Fig. 38 is a plan view illustrating an example of a thin film transistor array according to conventional art.
Fig. 39 is a plan view illustrating an example of power supply to thin film transistors illustrated in Fig 38.

### [Description of the Embodiments]

Referring to the drawings, some embodiments of the present invention will be described in detail. For ease of understanding, the figures referred to in the following description are not to scale. The same or corresponding components between the embodiments are designated using the same reference signs to omit unnecessary explanation.

### (Basic configurations of first to third embodiments)

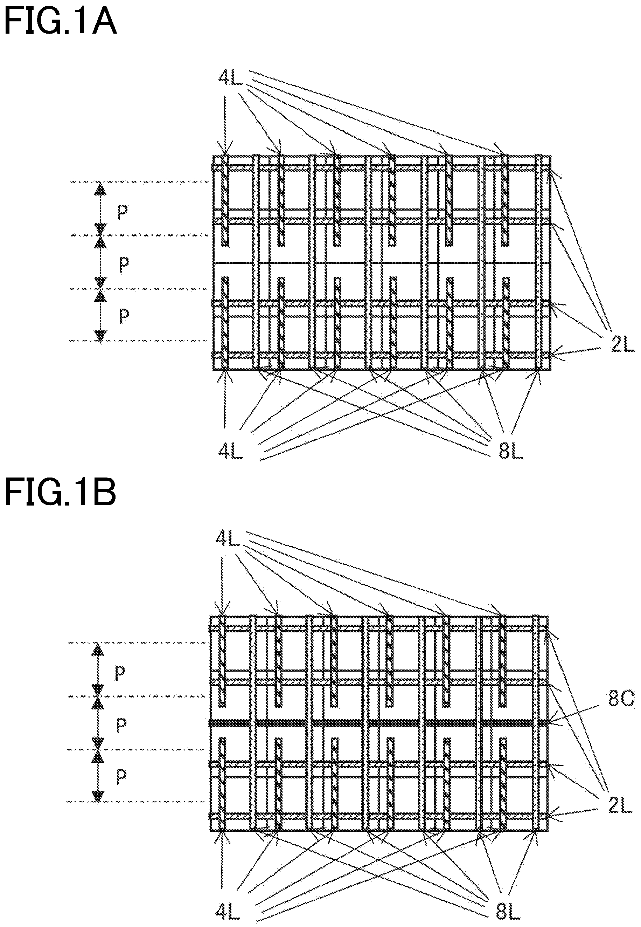

Figs. 1A, 2A and 3A show basic configurations of thin film transistor arrays according to the first to third embodiments of the present invention. As shown in Figs. 1A, 2A and 3A, a thin film transistor array includes an insulating substrate 1 (not shown), a plurality of column wirings 4L extending in the longitudinal direction (first direction) on the insulating substrate 1 as viewed in the figure, a plurality of row wirings 2L extending in the lateral direction (second direction) perpendicular to the longitudinal direction as viewed in the figure, a plurality of capacitor wirings 8L extending in the longitudinal direction, and a plurality of pixels (locations of the pixels are indicated by squares but the pixels are not shown) arranged in a matrix in the longitudinal and lateral directions. The plurality of pixels are disposed in a rectangular effective region having an M column by N row (M and N are natural numbers) matrix structure in which N pixels are arranged in the longitudinal direction and M pixels are arranged in the lateral direction.

Although not shown in Fig. 1A, 2A or 3A, each pixel includes a thin film transistor, a pixel electrode 10, and a capacitor electrode 8. The thin film transistor includes a gate electrode 2, a source electrode 4, a drain electrode 5, and a semiconductor pattern 6 between the source electrode 4 and the drain electrode 5. The semiconductor pattern 6 has an overlap with the gate electrode 2 with a gate insulating film 3 sandwiched therebetween. The capacitor electrode 8 and the corresponding pixel electrode 10 have an electrostatic capacitance therebetween. The source electrode 4 is connected to the corresponding column wiring 4L, the gate electrode 2 is connected to the corresponding row wiring 2L, the drain electrode 5 is connected to the corresponding pixel 10, and the capacitor electrode 8 is connected to the corresponding capacitor wiring 8L. Although the details will be described later, these electrodes and wirings are laminated with each other, with a plurality of insulating films sandwiched therebetween.

Figs. 1A, 2A and 3A show the planar arrangement of the row wirings 2L, the column wirings 4L, and the capacitor wirings 8L, together with the length of these wirings. Each row wiring 2L has a length extending across M pixels arranged in the lateral direction in the effective region. Each column wiring 4L has a length extending across N/2 pixels arranged in the longitudinal direction in the effective region. Each capacitor wiring 8L has a length extending across N pixels arranged in the longitudinal direction in the effective region. The positions of the row wirings 2L, the column wirings 4L, and the capacitor wirings 8L in the lamination direction are arbitrarily determined. Specifically, in Fig. 1A, 2A or 3A, the column wirings 4L and the capacitor wirings 8L are illustrated as being layers above the row wirings 2L. However, these wirings may be located otherwise. It should be noted that, in the following, the upper half area and the lower half area of the display surface may also be respectively termed an upper area and a lower area. Also, the row wirings 2L and the column wirings 4L formed in the upper area and the lower area may also be termed upper area row wirings 2L, lower area row wirings 2L, upper area column wirings 4L, and lower area column wirings 4L.

As shown in Fig. 1A, in a thin film transistor array according to the first embodiment, the column wirings 4L are provided at a ratio of one per column of N/2 pixels arranged in the longitudinal direction. Thus, M column wirings 4L are arranged in each of the two areas, totaling 2M in the entire effective region. Also, the row wirings 2L are provided at a ratio of one per row of M pixels arranged in the lateral direction. Thus, N/2 row wirings 2L are arranged in each of the two areas, totaling N in the entire effective region. Furthermore, the capacitor wirings 8L are arranged at a ratio of one per column of N pixels arranged in the longitudinal direction. Thus, M capacitor wirings 8L are provided in the entire effective region.

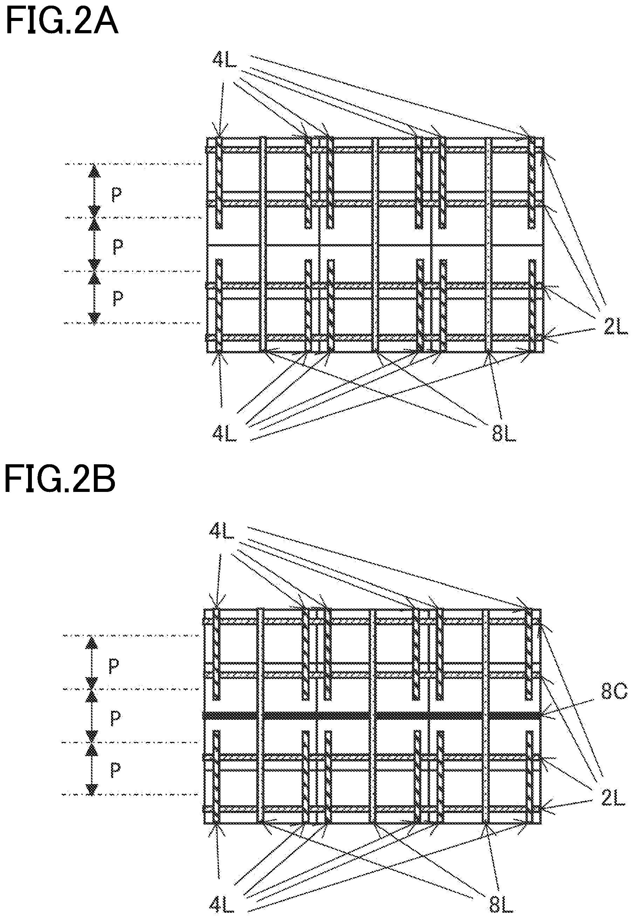

As shown in Fig. 2A, in a thin film transistor array according to the second embodiment, the column wirings 4L are arranged at a ratio of one per column of N/2 pixels arranged in the longitudinal direction. Thus, M column wirings 4L are arranged in each of the two areas, totaling 2M in the entire effective region. Also, the row wirings 2L are provided at a ratio of one per row of M pixels arranged in the lateral direction. Thus, N/2 row wirings 2L are arranged in each of the two areas, totaling N in the entire effective region. Furthermore, the capacitor wirings 8L are arranged at a ratio of one per two columns of N pixels arranged in the longitudinal direction. Thus, M/2 capacitor wirings 8L are provided in the entire effective region.

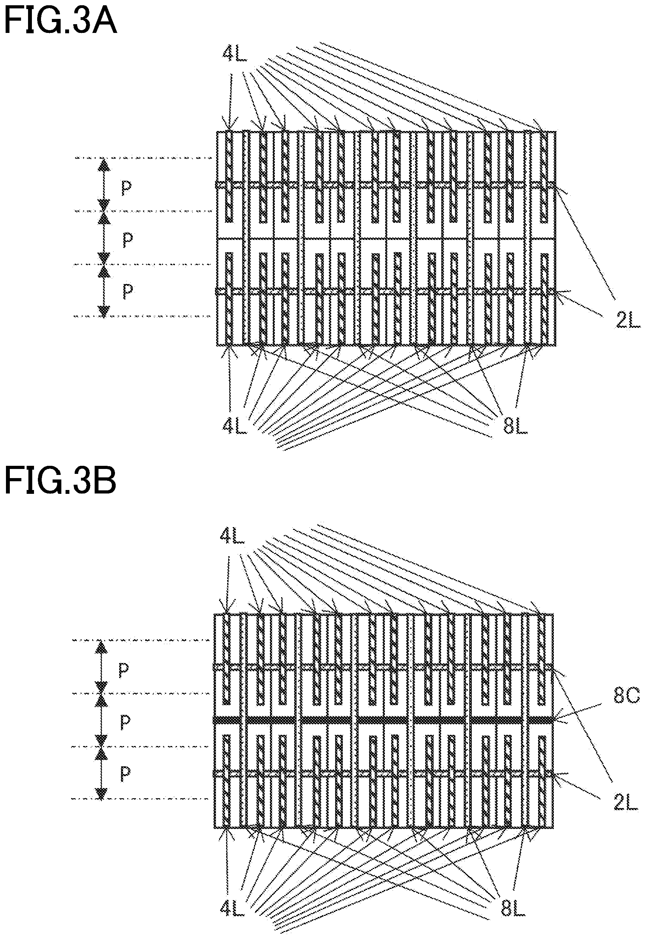

As shown in Fig. 3A, in a thin film transistor array according to the third embodiment, the column wirings 4L are arranged at a ratio of two per column of N/2 pixels arranged in the longitudinal direction. Thus, 2M column wirings 4L are provided to each of the two areas, totaling 4M in the entire effective region. Also, the row wirings 2L are arranged at a ratio of one per two rows of M pixels arranged in the lateral direction. Thus, N/4 row wirings 2L are arranged in each of the two areas, totaling N/2 in the entire effective region. Furthermore, the capacitor wirings 8L are arranged at a ratio of one per column of N pixels arranged in the longitudinal direction. Thus, M capacitor wirings 8L are provided in the entire effective region.

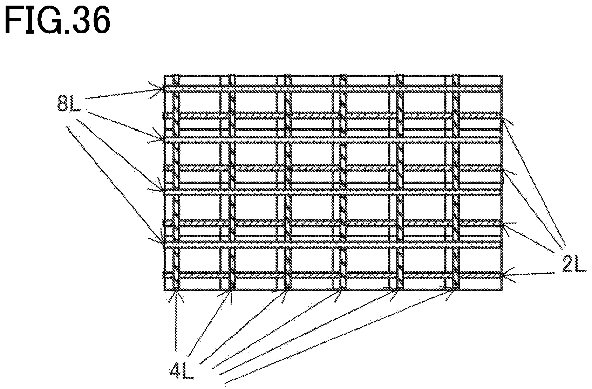

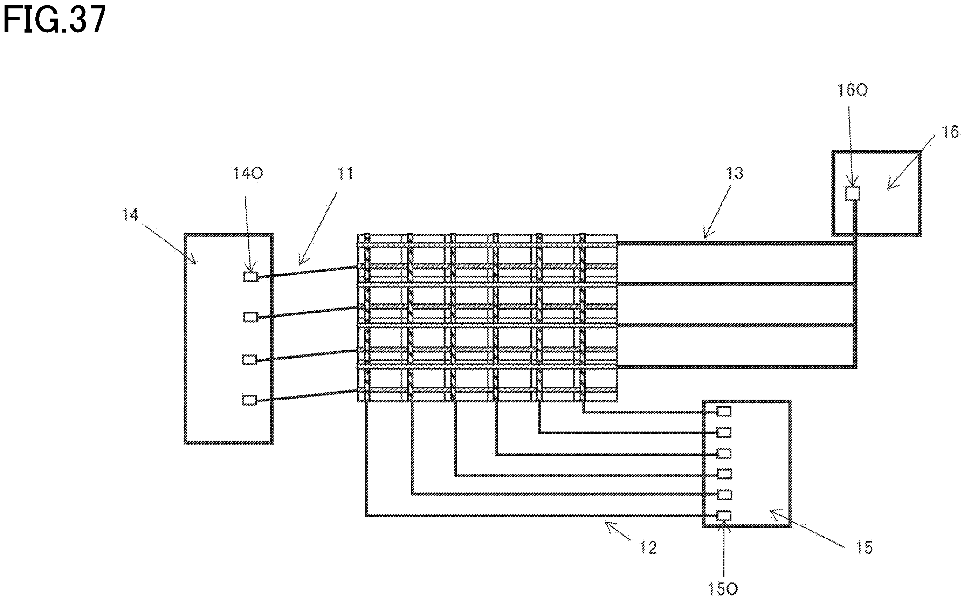

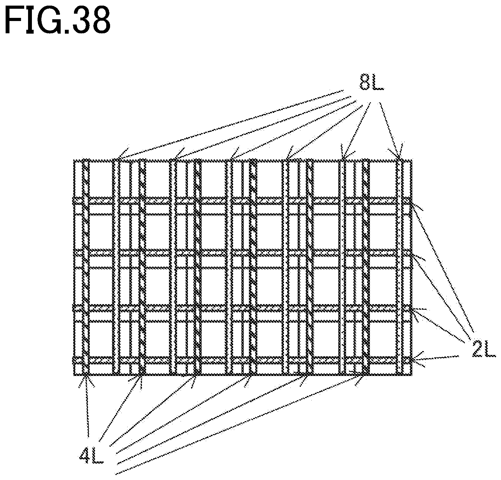

Figs. 36 and 38 each show a basic configuration of a thin film transistor array based on conventional art. The thin film transistor array shown in Fig. 36 includes column wirings 4L extending in the longitudinal direction, row wirings 2L extending in the lateral direction, and capacitor wirings 8L extending in the lateral direction. Each row wiring 2L has a length equivalent to the length of all the pixels in one row in the lateral direction of the effective region, each column wiring 4L has a length equivalent to the length of all the pixels in one column in the longitudinal direction of the effective region, and each capacitor wiring 8L has a length equivalent to the length of all the pixels in one row in the lateral direction in the effective region. Fig. 37 shows feed lines to the thin film transistor array shown in Fig. 36. Gate feed lines 11 are connected to the left ends of the respective row wirings 2L. Source feed lines 12 are connected to the lower ends of the respective column wirings 4L. Capacitor feed lines 13 are connected to the right ends of the respective capacitor wirings 8L.

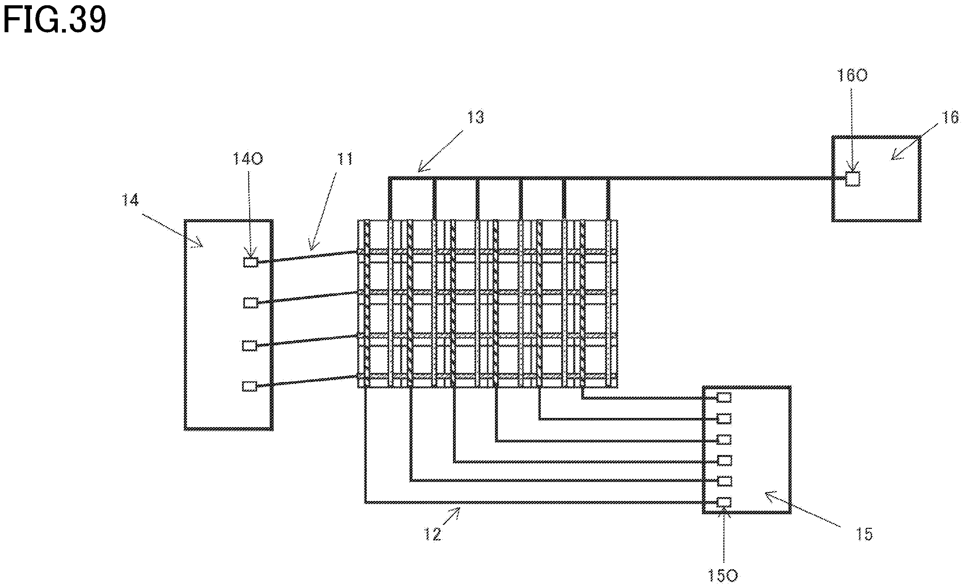

The thin film transistor array shown in Fig. 38 includes column wirings 4L extending in the longitudinal direction, row wirings 2L extending in the lateral direction, and capacitor wirings 8L extending in the longitudinal direction. Each row wiring 2L has a length equivalent to the length of all the pixels in one row in the lateral direction of the effective region, each column wiring 4L has a length equivalent to the length of all the pixels in one column in the longitudinal direction of the effective region, and each capacitor wiring 8L has a length equivalent to the length of all the pixels in in one column the longitudinal direction in the effective region. Fig. 39 shows feed lines to the thin film transistor array shown in Fig. 38. Gate feed lines 11 are connected to the left ends of the respective row wirings 2L, source feed lines 12 are connected to the lower ends of the respective column wirings 4L, and capacitor feed lines 13 are connected to the upper ends of the respective capacitor wirings 8L.

Thus, the row wirings 2L necessarily have intersections with the column wirings 4L, while the capacitor wirings 8L have intersections at least with the row wirings 2L or the column wirings 4L. The intersections have an electrostatic capacitance that depends on the overlap area between wirings, and the thickness and dielectric constant of the insulating film. Let Cgsl be the capacitance between row wiring and column wiring, Cgc be the capacitance between row wiring and capacitor wiring, and Csc be the capacitance between column wiring and capacitor wiring.

If most of the row wirings 2L and the column wirings 4L are covered with the pixel electrodes 10, the potential of the row wirings 2L and the column wirings 4L is prevented from directly affecting data displayed. However, the electrostatic capacitance between the row wirings 2L or the column wirings 4L and the pixel electrodes 10 cannot be ignored. Let Cgp be the capacitance between row wiring and pixel electrode, and Csp be the capacitance between column wiring and pixel electrode.

Each TFT includes a semiconductor pattern 6 between the source electrode 4 and the drain electrode 5. The semiconductor pattern 6 has an overlap with the gate electrode 2 with a gate insulating film 3 sandwiched therebetween. Part of the source electrode 4 or the drain electrode 5 also has an overlap with the gate electrode 2. Therefore, in principle, each TFT has a gate electrode - source electrode capacitance Cgs, and a gate electrode - drain electrode capacitance Cgd. Furthermore, there is electrostatic capacitance Cs between the capacitor electrode 8 and the corresponding pixel electrode 10.

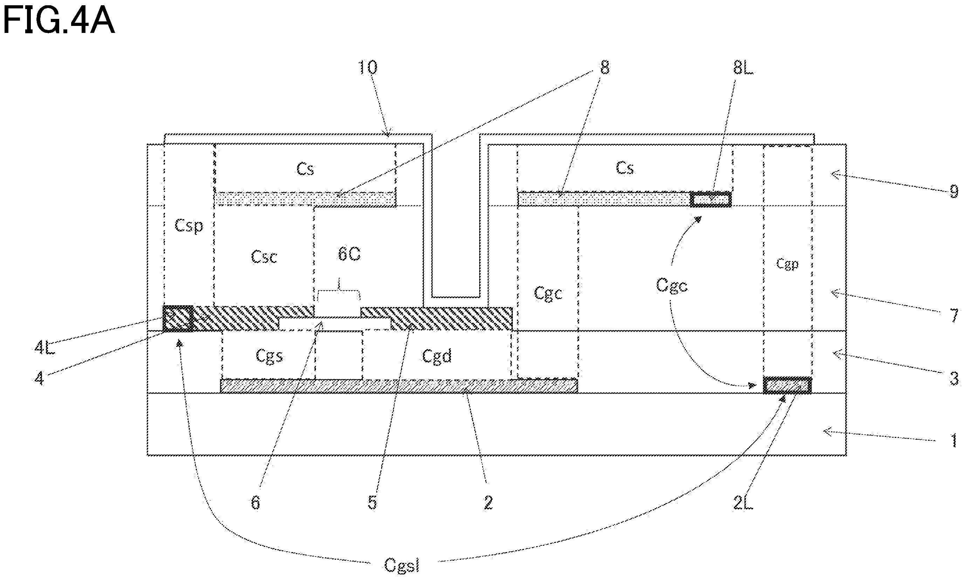

Fig. 4A is a cross-sectional view illustrating an example of a thin film transistor configuring a thin film transistor array according to the first to third embodiments of the present invention. The TFT shown in Fig. 4A includes an insulating substrate 1 on which a first electrically conductive layer, a gate insulating film 3, a second electrically conductive layer, an interlayer insulating film 7, a third electrically conductive layer, a capacitor insulating film 9, and a fourth electrically conductive layer are provided in this order. The first electrically conductive layer includes a gate electrode 2 and a row wiring 2L. The second electrically conductive layer includes a source electrode 4, a column wiring 4L, and a drain electrode 5. The third electrically conductive layer includes a capacitor electrode 8, and a capacitor wiring 8L. The fourth electrically conductive layer includes a pixel electrode 10.

Fig. 4A schematically shows regions where electrostatic capacitance occurs between wirings and electrodes (row wiring - column wiring capacitance Cgsl, row wiring - capacitor wiring capacitance Cgc, column wiring - capacitor wiring capacitance Csc, row wiring - pixel electrode capacitance Cgp, column wiring - pixel electrode capacitance Csp, gate electrode - source electrode capacitance Cgs, gate electrode - drain electrode capacitance Cgd, and storage capacitance Cs). (Due to the lack of overlap in the cross-section, Cgsl and Cgc are indicated by arrows.) When the TFT is in an on state (during calculation of a gate feedthrough voltage), Cgs is calculated by adding about half the area of a channel 6C to the overlap area between the gate electrode 2 and the source electrode 4, while Cgd is calculated by adding about half the area of the channel 6C to the overlap area between the gate electrode 2 and the drain electrode 5. When the TFT is in an off state (during calculation of parasite capacitance), only the overlap area between the gate electrode 2 and the source electrode 4 affects Cgs, while only the overlap area between the gate electrode 2 and the drain electrode 5 affects Cgd. Cs is defined by pixel electrode 10 / capacitor insulating film 9 / capacitor electrode 8.

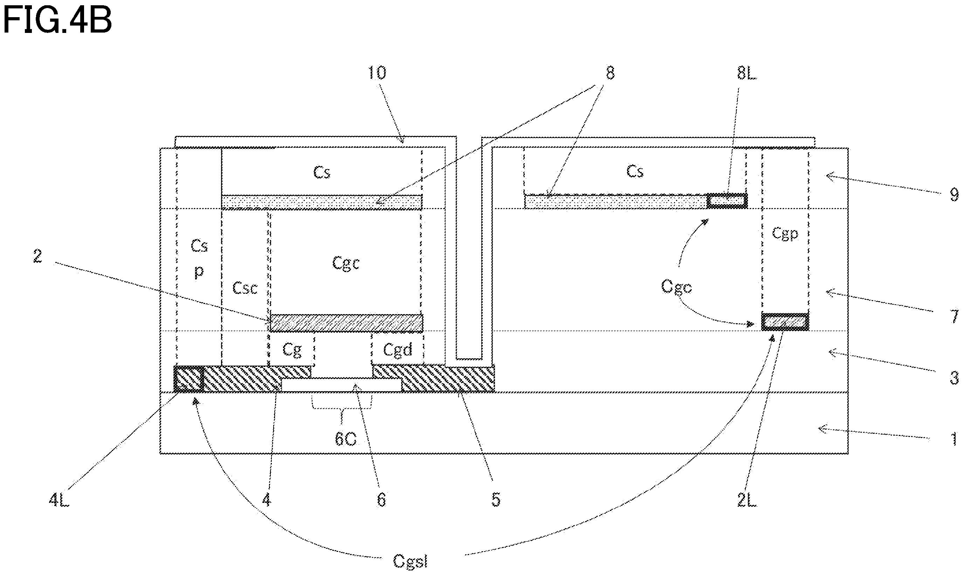

Fig. 4B is a cross-sectional view illustrating an example of a thin film transistor configuring a thin film transistor array according to the first to third embodiments of the present invention. The TFT shown in Fig. 4B includes an insulating substrate 1 on which a first electrically conductive layer, a gate insulating film 3, a second electrically conductive layer, an interlayer insulating film 7, a third electrically conductive layer, a capacitor insulating film 9, and a fourth electrically conductive layer are provided in this order. The first electrically conductive layer includes a source electrode 4, a column wiring 4L, and a drain electrode 5. The second electrically conductive layer includes a gate electrode 2, and a row wiring 2L. The third electrically conductive layer includes a capacitor electrode 8, and a capacitor wiring 8L. The fourth electrically conductive layer includes a pixel electrode 10.

Fig. 4B schematically shows regions where electrostatic capacitance occurs between wirings and electrodes (row wiring - column wiring capacitance Cgsl, row wiring - capacitor wiring capacitance Cgc, column wiring - capacitor wiring capacitance Csc, row wiring - pixel electrode capacitance Cgp, column wiring - pixel electrode capacitance Csp, gate electrode - source electrode capacitance Cgs, gate electrode - drain electrode capacitance Cgd, and storage capacitance Cs). (Due to the lack of overlap in the cross-section, Cgsl and Cgc are indicated by arrows.) When the TFT is in an on state (during calculation of a gate feedthrough voltage), Cgs is calculated by adding about half the area of a channel 6C to the overlap area between the gate electrode 2 and the source electrode 4, while Cgd is calculated by adding about half the area of the channel 6C to the overlap area between the gate electrode 2 and the drain electrode 5. When the TFT is in an off state (during calculation of parasite capacitance), only the overlap area between the gate electrode 2 and the source electrode 4 affects Cgs, while only the overlap area between the gate electrode 2 and the drain electrode 5 affects Cgd. Cs is defined by pixel electrode 10 / capacitor insulating film 9 / capacitor electrode 8.

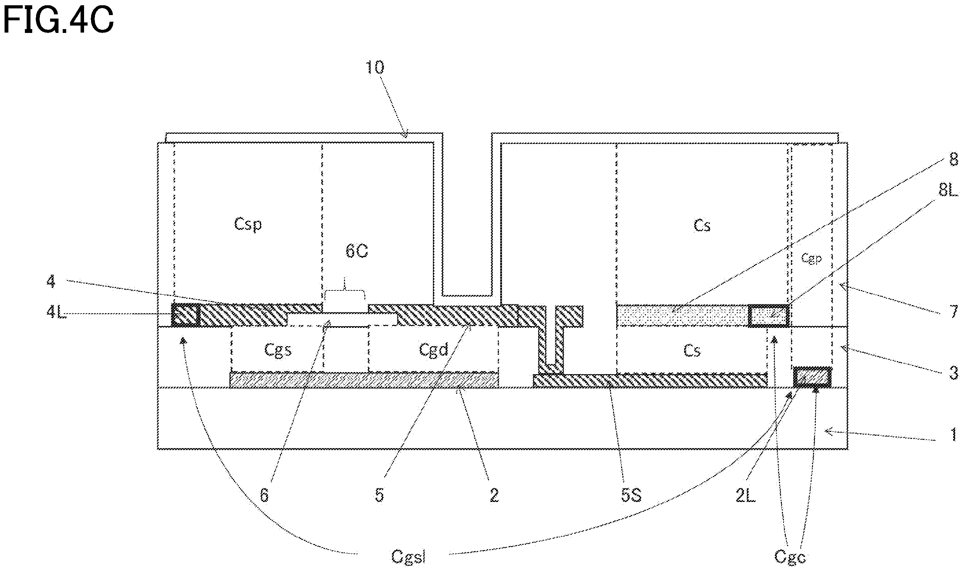

Fig. 4C is a cross-sectional view illustrating an example of a thin film transistor configuring a thin film transistor array according to the first to third embodiments of the present invention. The TFT shown in Fig. 4C includes an insulating substrate 1 on which a first electrically conductive layer, a gate insulating film 3, a second electrically conductive layer, an interlayer insulating film 7, and a third electrically conductive layer are provided in this order. The first electrically conductive layer includes a gate electrode 2, a row wiring 2L, and a drain sub-electrode 5S. The second electrically conductive layer includes a source electrode 4, a column wiring 4L, a drain electrode 5, a capacitor electrode 8, and a capacitor wiring 8L. The third electrically conductive layer includes a pixel electrode 10.

Fig. 4C schematically shows regions where electrostatic capacitance occurs between wirings and electrodes (row wiring - column wiring capacitance Cgsl, row wiring - capacitor wiring capacitance Cgc, row wiring - pixel electrode capacitance Cgp, column wiring - pixel electrode capacitance Csp, gate electrode - source electrode capacitance Cgs, gate electrode - drain electrode capacitance Cgd, and storage capacitance Cs). (Due to the lack of overlap in the cross-section, Cgsl and Cgc are indicated by arrows. Csc having no corresponding overlap is substantially 0.) When the TFT is in an on state (during calculation of a gate feedthrough voltage), Cgs is calculated by adding about half the area of a channel 6C to the overlap area between the gate electrode 2 and the source electrode 4, while Cgd is calculated by adding about half the area of the channel 6C to the overlap area between the gate electrode 2 and the drain electrode 5. When the TFT is in an off state (during calculation of parasite capacitance), only the overlap area between the gate electrode 2 and the source electrode 4 affects Cgs, while only the overlap area between the gate electrode 2 and the drain electrode 5 affects Cgd. Cs is mainly defined by the capacitor electrode 8 / gate insulating film 3 / drain sub-electrode 5S, however, Cs defined by the pixel electrode 10 / interlayer insulating film 7 / capacitor electrode 8 is also added.

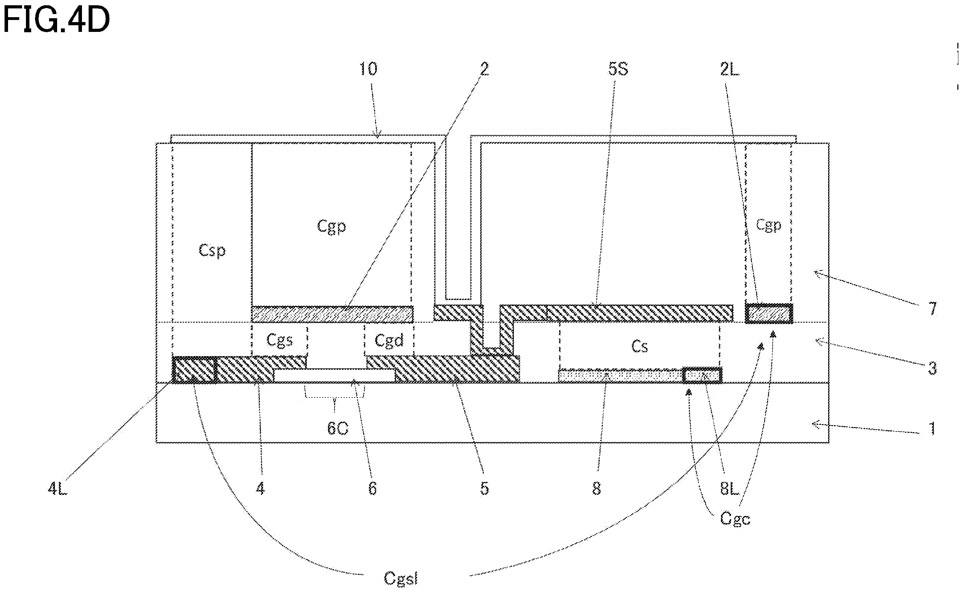

Fig. 4D is a cross-sectional view illustrating an example of a thin film transistor configuring a thin film transistor array according to the first to third embodiments of the present invention. The TFT shown in Fig. 4D includes an insulating substrate 1 on which a first electrically conductive layer, a gate insulating film 3, a second electrically conductive layer, an interlayer insulating film 7, and a third electrically conductive layer are provided in this order. The first electrically conductive layer includes a source electrode 4, a column wiring 4L, a drain electrode 5, a capacitor electrode 8, and a capacitor wiring 8L. The second electrically conductive layer includes a gate electrode 2, a row wiring 2L, and a drain sub-electrode 5S. The third electrically conductive layer includes a pixel electrode 10.

Fig. 4D schematically shows regions where electrostatic capacitance occurs between wirings and electrodes (row wiring - column wiring capacitance Cgsl, row wiring - capacitor wiring capacitance Cgc, row wiring - pixel electrode capacitance Cgp, column wiring - pixel electrode capacitance Csp, gate electrode - source electrode capacitance Cgs, gate electrode - drain electrode capacitance Cgd, and storage capacitance Cs). (Due to the lack of overlap in the cross-section, Cgsl and Cgc are indicated by arrows. Csc having no corresponding overlap is substantially 0.) When the TFT is in an on state (during calculation of a gate feedthrough voltage), Cgs is calculated by adding about half the area of a channel 6C to the overlap area between the gate electrode 2 and the source electrode 4, while Cgd is calculated by adding about half the area of the channel 6C to the overlap area between the gate electrode 2 and the drain electrode 5. When the TFT is in an off state (during calculation of parasite capacitance), only the overlap area between the gate electrode 2 and the source electrode 4 affects Cgs, while only the overlap area between the gate electrode 2 and the drain electrode 5 affects Cgd. Cs is defined by the drain sub-electrode 5S / gate insulating film 3 / capacitor electrode 8.

Of the eight types of electrostatic capacitance, Cgsl is in a parallel relationship with Cgs, while Cgp is in a parallel relationship with Cgd, and therefore Cgsl is included in Cgs, while Cgp is included in Cgd, so that there will be six types of electrostatic capacitance. Of the six types, Cs is designed to have a large value to maintain potential, while Cgs, Cgd, Csp, Csc and Cgc are designed to have relatively smaller values. Cgs and Cgd cannot be designed to have a value 0, but have approximately the same order of magnitude. Depending on the design, Csp, Csc or Cgc can have a value 0, however the value may be about the same as Cgs or Cgd at most.

Of the six types of electrostatic capacitance, Cgs, Csc, Csp // Cs are directly connected to the column wiring 4L, while Cgs, Cgc, Cgd // Cs are directly connected to the row wiring 2L. The mark // refers to a series circuit of capacitance. For example, Csp // Cs = 1 / (1/Csp + 1/Cs).

In the thin film transistor array shown in Fig. 36 or 38, the number of the column wirings 4L is M. Cgs, Csc and Csp connected to one column wiring 4L are N each, i.e., electrostatic capacitance C = N(Cgs+Csc+Csp // Cs).

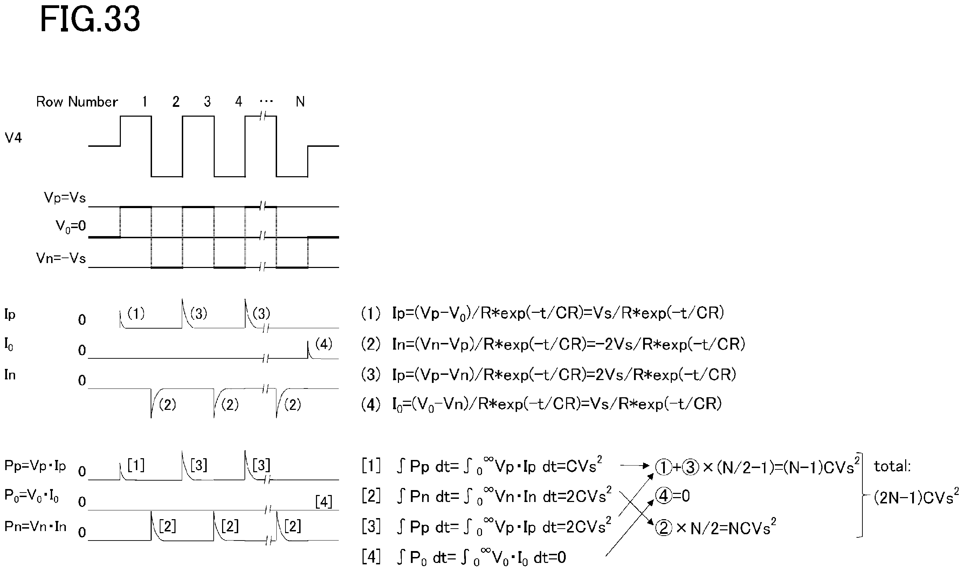

Voltage of the column wirings 4L is changed in conformity with data of each row. Therefore, the column wirings 4L are most frequently charged and discharged when reverse polarity is written for each row. The electrical energy consumed in one frame can be calculated as shown in Fig. 33. In the calculation, V4 is a voltage waveform of a column wiring 4L, ±Vs is a voltage of white writing and black writing, and R is a column wiring resistance (strictly, a sum of a column resistance and a series resistance (e.g., source driver output resistance)). In Fig. 33, the horizontal axis indicates time t. Vp and Ip are respectively voltage and current of a positive supply of a source driver, Vn and In are respectively voltage and current of a negative supply thereof, and V₀=0 and I₀ are respectively voltage and current of a GND wiring. Pp is a power consumption of the positive supply, Pn is a power consumption of the negative supply, and P₀=0 is a power consumption of the GND wiring. To simplify the formula, the integral of each charging waveform is calculated over the range expressed as t=0 to ∞, but this range may only have to be sufficiently larger than a time constant CR. For example, even t=0 to 3CR can cover 95% of the electrical energy, and can be approximately equivalent to t=0 to ∞. The electrical energy consumed in one frame by one column wiring is (2N-1)C(Vs)². Accordingly, the electrical energy consumed in one frame by M source wirings is M×(2N-1)×N(Cgs+Csc+Csp // Cs) × (Vs)² = MN(2N-1)(Cgs+Csc+Csp // Cs)(Vs)². If N is sufficiently larger than 1, the electrical energy consumed may be taken to be 2MN²(Cgs+Csc+Csp // Cs)(Vs)². The minimum electrical energy consumed is achieved in the case where the voltage of the column wiring is unchanged, and thus the electrical energy consumed in one frame is 0.

In the thin film transistor array shown in Fig. 36 or 38, the number of the row wirings 2L is N. There are M instances of Cgs, Cgc, Cgd // Cs connected to one row wiring, i.e., electrostatic capacitance C = M(Cgs+Cgc+Cgd // Cs).

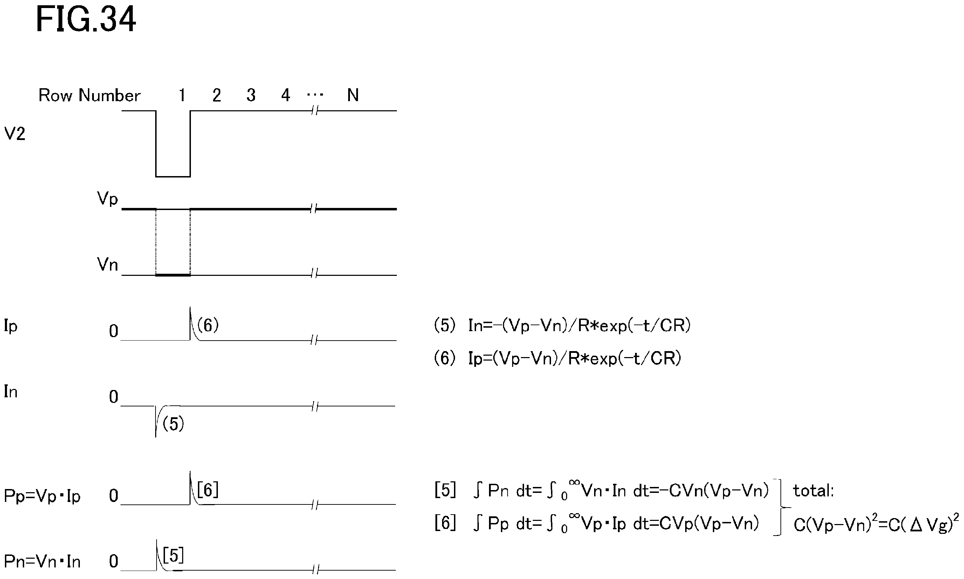

Each row wiring 2L, when selected, sequentially changes the voltage as off → on → off, and therefore, the number of charges and discharges does not rely on the image data, but the number of voltage changes is 2 per frame When a voltage change of a row wiring is expressed by ΔVg, the electrical energy consumed in one frame can be calculated as shown in Fig. 34. V2 is a voltage waveform of the row wiring 2L. Fig. 34 shows the case of a p channel TFT. In the case of an n channel TFT, the positive and negative signs of the voltage are reversed, but the electrical energy consumed remains unchanged. Vp and Vn are respectively positive and negative voltages of the gate, and R is a row wiring resistance (strictly, a sum of a row wiring resistance and a series resistance (e.g., output resistance of the gate driver)). In Fig. 34, the horizontal axis indicates time t. Vp and Ip are respectively voltage and current of a positive supply of a gate driver 14 described later, and Vn and In are respectively voltage and current of a negative supply thereof. Pp is a power consumption of the positive supply, and Pn is a power consumption of the negative supply. To simplify the formula, the integral of each charging waveform is calculated over the range expressed as t=0 to ∞, but this range may only have to be sufficiently larger than a time constant CR. For example, even t=0 to 3CR can cover 95% of the electrical energy, and can be approximately equivalent to t=0 to ∞. The electrical energy consumed in one frame by 1 row wiring is C(ΔVg)². Accordingly, the electrical energy consumed in one frame by N gate wirings is N×M(Cgs+Cgc+Cgd // Cs)×(ΔVg)² = MN(Cgs+Cgc+Cgd // Cs)(AVg)².

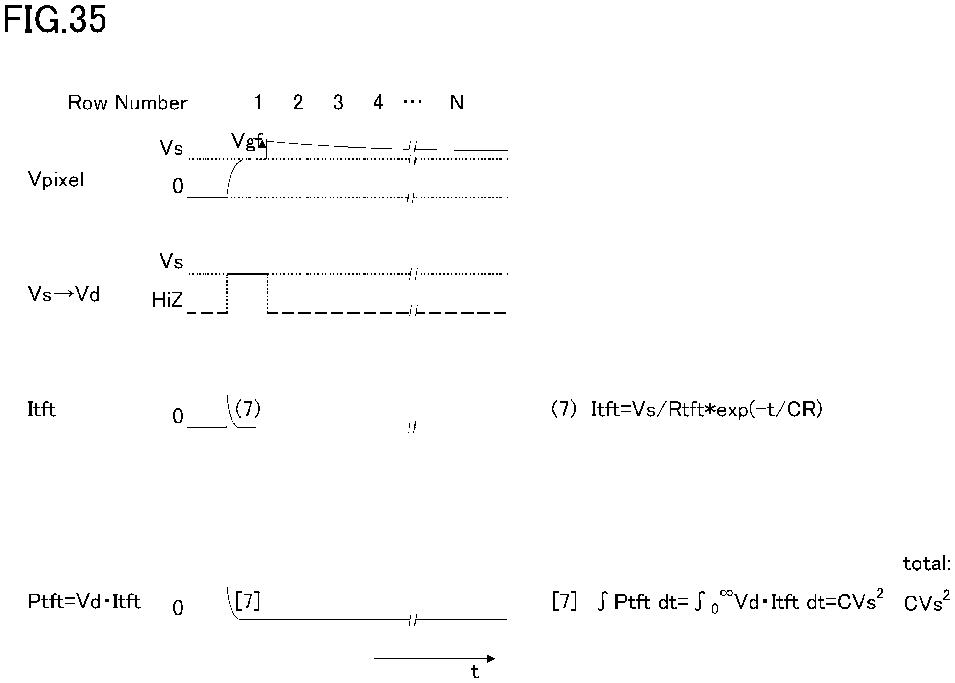

In the thin film transistor array shown in Fig. 36 or 38, the number of the pixels is MN When the TFT is in an on state, Cs and Cgd are charged, i.e., electrostatic capacitance C = Cs+Cgd. Cs and Cgd are most frequently charged when display of all the pixels is changed. In this case, when a voltage change of a column wiring is expressed by Vs, the electrical energy consumed in one frame can be calculated as shown in Fig. 35. V pixel is a voltage waveform of a pixel. R is a TFT resistance (strictly, a sum of a TFT resistance and a series resistance (e.g., column wiring resistance)). In Fig. 35, the horizontal axis indicates time t. When a drain voltage Vd=Vs is written, the current is Itft and the consumed electrical power is Ptft. To simplify the formula, the integral of each charging waveform is calculated over the range expressed as t=0 to ∞, but this range may only have to be sufficiently larger than a time constant CR. For example, even t=0 to 3CR can cover 95% of the electrical energy, and thus can be approximately equivalent to t=0 to ∞. The electrical energy consumed in one frame by one TFT is (Cs+Cgd)(Vs)². When the number of TFTs is MN, the electrical energy consumed is MN(Cs+Cgd)(Vs)². The same value is obtained in the case of Vd=-Vs. Power consumption is a minimum in the case where the potential of the entire pixels remains unchanged. In this case, power consumption is 0.

As described above, the maximum electrical energy consumed by the wirings is 2MN²(Cgs+Csc+Csp // Cs)(Vs)²+MN(Cgs+Cgc+Cgd // Cs)(ΔVg)² per frame if N is sufficiently larger than 1. The electrical power consumed due to voltage change of the column wirings is proportional to 2MN², while the electrical power consumed due to voltage change of row wirings is proportional to MN. (Cgs+Csc+Csp // Cs) and (Cgs+Cgc+Cgd // Cs) have approximately the same order of magnitude. Usually, N has a value in the range of several tens to several hundreds, and accordingly, the maximum value of the electrical power consumed due to voltage change of the column wirings is larger than that of the electrical power consumed due to voltage change of the row wirings.

In the case of a TFT array in which the structure is the same between the TFT portions other than the wirings and the storage capacitance portions, Cgs is the same between Figs. 36 and 38, Csp is the same between Figs. 36 and 38, Cgd is the same between Figs. 36 and 38, and Cs is the same between Figs. 36 and 38. Accordingly, the structure with small Csc (as in Fig. 38 where the capacitor wirings 8L are parallel to the column wirings 4L and thus the former do not overlap with the latter) has a smaller maximum value of electrical power consumption than does the structure with small Cgc (as in Fig. 36 where the capacitor wirings 8L are parallel to the row wirings 2L and thus the former do not overlap with the latter). Since the electrical power consumption due to voltage variation of a column wiring 4L is proportional to the square of N, electrical power consumption is small if N is small.

In the structure shown in Fig. 1A, the number of the column wirings 4L is increased to 2M compared to the structure shown in Fig. 38. However, the number of capacitances Cgs, Csc and Csp connected to one column wiring 4L is reduced to N/2, and the number of voltage changes per frame is also halved. Therefore, the maximum value of the electrical power consumption of the column wiring 4L is halved as expressed by (2M)(N/2)(N-1)(Cgs+Csc+Csp)(Vs)² ≈ MN²(Cgs+Csc+Csp)(Vs)². Accordingly, the electrical power consumption of the column wirings 4L can be greatly reduced. It should be noted that the electrical power consumption of the row wirings 2L remains unchanged as expressed by MN(Cgs+Cgc+Cgd // Cs)(AVg)².

With the structure shown in Fig. 2A, the number of the capacitor wirings 8L is halved, and thus the number of overlaps between the row wirings 2L and the capacitor wirings 8L is halved, compared to the structure shown in Fig. 1. Since the capacitance between a row wiring and a capacitor wiring is substantially caused by the overlap therebetween, the number of capacitances Cgc connected to one row wiring 2L is reduced to M/2. Accordingly, the electrical power consumption of the row wirings 2L is reduced as expressed by MN(Cgs+Cgc/2+Cgd // Cs)(ΔVg)². The maximum electrical power consumption of the column wirings 4L is the same as in Fig. 1 as expressed by (2M)(N/2)(N-1)(Cgs+Csc+Csp)(Vs)² ≈ MN²(Cgs+Csc+Csp)(Vs)².

With the structure shown in Fig. 3A, the number of the column wirings 4L increases to 4M, compared to the structure shown in Fig. 38, however, the number of capacitances Cgs and Csc connected to one column wiring 4L is reduced to N/4. Since the number of the column wirings 4L overlapped with a pixel electrode 10 is 2, the number of capacitances Csp is reduced to only N/2. The number of voltage changes of the column wirings per frame is also N/4, and therefore, the maximum value of the electrical power consumption of the column wirings 4L is reduced to (4M)(N/4)(N/2-1)(Cgs/4+Csc/4+Csp/2)(Vs)² ≈ MN²(Cgs+Csc+2Csp)(Vs)²/2. Accordingly, the electrical power consumption of the column wirings 4L can be greatly reduced. It should be noted that the electrical power consumption of the row wirings 2L is the same as in Fig. 1 as expressed by MN(Cgs+Cgc+Cgd // Cs)(AVg)².

The maximum value MN(Cs+Cgd)(Vs)² of the electrical power consumption of the TFTs has a constant MN, while the maximum value MN²(Cgs+Csc+2Csp)(Vs)²/2 of the electrical power consumption of the column wirings 4L has a constant MN². Therefore, if Cs and NCgs/2 are approximately the same, and Cgd, Csc and Csp are small, the electrical power consumption of the TFTs per frame is approximately the same as the electrical power consumption of the column wirings 4L per frame.

However, in the case of electronic paper, often one image is written in a plurality of frames. For example, when writing a horizontal stripe image over a plurality of frames, electrical power of MN²(Cgs+Csc+Csp)(Vs)²/2 is required to be consumed by the column wirings 4L of each frame during the writing. However, in this case, electrical power of MN(Cs+Cgd)(Vs)² is required to be consumed by the TFTs of only the initially written frame, and is not required in the frames for writing the same voltage. Accordingly, when the writing of several frames or several tens of frames overall is concerned, the electrical power consumption of the column wirings 4L is larger.

As described above, when the TFTs have a wiring structure as shown in Fig. 1A, electrical power consumption can be reduced, compared to the wiring structure based on conventional art as shown in Fig. 38. The structure shown in Fig. 2A or 3A can further reduce electrical power consumption than in the structure shown in Fig. 1A.

It is desirable that the M column by N row effective region satisfies M≥N/2. This is because, in the case of M<N/2, if the matrix of Fig. 38 is swapped to provide an N column by M row structure, the maximum value ≈ 2NM²(Cgs+Csc+Csp // Cs)(Vs)²+MN(Cgs+Cgc+Cgd // Cs)(ΔVg)² of the electrical power consumption of the wirings will be smaller than the maximum value ≈ MN²(Cgs+Csc+Csp // Cs)(Vs)²+MN(Cgs+Cgc+Cgd // Cs)(ΔVg)² of the electrical power consumption of the wirings in the structure of Fig. 1. In other words, the present invention exerts great advantageous effects when M≥N/2 is satisfied.

It is more preferable that the M column by N row effective region satisfies M≥N. This is because, in the case of N/2≤M<N, if the matrix is swapped and the structure of Fig. 1 is applied, the maximum value ≈ NM²(Cgs+Csc+Csp // Cs)(Vs)²+MN(Cgs+Cgc+Cgd // Cs)(ΔVg)² of the electrical power consumption of the wirings will be smaller than the maximum value ≈ MN²(Cgs+Csc+Csp // Cs)(Vs)²+MN(Cgs+Cgc+Cgd // Cs)(ΔVg)² of the electrical power consumption of the wirings when the structure of Fig. 1 is applied without swapping the matrix. However, depending on the number of pixels M×N in the effective region and the relationship with the outputs of the drivers used, N/2≤M<N may be used.

In the structures shown in Figs. 1A, 2A and 3A, the column wirings 4L each have a length corresponding to (N/2) pixels, while the capacitor wirings 8L parallel to the column wirings 4L each have a length corresponding to N pixels. On the other hand, the capacitor wirings 8L of typically used panels, if they are parallel to the row wirings 2L as shown in Fig. 36, have the same length as the row wirings 2L, and if they are parallel to the column wirings 4L as shown in Fig. 38, have the same length as the column wirings 4L. The present invention is advantageous in that the column wirings 4L have a length corresponding to (N/2) pixels to reduce electrical power consumption, and the capacitor wirings 8L have a length corresponding to N pixels so that power supply to the capacitor wirings 8L can be respectively conducted through at least one portion of each respective capacitor wirings. Furthermore, the present invention is advantageous in that the power supply to the capacitor wirings from the upper and lower sides can prevent voltage drop that would otherwise be caused by the resistance of the capacitor wirings.

In the structures shown in Fig. 1B, 2B or 3B, a capacitor-connecting wiring 8C is further provided to the center of the effective region. With this structure, power supply to the capacitor wirings 8L is greatly simplified by only supplying power to the capacitor-connecting wiring 8C. Furthermore, since the capacitor-connecting wiring 8C overlaps with neither the row wirings 2L nor the column wirings 4L, Cgc and Csc are prevented from increasing.

In the structures of not only Figs. 1A, 2A and 3A but also Figs. 1B, 2B and 3B, the pixel pitch P between the (N/2)^{th} and (N/2+1)^{th} rows from the top of the effective region is equal to the pixel pitch P between other rows, irrespective of the presence of the capacitor-connecting wiring 8C at the center of the effective region. In other words, pixels adjacent in the longitudinal direction have a constant pitch. Thus, the observer will not feel uneasy as if the image is separated into upper and lower parts. To make the pixel pitch uniform, the capacitor-connecting wiring 8C is preferred to be arranged below the pixel electrode 10. If the capacitor-connecting wiring 8C overlaps with the (N/2)^{th} line pixel electrodes 10 or the (N/2+1)^{th} line pixel electrodes 10, the area of the capacitor electrodes 8 on the (N/2)^{th} or (N/2+1)^{th} line may be reduced to cancel the electrostatic capacitance due to the overlap. As will be described later, capacitor-connecting wirings 8C may be formed in a plurality of electrically conductive layers so as to be parallel to each other.

### (Details of first embodiment)

In the thin film transistor array according to the first embodiment, electrical power can be supplied by connecting gate feed lines 11 to first ends of at least a part of the plurality of row wirings 2L, by connecting first source feed lines 12 to first ends of the column wirings 4L formed in a first area of the two areas, on the opposite side to a second area of the two areas, by connecting second source feed lines 12 to first ends of the column wirings 4L formed in the second area of the two areas, on the opposite side to the first area, and by connecting a capacitor feed line 13 to first and/or second ends of the capacitor wirings 8L. Furthermore, gate intermediate lines 11M may be connected to second ends of the row wirings 2L whose first ends are connected to the gate feed lines 11, so that electrical connection can be established, via the gate intermediate lines 11M, between the gate feed lines 11 and the row wirings 2L to which no gate feed lines 11 are connected.

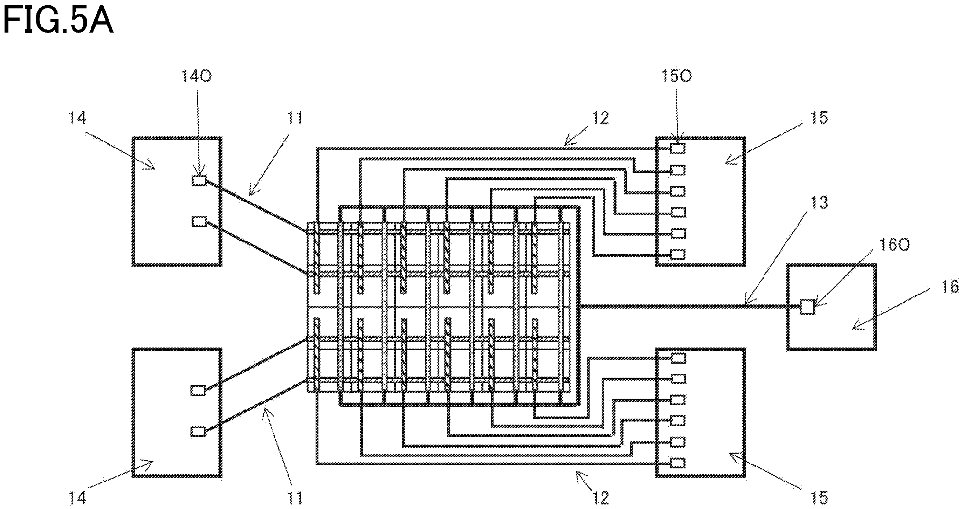

Specifically, in the structure shown in Fig. 1A, electrical power can be supplied, as in Fig. 5A, for example, by connecting gate feed lines 11 to left or right ends of the row wirings 2L, by connecting source feed lines 12 to upper ends of the upper area column wirings 4L, by connecting another set of feed lines 12 to lower ends of the lower area column wirings 4L, and by connecting a capacitor feed line 13 to upper and lower ends of the capacitor wirings 8L. The gate feed lines 11 are connected to respective output terminals 140 of a gate driver 14, the source feed lines 12 are connected to respective output terminals 150 of a source driver 15, and the capacitor feed line 13 is connected to a common electrode potential, or an output terminal 160 of a capacitor power supply 16, or a GND terminal. (The common electrode potential refers to a potential applied to counter electrodes in a display device with a structure in which a display medium is sandwiched between a thin film transistor array and a counter substrate including the counter electrodes. The common electrode potential is preferably used when the display medium is liquid crystal. When the display media are electrophoretic particles, a capacitor power potential, GND potential, or common electrode potential is preferably used.)

In the case of Fig. 5A, there is little overlap between wirings in a region outside the effective region, and thus electrical power consumption can be minimized in the region outside the effective region. In Fig. 5A, the wirings overlap only at intersections (at 2(M-1) points) between the source feed lines 12 and the capacitor feed line 13, outside the effective region. In Fig. 5A, input terminals of the gate driver 14, the source driver 15 and the capacitor power supply 16 are omitted. In Fig. 5A, two separate gate drivers 14 and two separate source drivers 15 are provided, however, the configuration is not limited to this. For example, one gate driver and two source drivers may be used, or one or two gate-source integrated drivers may be used.

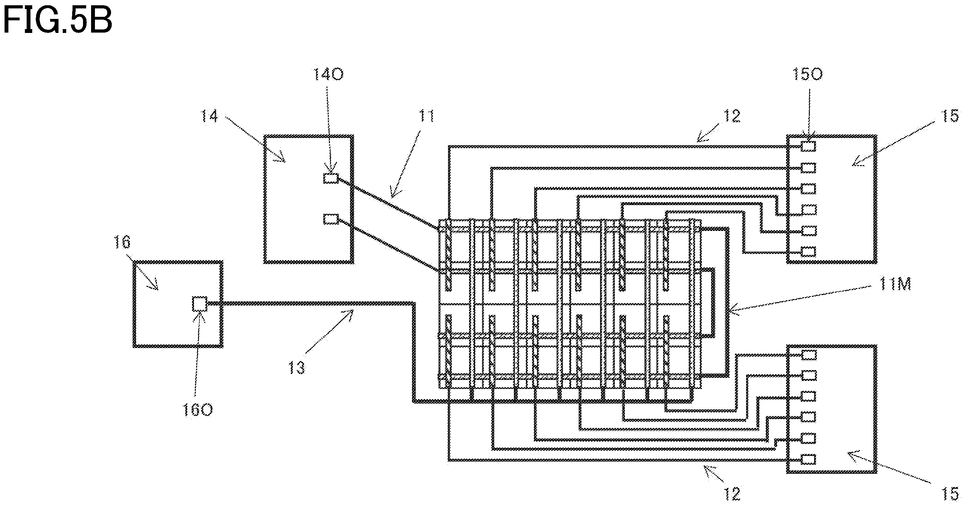

Alternatively, in the structure shown in Fig. 1A, as shown in Fig. 5B, for example, electrical power can be supplied with feed lines 11 being connected to first left or right ends of first upper or lower area row wirings 2L, with first ends of gate intermediate lines 11M being connected to second left or right ends of the first upper or lower area row wirings 2L, with second ends of the gate intermediate lines 11M being connected to left or right ends of second upper or lower area row wirings 2L, with source feed lines 12 being connected to upper ends of the upper area column wirings 4L, with another set of source feed lines 12 being connected to lower ends of the lower area column wirings 4L, and with a capacitor feed line 13 being connected to lower or upper ends of the capacitor wirings 8L. The gate feed lines 11 are connected to respective output terminals 140 of a gate driver 14, the source feed lines 12 are connected to respective output terminals 150 of a source driver 15, and the capacitor feed line 13 is connected to a common electrode potential, or an output terminal 160 of a capacitor power supply 16, or a GND terminal.

In this case, there is little overlap between wirings in a region outside the effective region, and thus electrical power consumption can be minimized in the region outside the effective region. In Fig. 5B, the wirings overlap only at intersections (M points) between the source feed lines 12 and the capacitor feed line 13, outside the effective region. In Fig. 5B, input terminals of the gate driver 14, the source driver 15 and the capacitor power supply 16 are omitted. In Fig. 5B, one gate driver 14 and two separate source drivers 15 are provided, however, the configuration is not limited to this. For example, one gate driver and one source driver may be used, or one gate-source integrated driver may be used.

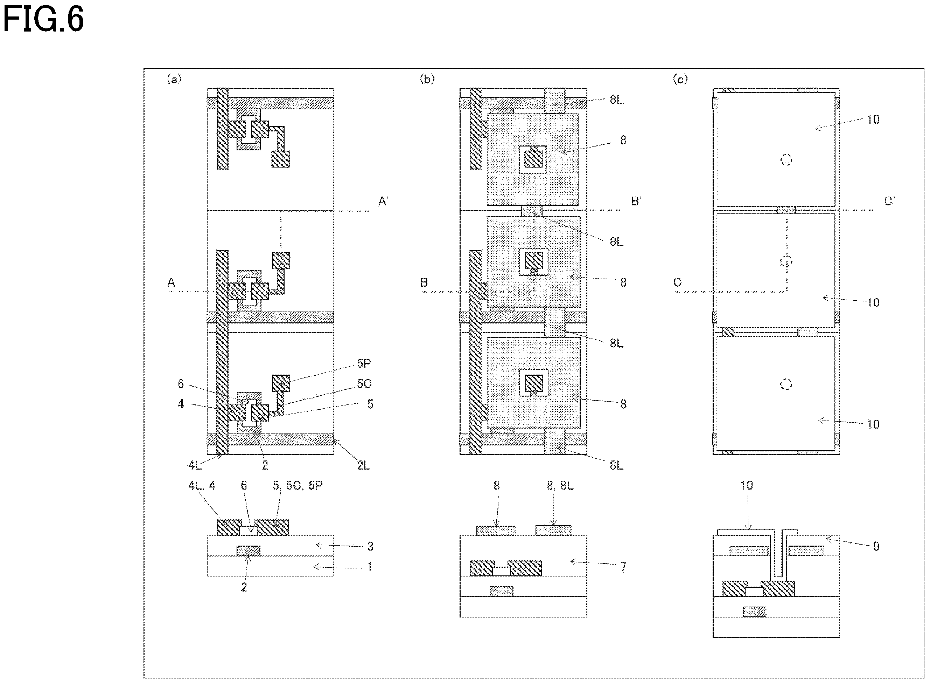

Figs. 6(a) to 6(c) each show a process of producing a thin film transistor array in which the TFTs include, as does the TFT shown in Fig. 4A, an insulating substrate 1 on which a first electrically conductive layer, a gate insulating film 3, a second electrically conductive layer, an interlayer insulating film 7, a third electrically conductive layer, a capacitor insulating film 9, and a fourth electrically conductive layer are provided in this order. The first electrically conductive layer includes gate electrodes 2, and row wirings 2L. The second electrically conductive layer includes source electrodes 4, column wirings 4L, and drain electrodes 5. The third electrically conductive layer includes capacitor electrodes 8, and capacitor wirings 8L. The fourth electrically conductive layer includes pixel electrodes 10. The upper plan views each show one column of pixels in the (N/2)^{th}, (N/2+1)^{th} and (N/2+2)^{th} rows from the top of the effective region, and the lower cross-sectional views each show a cross section taken along the broken line of the corresponding plan view.

Fig. 6(a) shows a state of the array where there is the insulating substrate 1, on which there are the gate electrodes 2 and the row wirings 2L, on which there is the gate insulating film 3, on which there is the semiconductor pattern 6, on which there are the source electrodes 4, the column wirings 4L, the drain electrodes 5, drain-connecting wirings 5C and drain pads 5P. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. In the state shown in Fig. 6(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 6(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 6(b) shows a state where the interlayer insulating film 7 is provided on the array in the state shown in Fig. 6(a), with the capacitor electrodes 8 and the capacitor wirings 8L being further provided thereon. In the state shown in Fig. 6(b), the plurality of capacitor electrodes 8 are connected by a capacitor wiring 8L, so that the capacitor electrodes 8 serve as parts of the capacitor wiring 8L, and the capacitor electrodes 8 and the capacitor wiring 8L serve as a capacitor wiring overall. However, the capacitor electrodes 8 may be branched from a continuous capacitor wiring 8L.

Fig. 6(c) shows a structure in which the capacitor insulating film 9 is provided on the array in the state shown in Fig. 6(b), with the pixel electrodes 10 being further provided thereon. Each pixel electrode 10 is electrically connected to the corresponding drain pad 5P via an aperture in the capacitor insulating film 9 and an aperture in the interlayer insulating film 7.

Alternatively, in the thin film transistor array according to the first to third embodiments, in the case where there is a capacitor-connecting wiring 8C between the upper and lower areas of the effective region, electrical power can be supplied by connecting gate feed lines 11 to first ends of at least a part of the plurality of row wirings 2L, by connecting first source feed lines 12 to first ends of the column wirings 4L formed in a first area of the two areas, on the opposite side to a second area of the two areas, by connecting second source feed lines 12 to first ends of the column wirings 4L formed in the second area of the two areas, on the opposite side to the first area, and by connecting a capacitor feed line 13 to one end or both ends of the capacitor-connecting wiring 8C. Furthermore, gate intermediate lines 11M may be connected to second ends of the row wirings 2L whose first ends are connected to the gate feed lines 11, so that electrical connection can be established, via the gate intermediate lines 11M, between the gate feed lines 11 and the row wirings 2L to which no gate feed lines 11 are connected.

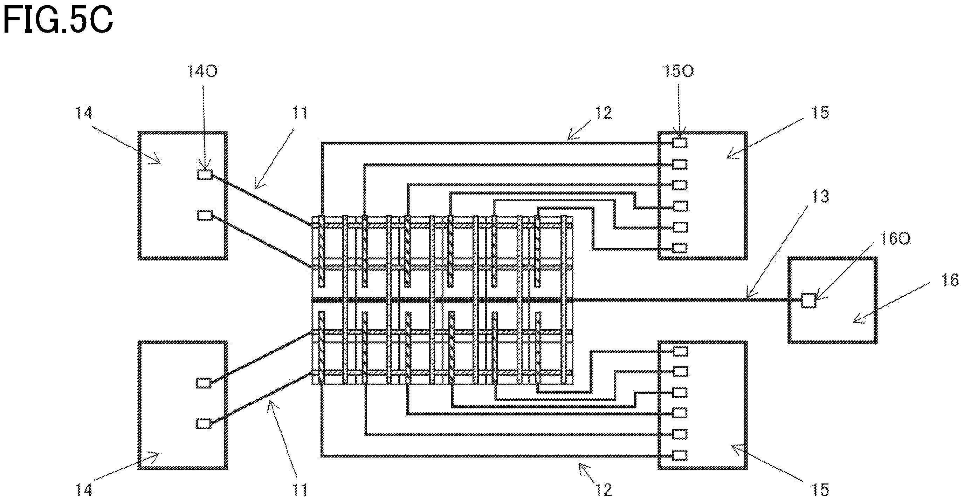

Specifically, in the structure shown in Fig. 1B, electrical power can be supplied, as in Fig. 5C, for example, by connecting gate feed lines 11 to left or right ends of the row wirings 2L, by connecting source feed lines 12 to upper ends of the upper area column wirings 4L, by connecting another set of source feed lines 12 to lower ends of the lower area column wirings 4L, and by connecting a capacitor feed line 13 to a left or right end of the capacitor-connecting wiring 8C. The gate feed lines 11 are connected to respective output terminals 140 of a gate driver 14, the source feed lines 12 are connected to respective output terminals 150 of a source driver 15, and the capacitor feed line 13 is connected to a common electrode potential, or an output terminal 160 of a capacitor power supply 16, or a GND terminal. (The common electrode potential refers to a potential applied to counter electrodes in a display device with a structure in which a display medium is sandwiched between a thin film transistor array and a counter substrate including the counter electrodes. The common electrode potential is preferably used when the display medium is liquid crystal. When the display media are electrophoretic particles, a capacitor power potential, GND potential, or common electrode potential is preferably used.)

In this case, overlaps between wirings in a region outside the effective region can be completely eliminated, and thus electrical power consumption can be minimized in the region outside the effective region. In Fig. 5C, input terminals of the gate driver 14, the source driver 15 and the capacitor power supply 16 are omitted. In Fig. 5C, two separate gate drivers 14 and two separate source drivers 15 are provided, however, the configuration is not limited to this. For example, one gate driver and two source drivers may be used, or one or two gate-source integrated drivers may be used.

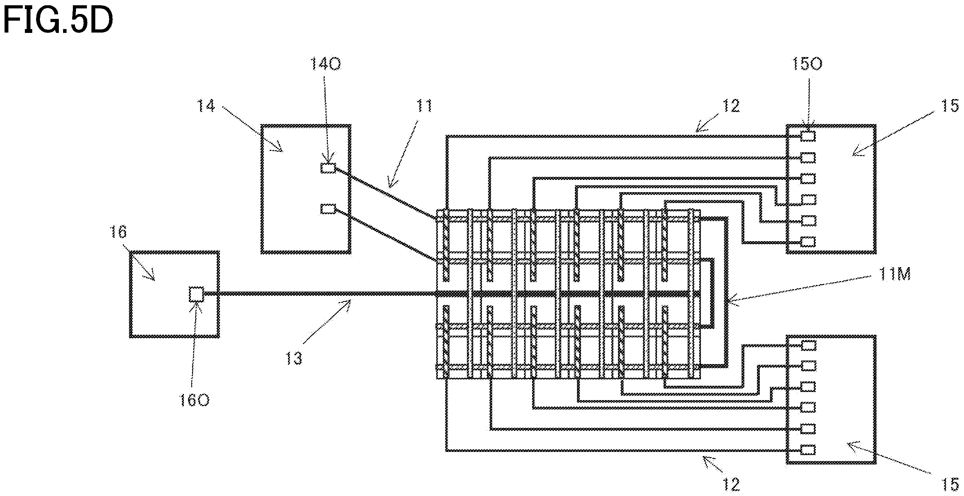

Alternatively, in the structure shown in Fig. 1B, as shown in Fig. 5D, for example, electrical power can be supplied with gate feed lines 11 being connected to first left or right ends of first upper or lower area row wirings 2L, with first ends of gate intermediate lines 11M being connected to second left or right ends of the first upper or lower area row wirings 2L, with second ends of the gate intermediate lines 11M being connected to left or right ends of second upper or lower area row wirings 2L, with source feed lines 12 being connected to upper ends of the upper area column wirings 4L, with another set of source feed lines 12 being connected to lower ends of the lower area column wirings 4L, and with a capacitor feed line 13 being connected to a left or right end of the capacitor-connecting wiring 8C. The gate feed lines 11 are connected to respective output terminals 140 of a gate driver 14, the source feed lines 12 are connected to respective output terminals 150 of a source driver 15, and the capacitor feed line 13 is connected to a common electrode potential, or an output terminal 160 of a capacitor power supply 16, or a GND terminal.

In this case, overlaps between wirings in a region outside the effective region can be completely eliminated, and thus electrical power consumption can be minimized in the region outside the effective region. In Fig. 5D, input terminals of the gate driver 14, the source driver 15 and the capacitor power supply 16 are omitted. In Fig. 5D, one gate driver 14 and two separate source drivers 15 are provided, however, the configuration is not limited to this. For example, one gate driver and one source driver may be used, or one gate-source integrated driver may be used.

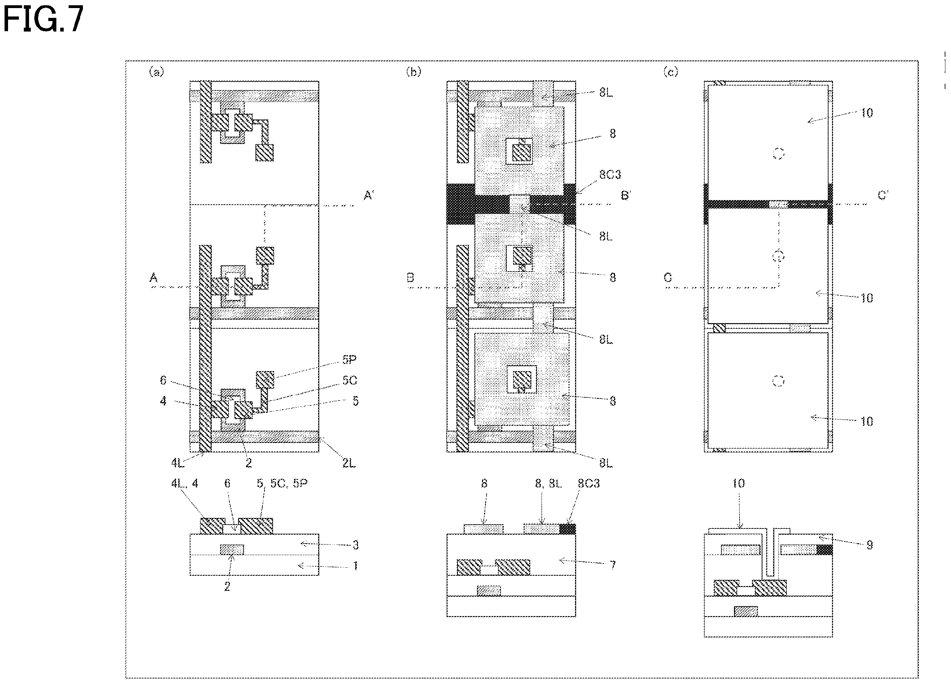

Figs. 7(a) to 13(c) each show a process of producing a thin film transistor array in which the TFTs include, as does the TFT shown in Fig. 4A, an insulating substrate 1 on which a first electrically conductive layer, a gate insulating film 3, a second electrically conductive layer, an interlayer insulating film 7, a third electrically conductive layer, a capacitor insulating film 9, and a fourth electrically conductive layer are provided in this order. The first electrically conductive layer includes gate electrodes 2, and row wirings 2L. The second electrically conductive layer includes source electrodes 4, column wirings 4L, and drain electrodes 5. The third electrically conductive layer includes capacitor electrodes 8, and capacitor wirings 8L. The fourth electrically conductive layer includes pixel electrodes 10. The upper plan views each show one column of pixels in the (N/2)^{th}, (N/2+1)^{th} and (N/2+2)^{th} rows from the top of the effective region, and the lower cross-sectional views each show a cross section taken along the broken line of the corresponding plan view.

Fig. 7(a) shows a state of the array where there is the insulating substrate 1, on which there are the gate electrodes 2 and the row wirings 2L, on which there is the gate insulating film 3, on which there is a semiconductor pattern 6, on which there are the source electrodes 4, the column wirings 4L, the drain electrodes 5, drain-connecting wirings 5C and drain pads 5P. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. In the state shown in Fig. 7(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 7(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 7(b) shows a state where the interlayer insulating film 7 is provided on the array in the state shown in Fig. 7(a), with the capacitor electrodes 8, the capacitor wirings 8L, and a capacitor-connecting wiring 8C3 being further provided thereon. In the state shown in Fig. 7(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C3, so that the capacitor wiring middle parts 8L serve as parts of the capacitor-connecting wiring 8C3, i.e., the capacitor wiring middle parts 8L and the capacitor-connecting wiring 8C3 serve as a capacitor-connecting wiring 8C3 overall. The capacitor-connecting wiring 8C3 overlaps with neither the row wirings 2L nor the column wirings 4L.

Fig. 7(c) shows a structure in which the capacitor insulating film 9 is provided on the array in the state shown in Fig. 7(b), with the pixel electrodes 10 being further provided thereon. Each pixel electrode 10 is electrically connected to the corresponding drain pad 5P via an aperture in the capacitor insulating film 9 and an aperture in the interlayer insulating film 7. Since the pixel electrodes 10 in the (N/2)^{th} and (N/2+1)^{th} rows have overlaps with the capacitor-connecting wiring 8C3 and thus Cs increases accordingly, the capacitor electrodes 8 in the (N/2)^{th} and (N/2+1)^{th} rows may be made smaller, as shown in Fig. 7(b), than the capacitor electrodes 8 in other rows, to maintain Cs to be equivalent.

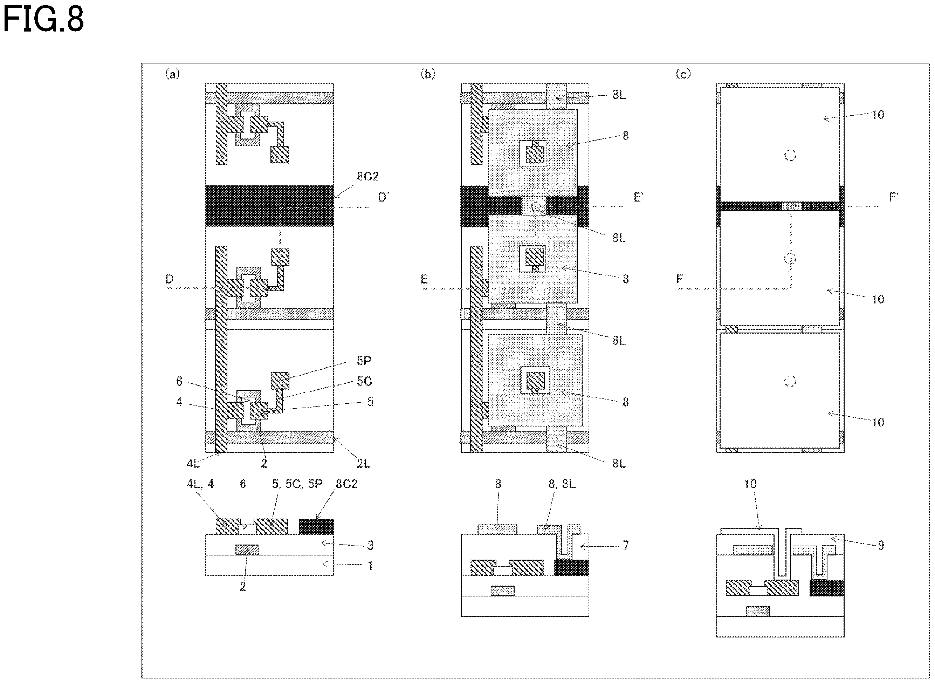

Fig. 8(a) shows a state of an array where there is an insulating substrate 1, on which there are gate electrodes 2 and row wirings 2L, on which there is a gate insulating film 3, on which there is a semiconductor pattern 6, on which there are source electrodes 4, column wirings 4L, drain electrodes 5, drain-connecting wirings 5C, drain pads 5P, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C2 overlaps with neither the row wirings 2L nor the column wirings 4L. In the state shown in Fig. 8(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as a row wiring 2L overall. In the state shown in Fig. 8(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring overall.

Fig. 8(b) shows a state where an interlayer insulating film 7 is provided on the array in the state shown in Fig. 8(a), with capacitor electrodes 8 and capacitor wirings 8L being further provided thereon. In the state shown in Fig. 8(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are electrically connected to the capacitor-connecting wiring 8C2 of the second electrically conductive layer via apertures in the interlayer insulating film 7.

Fig. 8(c) shows a structure in which a capacitor insulating film 9 is provided on the array in the state shown in Fig. 8(b), with pixel electrodes 10 being further provided thereon. Each pixel electrode 10 is electrically connected to the corresponding drain pad 5P via an aperture in the capacitor insulating film 9 and an aperture in the interlayer insulating film 7. Since the pixel electrodes 10 in the (N/2)^{th} and (N/2+1)^{th} rows have overlaps with the capacitor-connecting wiring 8C2 and thus Cs increases accordingly, the capacitor electrodes 8 in the (N/2)^{th} and (N/2+1)^{th} rows may be made smaller, as shown in Fig. 8(b), than the capacitor electrodes 8 in other rows, to maintain Cs to be equivalent.

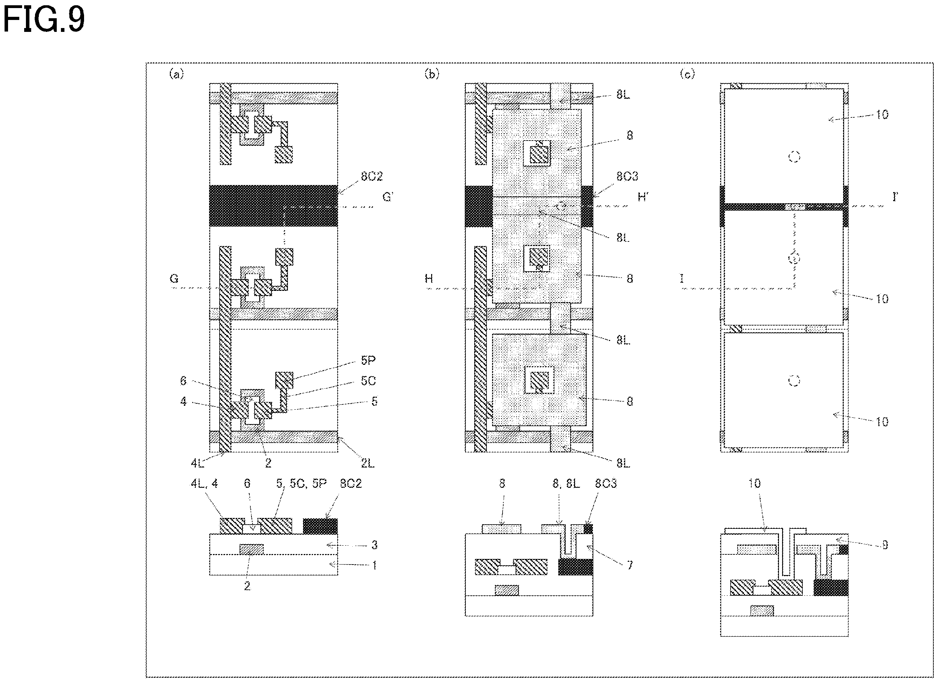

Fig. 9(a) shows a state of an array where there is an insulating substrate 1, on which there are gate electrodes 2 and row wirings 2L, on which there is a gate insulating film 3, on which there is a semiconductor pattern 6, on which there are source electrodes 4, column wirings 4L, drain electrodes 5, drain-connecting wirings 5C, drain pads 5P, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C2 overlaps with neither the row wirings 2L nor the column wirings 4L. In the state shown in Fig. 9(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 9(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 9(b) shows a state where an interlayer insulating film 7 is provided on the array in the state shown in Fig. 9(a), with capacitor electrodes 8, capacitor wirings 8L, and a capacitor-connecting wiring 8C3 being further provided thereon. In the state shown in Fig. 9(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C3, so that the capacitor wiring middle parts 8L serve as parts of the capacitor-connecting wiring 8C3, i.e., the capacitor wiring middle parts 8L and the capacitor-connecting wiring 8C3 serve as a capacitor-connecting wiring 8C3 overall. The capacitor wiring middle parts 8L are electrically connected to the capacitor-connecting wiring 8C2 of the second electrically conductive layer via apertures in the interlayer insulating film 7.

Fig. 9(c) shows a structure in which a capacitor insulating film 9 is provided on the array in the state shown in Fig. 9(b), with pixel electrodes 10 being further provided thereon. Each pixel electrode 10 is electrically connected to the corresponding drain pad 5P via an aperture in the capacitor insulating film 9 and an aperture in the interlayer insulating film 7. Since the pixel electrodes 10 in the (N/2)^{th} and (N/2+1)^{th} rows have overlaps with the capacitor-connecting wiring 8C3 and thus Cs increases accordingly, the capacitor electrodes 8 in the (N/2)^{th} and (N/2+1)^{th} rows may be made smaller, as shown in Fig. 9(b), than the capacitor electrodes 8 in other rows, to maintain Cs to be equivalent.

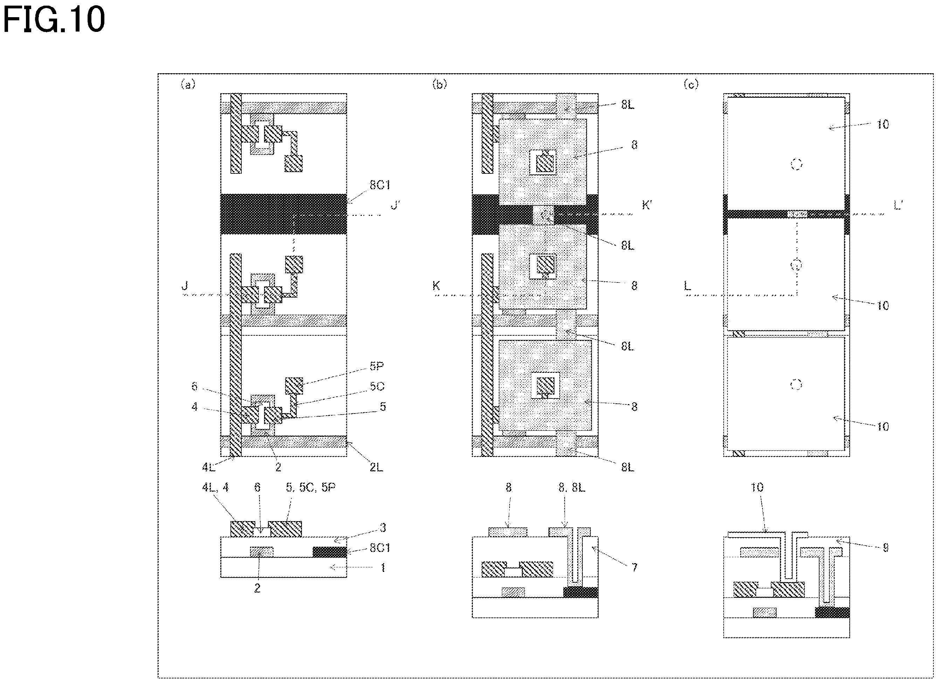

Fig. 10(a) shows a state of an array where there is an insulating substrate 1, on which there are gate electrodes 2, row wirings 2L, and a capacitor-connecting wiring 8C1, on which there is a gate insulating film 3, on which there is a semiconductor pattern 6, on which there are source electrodes 4, column wirings 4L, drain electrodes 5, drain-connecting wirings 5C, and drain pads 5P. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C1 overlaps with neither the row wirings 2L nor the column wirings 4L. In the state shown in Fig. 10(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 10(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 10(b) shows a state where an interlayer insulating film 7 is provided on the array in the state shown in Fig. 10(a), with capacitor electrodes 8 and capacitor wirings 8L being further provided thereon. In the state shown in Fig. 10(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are electrically connected to the capacitor-connecting wiring 8C1 via apertures in the interlayer insulating film 7 and apertures in the gate insulating film 3.

Fig. 10(c) shows a structure in which a capacitor insulating film 9 is provided on the array in the state shown in Fig. 10(b), with pixel electrodes 10 being further provided thereon. Each pixel electrode 10 is electrically connected to the corresponding drain pad 5P via an aperture in the capacitor insulating film 9 and an aperture in the interlayer insulating film 7. Since the pixel electrodes 10 in the (N/2)^{th} and (N/2+1)^{th} rows have overlaps with the capacitor-connecting wiring 8C1 and thus Cs increases accordingly, the capacitor electrodes 8 in the (N/2)^{th} and (N/2+1)^{th} rows may be made smaller, as shown in Fig. 10(b), than the capacitor electrodes 8 in other rows, to maintain Cs to be equivalent.

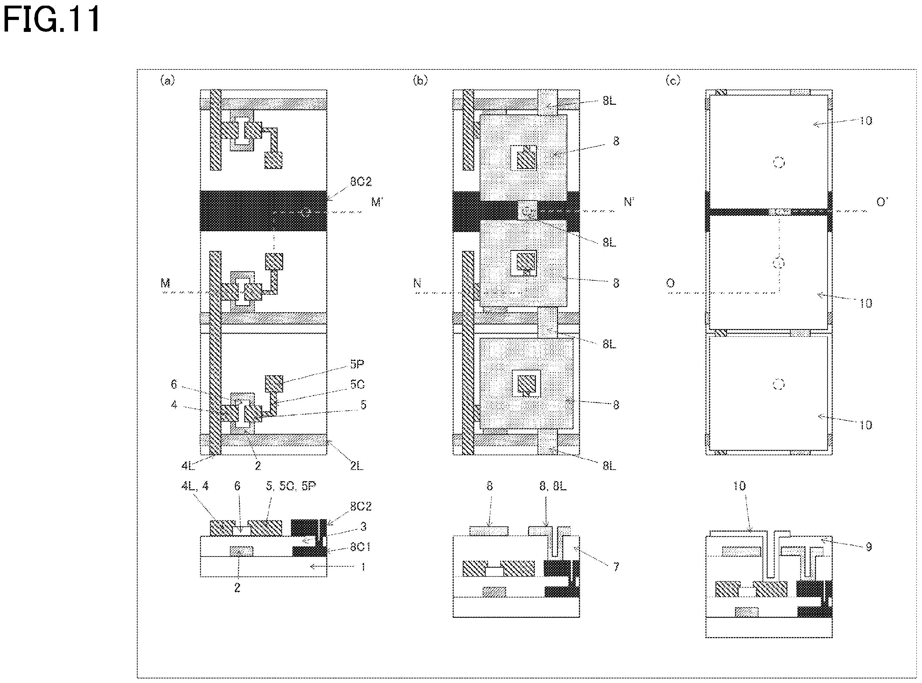

Fig. 11(a) shows a state of an array where there is an insulating substrate 1, on which there are gate electrodes 2, row wirings 2L, and a capacitor-connecting wiring 8C1, on which there is a gate insulating film 3, on which there is a semiconductor pattern 6, on which there are source electrodes 4, column wirings 4L, drain electrodes 5, drain-connecting wirings 5C, drain pads 5P, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C2 of the second electrically conductive layer is electrically connected to the capacitor-connecting wiring 8C1 of the first electrically conductive layer via apertures in the gate insulating film 3. The capacitor-connecting wirings 8C1 and 8C2 overlap with neither the row wirings 2L nor the column wirings 4L. In the state shown in Fig. 11(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 11(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 11(b) shows a state where an interlayer insulating film 7 is provided on the array in the state shown in Fig. 11(a), with capacitor electrodes 8 and capacitor wirings 8L being further provided thereon. In the state shown in Fig. 11(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are electrically connected to the capacitor-connecting wiring 8C2 via apertures in the interlayer insulating film 7.

Fig. 11(c) shows a structure in which a capacitor insulating film 9 is provided on the array in the state shown in Fig. 11(b), with pixel electrodes 10 being further provided thereon. Each pixel electrode 10 is electrically connected to the corresponding drain pad 5P via an aperture in the capacitor insulating film 9 and an aperture in the interlayer insulating film 7. Since the pixel electrodes 10 in the (N/2)^{th} and (N/2+1)^{th} rows have overlaps with the capacitor-connecting wiring 8C2 and thus Cs increases accordingly, the capacitor electrodes 8 in the (N/2)^{th} and (N/2+1)^{th} rows may be made smaller, as shown in Fig. 11(b), than the capacitor electrodes 8 in other rows, to maintain Cs to be equivalent.

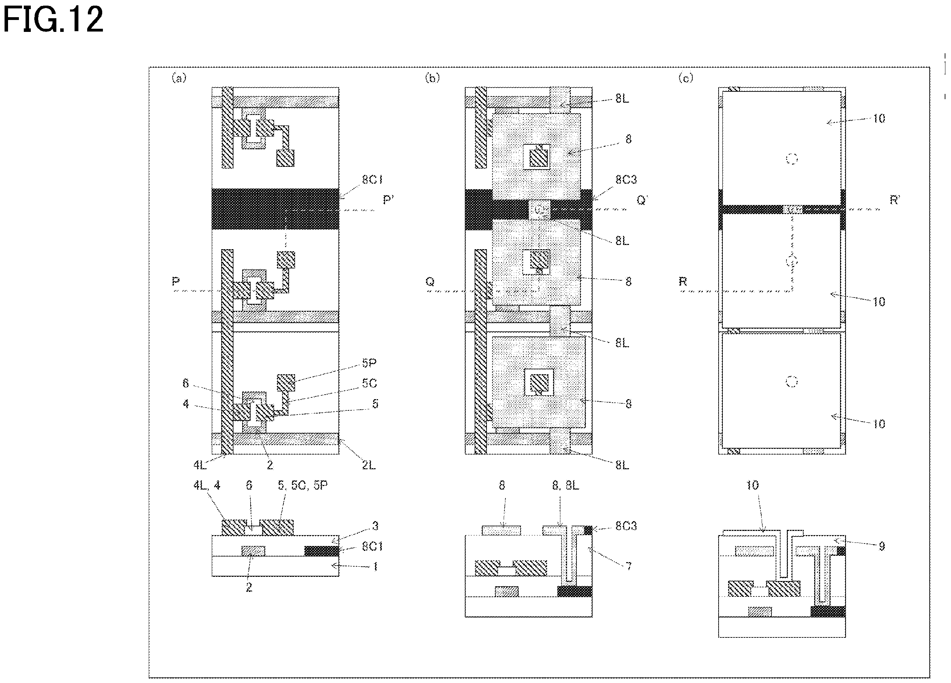

Fig. 12(a) shows a state of an array where there is an insulating substrate 1, on which there are gate electrodes 2, row wirings 2L, and a capacitor-connecting wiring 8C1, on which there is a gate insulating film 3, on which there is a semiconductor pattern 6, on which there are source electrodes 4, column wirings 4L, drain electrodes 5, drain-connecting wirings 5C, and drain pads 5P. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C1 overlaps with neither the row wirings 2L nor the column wirings 4L. In the state shown in Fig. 12(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 12(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 12(b) shows a state where an interlayer insulating film 7 is provided on the array in the state shown in Fig. 12(a), with capacitor electrodes 8, capacitor wirings 8L, and a capacitor-connecting wiring 8C3 being further provided thereon. In the state shown in Fig. 12(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C3, so that the capacitor wiring middle parts 8L serve as parts of the capacitor-connecting wiring 8C3, i.e., the capacitor wiring middle parts 8L and the capacitor-connecting wiring 8C3 serve as a capacitor-connecting wiring 8C3 overall. The capacitor wiring middle parts 8L are electrically connected to the capacitor-connecting wiring 8C1 of the first electrically conductive layer via apertures in the interlayer insulating film 7, and apertures in the gate insulating film 3. The capacitor-connecting wirings 8C1 and 8C3 overlap with neither the row wirings 2L nor the column wirings 4L.

Fig. 12(c) shows a structure in which a capacitor insulating film 9 is provided on the array in the state shown in Fig. 12(b), with pixel electrodes 10 being further provided thereon. Each pixel electrode 10 is electrically connected to the corresponding drain pad 5P via an aperture in the capacitor insulating film 9 and an aperture in the interlayer insulating film 7. Since the pixel electrodes 10 in the (N/2)^{th} and (N/2+1)^{th} rows have overlaps with the capacitor-connecting wiring 8C3 and thus Cs increases accordingly, the capacitor electrodes 8 in the (N/2)^{th} and (N/2+1)^{th} rows may be made smaller, as shown in Fig. 12(b), than the capacitor electrodes 8 in other rows, to maintain Cs to be equivalent.

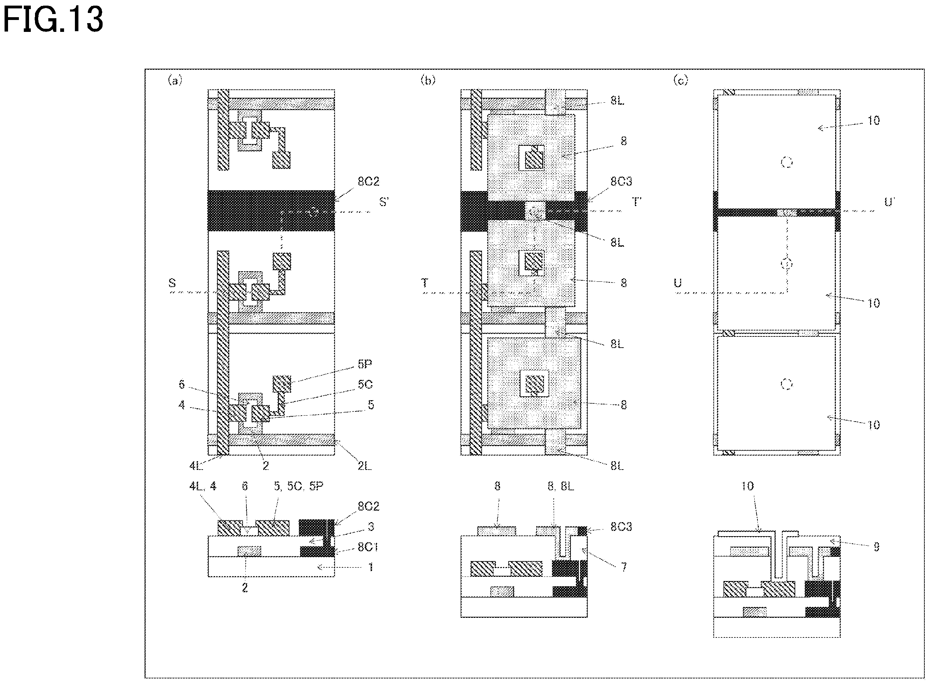

Fig. 13(a) shows a state of an array where there is an insulating substrate 1, on which there are gate electrodes 2, row wirings 2L, and a capacitor-connecting wiring 8C1, on which there is a gate insulating film 3, on which there is a semiconductor pattern 6, on which there are source electrodes 4, column wirings 4L, drain electrodes 5, drain-connecting wirings 5C, drain pads 5P, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C2 of the second electrically conductive layer is electrically connected to the capacitor-connecting wiring 8C1 of the first electrically conductive layer via apertures in the gate insulating film. The capacitor-connecting wirings 8C1 and 8C2 overlap with neither the row wirings 2L nor the column wirings 4L. In the state shown in Fig. 13(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 13(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 13(b) shows a state where an interlayer insulating film 7 is provided on the array in the state shown in Fig. 13(a), with capacitor electrodes 8, capacitor wirings 8L, and a capacitor-connecting wiring 8C3 being further provided thereon. In the state shown in Fig. 13(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C3, so that the capacitor wiring middle parts 8L serve as parts of the capacitor-connecting wiring 8C3, i.e., the capacitor wiring middle parts 8L and the capacitor-connecting wiring 8C3 serve as a capacitor-connecting wiring 8C3 overall. The capacitor wiring middle parts 8L are electrically connected to the capacitor-connecting wiring 8C2 of the second electrically conductive layer via apertures in the interlayer insulating film 7.

Fig. 13(c) shows a structure in which a capacitor insulating film 9 is provided on the array in the state shown in Fig. 13(b), with pixel electrodes 10 being further provided thereon. Each pixel electrode 10 is electrically connected to the corresponding drain pad 5P via an aperture in the capacitor insulating film 9 and an aperture in the interlayer insulating film 7. Since the pixel electrodes 10 in the (N/2)^{th} and (N/2+1)^{th} rows have overlaps with the capacitor-connecting wiring 8C3 and thus Cs increases accordingly, the capacitor electrodes 8 in the (N/2)^{th} and (N/2+1)^{th} rows may be made smaller, as shown in Fig. 13(b), than the capacitor electrodes 8 in other rows, to maintain Cs to be equivalent.

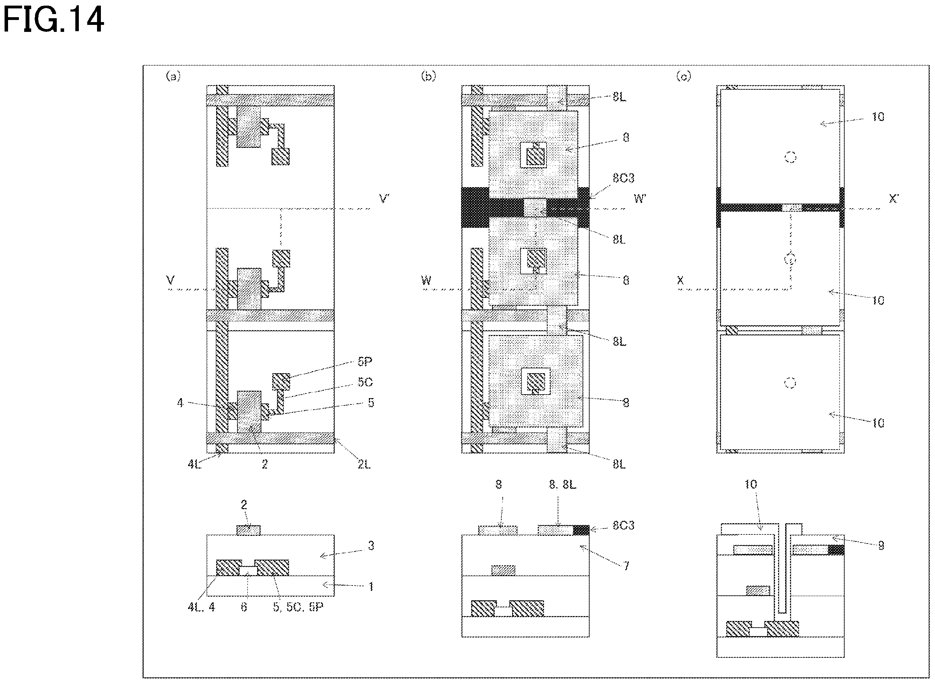

Figs. 14(a) to 20(c) each show a process of producing a thin film transistor array in which the TFTs include, as does the TFT shown in Fig. 4B, an insulating substrate 1 on which a first electrically conductive layer, a gate insulating film 3, a second electrically conductive layer, an interlayer insulating film 7, a third electrically conductive layer, a capacitor insulating film 9, and a fourth electrically conductive layer are provided in this order. The first electrically conductive layer includes source electrodes 4, column wirings 4L, and drain electrodes 5. The second electrically conductive layer includes gate electrodes 2, and row wirings 2L. The third electrically conductive layer includes capacitor electrodes 8, and capacitor wirings 8L. The fourth electrically conductive layer includes pixel electrodes 10. The upper plan views each show pixels in the (N/2)^{th}, (N/2+1)^{th} and (N/2+2)^{th} rows from the top of the effective region, and the lower cross-sectional views each show a cross section taken along the broken line of the corresponding plan view.

Fig. 14(a) shows a state of the array where there is the insulating substrate 1, on which there is a semiconductor pattern 6, on which there are the source electrodes 4, the column wirings 4L, the drain electrodes 5, drain-connecting wirings 5C, and drain pads 5P, on which there is the gate insulating film 3, on which there are the gate electrodes 2, and the row wirings 2L. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. In the state shown in Fig. 14(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 14(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 14(b) shows a state where the interlayer insulating film 7 is provided on the array in the state shown in Fig. 14(a), with capacitor electrodes 8, capacitor wirings 8L, and a capacitor-connecting wiring 8C3 being further provided thereon. In the state shown in Fig. 14(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C3, so that the capacitor wiring middle parts 8L serve as parts of the capacitor-connecting wiring 8C3, i.e., the capacitor wiring middle parts 8L and the capacitor-connecting wiring 8C3 serve as a capacitor-connecting wiring 8C3 overall. The capacitor-connecting wiring 8C3 overlaps with neither the row wirings 2L nor the column wirings 4L.

Fig. 14(c) shows a structure in which the capacitor insulating film 9 is provided on the array in the state shown in Fig. 14(b), with the pixel electrodes 10 being further provided thereon. Each pixel electrode 10 is electrically connected to the corresponding drain pad 5P via an aperture in the capacitor insulating film 9, an aperture in the interlayer insulating film 7, and an aperture in the gate insulating film 3. Since the pixel electrodes 10 in the (N/2)^{th} and (N/2+1)^{th} rows have overlaps with the capacitor-connecting wiring 8C3 and thus Cs increases accordingly, the capacitor electrodes 8 in the (N/2)^{th} and (N/2+1)^{th} rows may be made smaller, as shown in Fig. 14(b), than the capacitor electrodes 8 in other rows, to maintain Cs to be equivalent.

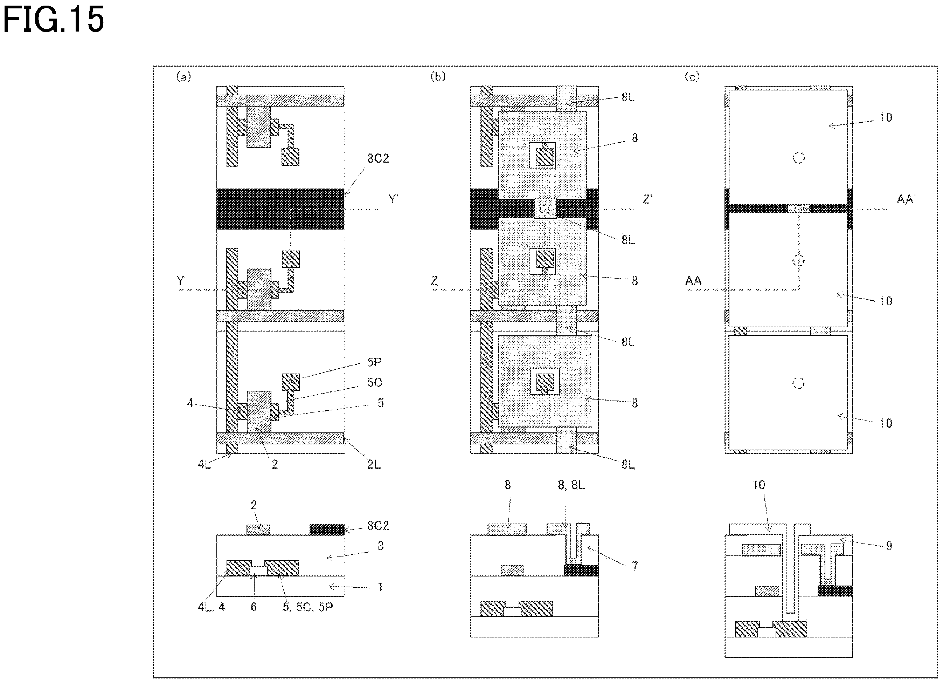

Fig. 15(a) shows a state of an array where there is an insulating substrate 1, on which there is a semiconductor pattern 6, on which there are source electrodes 4, column wirings 4L, drain electrodes 5, drain-connecting wirings 5C and drain pads 5P, on which there is a gate insulating film 3, on which there are gate electrodes 2, row wirings 2L, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C2 overlaps with neither the row wirings 2L nor the column wirings 4L. In the state shown in Fig. 15(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 15(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 15(b) shows a state where an interlayer insulating film 7 is provided on the array in the state shown in Fig. 15(a), with capacitor electrodes 8 and capacitor wirings 8L being further provided thereon. In the state shown in Fig. 15(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are electrically connected to the capacitor-connecting wiring 8C2 via apertures in the interlayer insulating film 7.

Fig. 15(c) shows a structure in which a capacitor insulating film 9 is provided on the array in the state shown in Fig. 15(b), with pixel electrodes 10 being further provided thereon. Each pixel electrode 10 is electrically connected to the corresponding drain pad 5P via an aperture in the capacitor insulating film 9, an aperture in the interlayer insulating film 7, and an aperture in the gate insulating film 3. Since the pixel electrodes 10 in the (N/2)^{th} and (N/2+1)^{th} rows have overlaps with the capacitor-connecting wiring 8C2 and thus Cs increases accordingly, the capacitor electrodes 8 in the (N/2)^{th} and (N/2+1)^{th} rows may be made smaller, as shown in Fig. 15(b), than the capacitor electrodes 8 in other rows, to maintain Cs to be equivalent.

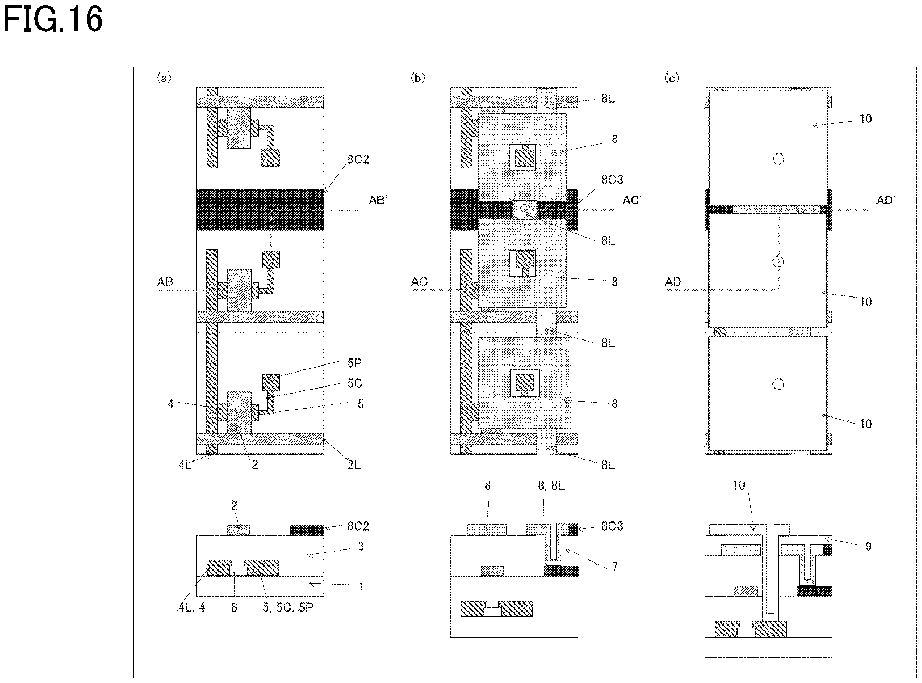

Fig. 16(a) shows a state of an array where there is an insulating substrate 1, on which there is a semiconductor pattern 6, on which there are source electrodes 4, column wirings 4L, drain electrodes 5, drain-connecting wirings 5C and drain pads 5P, on which there is a gate insulating film 3, on which there are gate electrodes 2, row wirings 2L, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C2 overlaps with neither the row wirings 2L nor the column wirings 4L. In the state shown in Fig. 16(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 16(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 16(b) shows a state where an interlayer insulating film 7 is provided on the array in the state shown in Fig. 16(a), with capacitor electrodes 8, capacitor wirings 8L, and a capacitor-connecting wiring 8C3 being further provided thereon. In the state shown in Fig. 16(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C3, so that the capacitor wiring middle parts 8L serve as parts of the capacitor-connecting wiring 8C3, i.e., the capacitor wiring middle parts 8L and the capacitor-connecting wiring 8C3 serve as a capacitor-connecting wiring 8C3 overall. The capacitor wiring middle parts 8L are electrically connected to the capacitor-connecting wiring 8C2 of the second electrically conductive layer via apertures in the interlayer insulating film 7.

Fig. 16(c) shows a structure in which a capacitor insulating film 9 is provided on the array in the state shown in Fig. 16(b), with pixel electrodes 10 being further provided thereon. Each pixel electrode 10 is electrically connected to the corresponding drain pad 5P via an aperture in the capacitor insulating film 9, an aperture in the interlayer insulating film 7, and an aperture in the gate insulating film 3. Since the pixel electrodes 10 in the (N/2)^{th} and (N/2+1)^{th} rows have overlaps with the capacitor-connecting wiring 8C3 and thus Cs increases accordingly, the capacitor electrodes 8 in the (N/2)^{th} and (N/2+1)^{th} rows may be made smaller, as shown in Fig. 16(b), than the capacitor electrodes 8 in other rows, to maintain Cs to be equivalent.

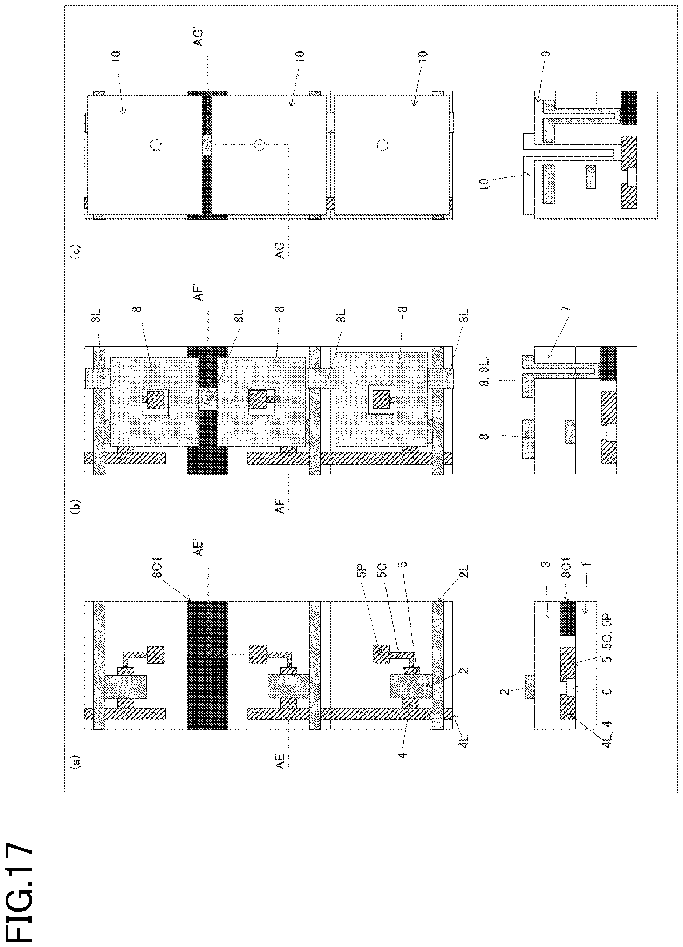

Fig. 17(a) shows a state of an array where there is an insulating substrate 1, on which there is a semiconductor pattern 6, on which there are source electrodes 4, column wirings 4L, drain electrodes 5, drain-connecting wirings 5C, drain pads 5P, and a capacitor-connecting wiring 8C1, on which there is a gate insulating film 3, on which there are gate electrodes 2, and row wirings 2L. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C1 overlaps with neither the row wirings 2L nor the column wirings 4L. In the state shown in Fig. 17(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 17(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 17(b) shows a state where an interlayer insulating film 7 is provided on the array in the state shown in Fig. 17(a), with capacitor electrodes 8 and capacitor wirings 8L being further provided thereon. In the state shown in Fig. 17(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are electrically connected to the capacitor-connecting wiring 8C1 of the first electrically conductive layer via apertures in the interlayer insulating film 7 and apertures in the gate insulating film 3.

Fig. 17(c) shows a structure in which a capacitor insulating film 9 is provided on the array in the state shown in Fig. 17(b), with pixel electrodes 10 being further provided thereon. Each pixel electrode 10 is electrically connected to the corresponding drain pad 5P via an aperture in the capacitor insulating film 9, an aperture in the interlayer insulating film 7, and an aperture in the gate insulating film 3. Since the pixel electrodes 10 in the (N/2)^{th} and (N/2+1)^{th} rows have overlaps with the capacitor-connecting wiring 8C1 and thus Cs increases accordingly, the capacitor electrodes 8 in the (N/2)^{th} and (N/2+1)^{th} rows may be made smaller, as shown in Fig. 17(b), than the capacitor electrodes 8 in other rows, to maintain Cs to be equivalent.

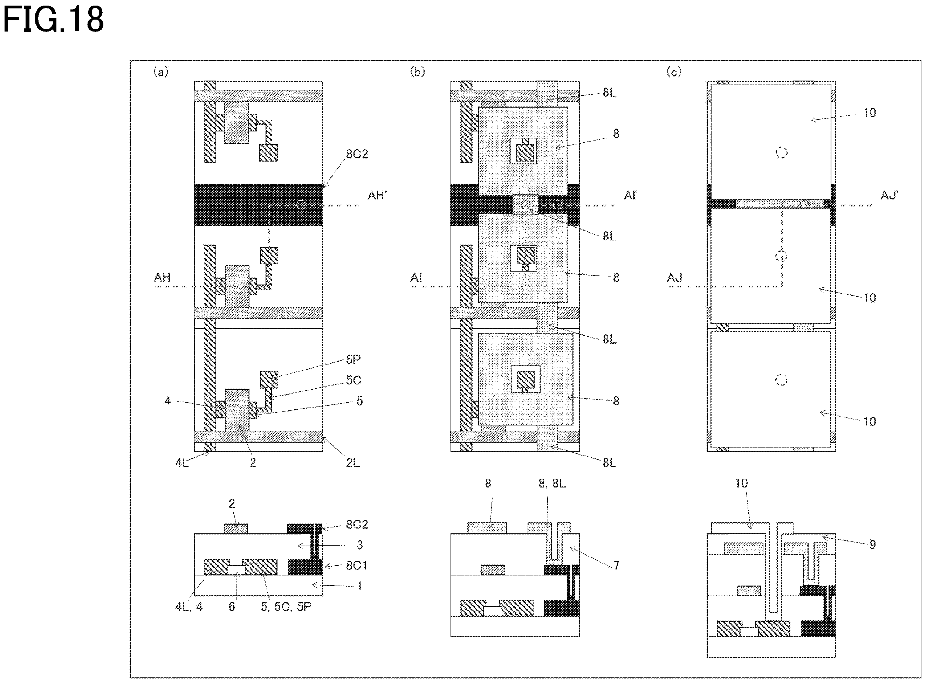

Fig. 18(a) shows a state of an array where there is an insulating substrate 1, on which there is a semiconductor pattern 6, on which there are source electrodes 4, column wirings 4L, drain electrodes 5, drain-connecting wirings 5C, drain pads 5P, and a capacitor-connecting wiring 8C1, on which there is a gate insulating film 3, on which there are gate electrodes 2, row wirings 2L, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C2 of the second electrically conductive layer is electrically connected to the capacitor-connecting wiring 8C1 of the first electrically conductive layer via apertures in the gate insulating film 3. The capacitor-connecting wirings 8C1 and 8C2 overlap with neither the row wirings 2L nor the column wirings 4L. In the state shown in Fig. 18(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 18(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 18(b) shows a state where an interlayer insulating film 7 is provided on the array in the state shown in Fig. 18(a), with capacitor electrodes 8 and capacitor wirings 8L being further provided thereon. In the state shown in Fig. 18(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are electrically connected to the capacitor-connecting wiring 8C2 via apertures in the interlayer insulating film 7.

Fig. 18(c) shows a structure in which a capacitor insulating film 9 is provided on the array in the state shown in Fig. 18(b), with pixel electrode 10 being further provided thereon. Each pixel electrode 10 is electrically connected to the corresponding drain pad 5P via an aperture in the capacitor insulating film 9, an aperture in the interlayer insulating film 7, and an aperture in the gate insulating film 3. Since the pixel electrodes 10 in the (N/2)^{th} and (N/2+1)^{th} rows have overlaps with the capacitor-connecting wiring 8C2 and thus Cs increases accordingly, the capacitor electrodes 8 in the (N/2)^{th} and (N/2+1)^{th} rows may be made smaller, as shown in Fig. 18(b), than the capacitor electrodes 8 in other rows, to maintain Cs to be equivalent.

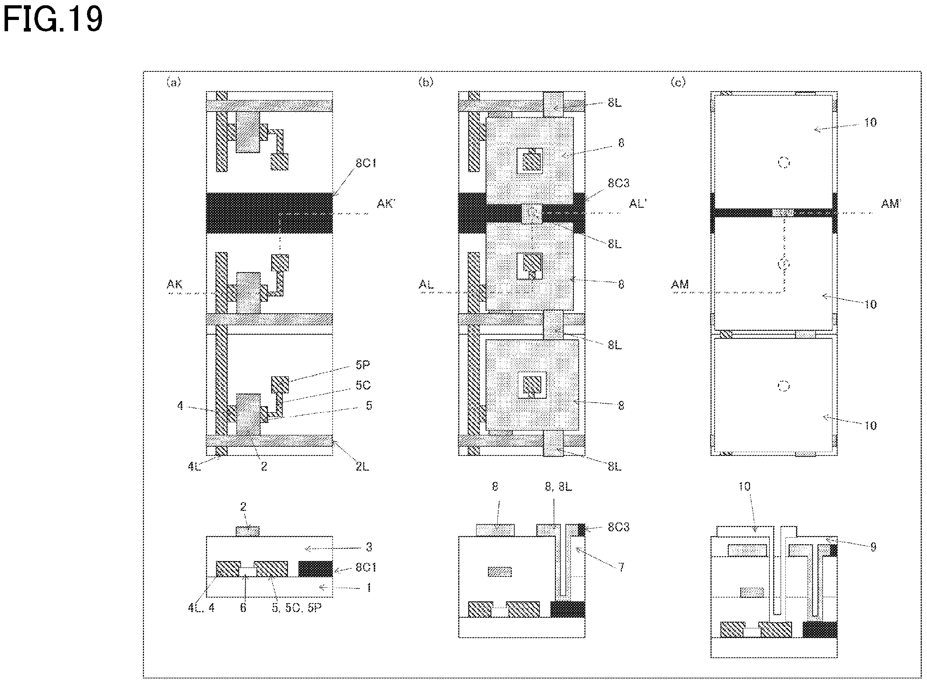

Fig. 19(a) shows a state of an array where there is an insulating substrate 1, on which there is a semiconductor pattern 6, on which there are source electrodes 4, column wirings 4L, drain electrodes 5, drain-connecting wirings 5C, drain pads 5P, and a capacitor-connecting wiring 8C1, on which there is a gate insulating film 3, on which there are gate electrodes 2, and row wirings 2L. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C1 overlaps with neither the row wirings 2L nor the column wirings 4L. In the state shown in Fig. 19(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 19(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 19(b) shows a state where an interlayer insulating film 7 is provided on the array in the state shown in Fig. 19(a), with capacitor electrodes 8, capacitor wirings 8L, and a capacitor-connecting wiring 8C3 being further provided thereon. In the state shown in Fig. 19(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C3, so that the capacitor wiring middle parts 8L serve as parts of the capacitor-connecting wiring 8C3, i.e., the capacitor wiring middle parts 8L and the capacitor-connecting wiring 8C3 serve as a capacitor-connecting wiring 8C3 overall. The capacitor wiring middle parts 8L are electrically connected to the capacitor-connecting wiring 8C1 of the first electrically conductive layer via apertures in the interlayer insulating film 7, and apertures in the gate insulating film 3. The capacitor-connecting wirings 8C1 and 8C3 overlap with neither the row wirings 2L nor the column wirings 4L.

Fig. 19(c) shows a structure in which a capacitor insulating film 9 is provided on the array in the state shown in Fig. 19(b), with pixel electrodes 10 being further provided thereon. Each pixel electrode 10 is electrically connected to the corresponding drain pad 5P via an aperture in the capacitor insulating film 9, an aperture in the interlayer insulating film 7, and an aperture in the gate insulating film 3. Since the pixel electrodes 10 in the (N/2)^{th} and (N/2+1)^{th} rows have overlaps with the capacitor-connecting wiring 8C3 and thus Cs increases accordingly, the capacitor electrodes 8 in the (N/2)^{th} and (N/2+1)^{th} rows may be made smaller, as shown in Fig. 19(b), than the capacitor electrodes 8 in other rows, to maintain Cs to be equivalent.

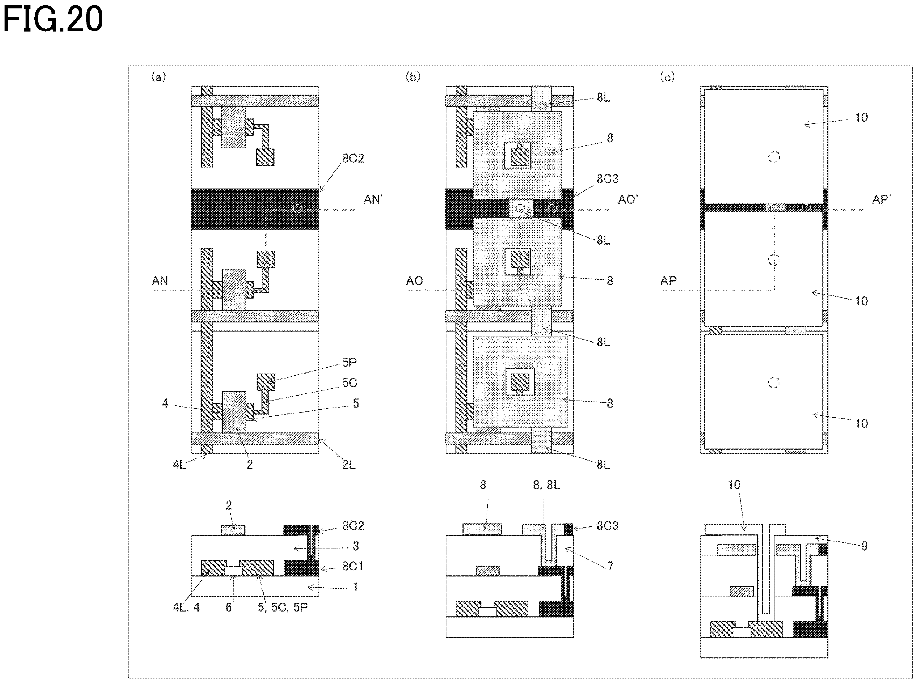

Fig. 20(a) shows a state of an array where there is an insulating substrate 1, on which there is a semiconductor pattern 6, on which there are source electrodes 4, column wirings 4L, drain electrodes 5, drain-connecting wirings 5C, drain pads 5P, and a capacitor-connecting wiring 8C1, on which there is a gate insulating film 3, on which there are gate electrodes 2, row wirings 2L, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. The capacitor-connecting wiring 8C2 of the second electrically conductive layer is electrically connected to the capacitor-connecting wiring 8C1 of the first electrically conductive layer via apertures in the gate insulating film. The capacitor-connecting wirings 8C1 and 8C2 overlap with neither the row wirings 2L nor the column wirings 4L. In the state shown in Fig. 20(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 20(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 20(b) shows a state where an interlayer insulating film 7 is provided on the array in the state shown in Fig. 20(a), with capacitor electrodes 8, capacitor wirings 8L, and a capacitor-connecting wiring 8C3 being further provided thereon. In the state shown in Fig. 20(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C3, so that the capacitor wiring middle parts 8L serve as parts of the capacitor-connecting wiring 8C3, i.e., the capacitor wiring middle parts 8L and the capacitor-connecting wiring 8C3 serve as a capacitor-connecting wiring 8C3 overall. The capacitor wiring middle parts 8L are electrically connected to the capacitor-connecting wiring 8C2 of the second electrically conductive layer via apertures in the interlayer insulating film 7.

Fig. 20(c) shows a structure in which a capacitor insulating film 9 is provided on the array in the state shown in Fig. 20(b), with pixel electrodes 10 being further provided thereon. Each pixel electrode 10 is electrically connected to the corresponding drain pad 5P via an aperture in the capacitor insulating film 9, an aperture in the interlayer insulating film 7, and an aperture in the gate insulating film 3. Since the pixel electrodes 10 in the (N/2)^{th} and (N/2+1)^{th} rows have overlaps with the capacitor-connecting wiring 8C3 and thus Cs increases accordingly, the capacitor electrodes 8 in the (N/2)^{th} and (N/2+1)^{th} rows may be made smaller, as shown in Fig. 13(b), than the capacitor electrodes 8 in other rows, to maintain Cs to be equivalent.

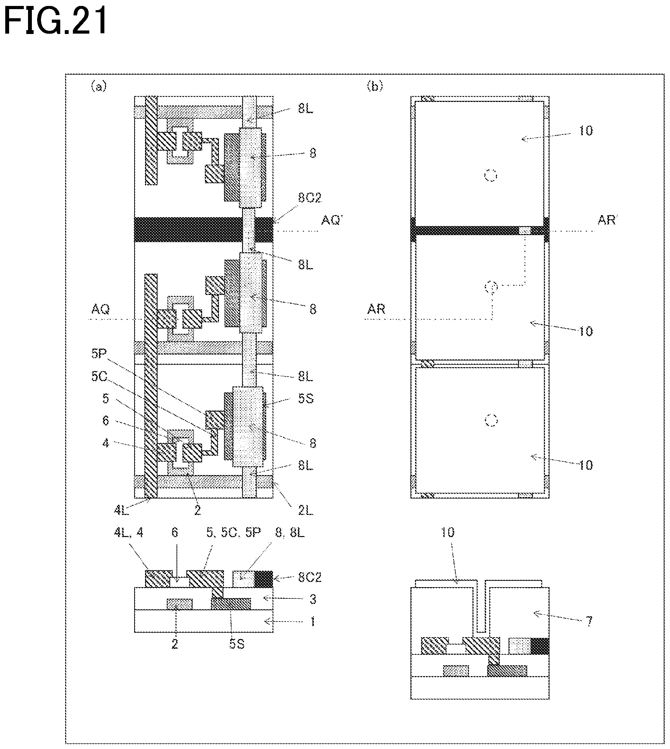

Figs. 21(a) to 23(b) each show a process of producing a thin film transistor array in which the TFTs include, as does the TFT shown in Fig. 4C, an insulating substrate 1 on which a first electrically conductive layer, a gate insulating film 3, a second electrically conductive layer, an interlayer insulating film 7, and a third electrically conductive layer are provided in this order. The first electrically conductive layer includes gate electrodes 2, row wirings 2L, and drain sub-electrodes 5S. The second electrically conductive layer includes source electrodes 4, column wirings 4L, drain electrodes 5, and capacitor electrodes 8. The third electrically conductive layer includes pixel electrodes 10. The upper plan views each show pixels in the (N/2)^{th}, (N/2+1)^{th} and (N/2+2)^{th} rows from the top of the effective region, and the lower cross-sectional views each show a cross section taken along the broken line of the corresponding plan view.

Fig. 21(a) shows a state of the array where there is the insulating substrate 1, on which there are gate the electrodes 2, the row wirings 2L, and drain sub-electrodes 5S, on which there is the gate insulating film 3, on which there is a semiconductor pattern 6, on which there are the source electrodes 4, the column wirings 4L, the drain electrodes 5, drain-connecting wirings 5C, drain pads 5P, the capacitor electrodes, 8, capacitor wirings 8L, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. Each drain electrode is connected to the corresponding drain sub-electrode 5S via an aperture in the gate insulating film 3, while the drain sub-electrode 5S has an overlap with the corresponding capacitor electrode 8 via the gate insulating film 3. In the state shown in Fig. 21(a), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C2, so that the capacitor wiring middle parts 8L serve as parts of the capacitor-connecting wiring 8C2, i.e., the capacitor wiring middle parts 8L and the capacitor-connecting wiring 8C2 serve as a capacitor-connecting wiring 8C2 overall. The capacitor-connecting wiring 8C2 overlaps with neither the row wirings 2L nor the column wirings 4L.

Fig. 21(b) shows a structure in which the interlayer insulating film 7 is provided on the array in the state shown in Fig. 21(a), with the pixel electrodes 10 being further provided thereon. Each pixel electrode 10 is electrically connected to the corresponding drain pad 5P via an aperture in the interlayer insulating film 7. Since the pixel electrodes 10 in the (N/2)^{th} and (N/2+1)^{th} rows have overlaps with the capacitor-connecting wiring 8C2 and thus Cs increases accordingly, the capacitor electrodes 8 in the (N/2)^{th} and (N/2+1)^{th} rows may be made smaller, as shown in Fig. 21(a), than the capacitor electrodes 8 in other rows, to maintain Cs to be equivalent.

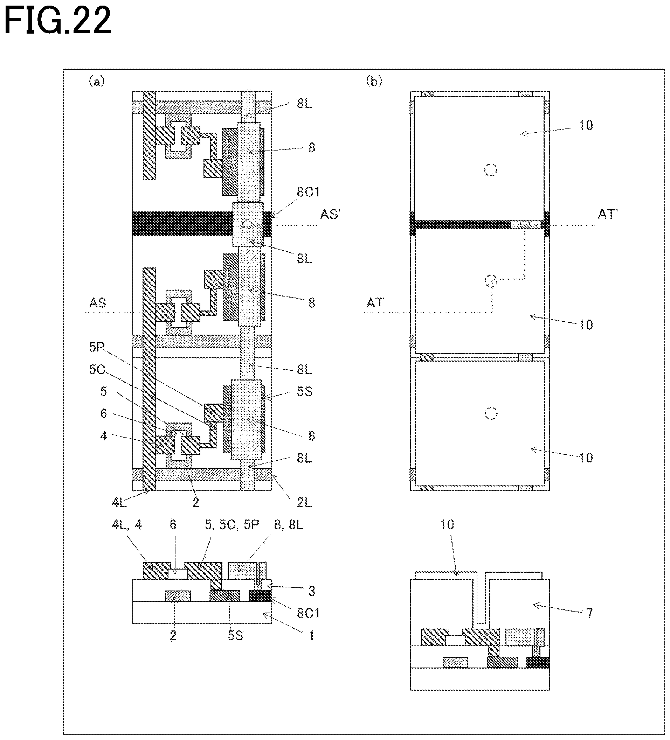

Fig. 22(a) shows a state of an array where there is an insulating substrate 1, on which there are gate electrodes 2, row wirings 2L, drain sub-electrodes 5S, and a capacitor-connecting wiring 8C1, on which there is a gate insulating film 3, on which there is a semiconductor pattern 6, on which there are source electrodes 4, column wirings 4L, drain electrodes 5, drain-connecting wirings 5C, and drain pads 5P. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+)^{th} row. The capacitor-connecting wiring 8C1 overlaps with neither the row wirings 2L nor the column wirings 4L. In the state shown in Fig. 22(a), a plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are electrically connected to the capacitor-connecting wiring 8C1 of the first electrically conductive layer via apertures in the gate insulating film 3.

Fig. 22(b) shows a structure in which an interlayer insulating film 7 is provided on the array in the state shown in Fig. 22(a), with pixel electrodes 10 being further provided thereon. Each pixel electrode 10 is electrically connected to the corresponding drain pad 5P via an aperture in the interlayer insulating film 7. Since the pixel electrodes 10 in the (N/2)^{th} and (N/2+1)^{th} rows have overlaps with the capacitor-connecting wiring 8C1 and thus Cs increases accordingly, the capacitor electrodes 8 in the (N/2)^{th} and (N/2+1)^{th} rows may be made smaller, as shown in Fig. 22(a), than the capacitor electrodes 8 in other rows, to maintain Cs to be equivalent.

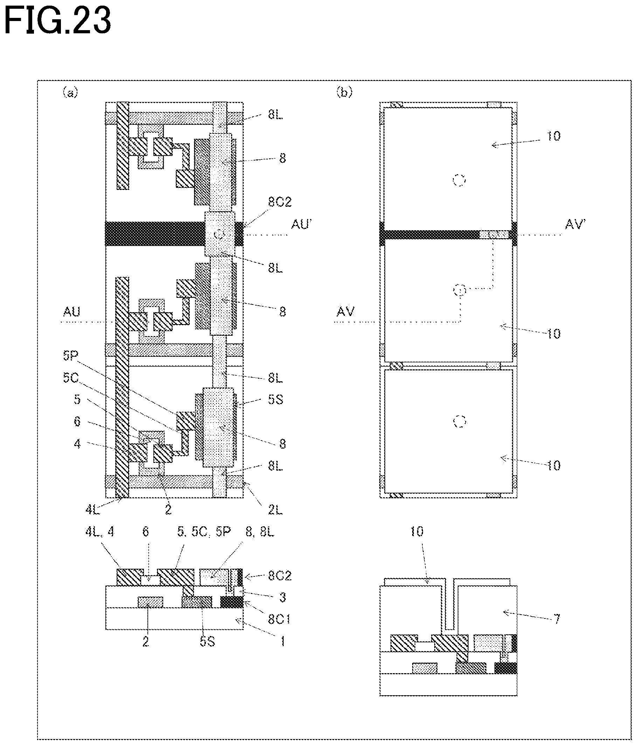

Fig. 23(a) shows a state of an array where there is an insulating substrate 1, on which there are gate electrodes 2, row wirings 2L, drain sub-electrodes 5S, and a capacitor-connecting wiring 8C1, on which there is a gate insulating film 3, on which there is a semiconductor pattern 6, on which there are source electrodes 4, column wirings 4L, drain electrodes 5, drain-connecting wirings 5C, drain pads 5P, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+1)^{th} row. In the state shown in Fig. 23(a), a plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C2, so that the capacitor wiring middle parts 8L serve as parts of the capacitor-connecting wiring 8C2, i.e., the capacitor wiring middle parts 8L and the capacitor-connecting wiring 8C2 serve as a capacitor-connecting wiring 8C2 overall. The capacitor wiring middle parts 8L are electrically connected to the capacitor-connecting wiring 8C1 of the first electrically conductive layer via apertures in the gate insulating film. The capacitor-connecting wirings 8C1 and 8C2 overlap with neither the row wirings 2L nor the column wirings 4L.

Fig. 23(b) shows a structure in which an interlayer insulating film 7 is provided on the array in the state shown in Fig. 23(a), with pixel electrodes 10 being further provided thereon. Each pixel electrode 10 is electrically connected to the corresponding drain pad 5P via an aperture in the interlayer insulating film 7. Since the pixel electrodes 10 in the (N/2)^{th} and (N/2+1)^{th} rows have overlaps with the capacitor-connecting wiring 8C2 and thus Cs increases accordingly, the capacitor electrodes 8 in the (N/2)^{th} and (N/2+1)^{th} rows may be made smaller, as shown in Fig. 23(a), than the capacitor electrodes 8 in other rows, to maintain Cs to be equivalent.

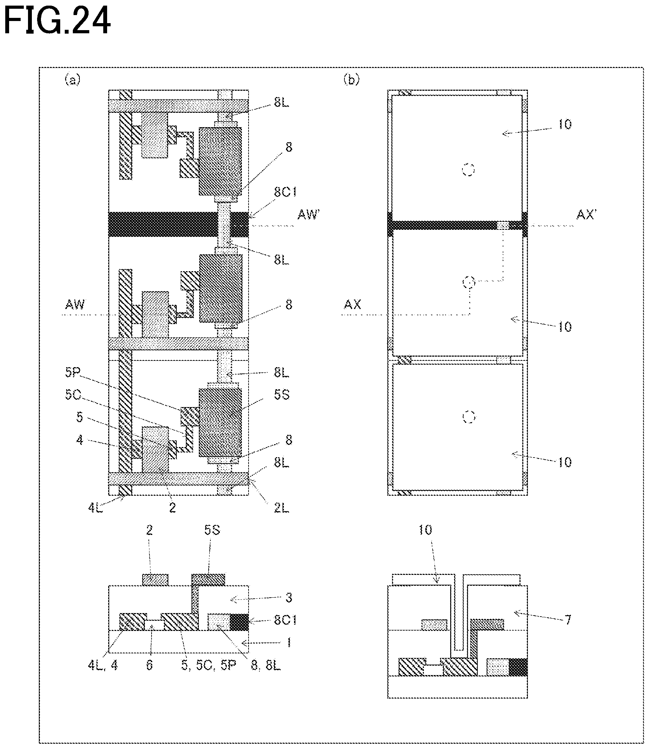

Figs. 24(a) to 26(b) each show a process of producing a thin film transistor array in which the TFTs include, as does the TFT shown in Fig. 4D, an insulating substrate 1 on which a first electrically conductive layer, a gate insulating film 3, a second electrically conductive layer, an interlayer insulating film 7, and a third electrically conductive layer are provided in this order. The first electrically conductive layer includes source electrodes 4, column wirings 4L, drain electrodes 5, and drain-connecting wiring electrodes 5C. The second electrically conductive layer includes gate electrodes 2, row wirings 2L, and drain sub-electrodes 5S. The third electrically conductive layer includes pixel electrodes 10. The upper plan views each show pixels in the (N/2)^{th}, (N/2+1)^{th} and (N/2+2)^{th} rows from the top of the effective region, and the lower cross-sectional views each show a cross section taken along the broken line of the corresponding plan view.

Fig. 24(a) shows a state of the array where there is the insulating substrate 1, on which there is a semiconductor pattern 6, on which there are the source electrodes 4, the column wirings 4L, the drain electrodes 5, the drain-connecting wirings 5C, drain pads 5P, capacitor electrodes 8, capacitor wirings 8L, and a capacitor-connecting wiring 8C1, on which there is the gate insulating film 3, on which there are the gate electrodes 2, the row wirings 2L, and the drain sub-electrodes 5S. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+)^{th} row. Each drain electrode is connected to the corresponding drain sub-electrode 5S via an aperture in the gate insulating film 3, while the drain sub-electrode 5S has an overlap with the corresponding capacitor electrode 8 via the gate insulating film 3. In the state shown in Fig. 24(a), a plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C1, so that the capacitor wiring middle parts 8L serve as parts of the capacitor-connecting wiring 8C1, i.e., the capacitor wiring middle parts 8L and the capacitor-connecting wiring 8C1 serve as a capacitor-connecting wiring 8C1 overall. The capacitor-connecting wiring 8C1 overlaps with neither the row wirings 2L nor the column wirings 4L.

Fig. 24(b) shows a structure in which the interlayer insulating film 7 is provided on the array in the state shown in Fig. 24(a), with the pixel electrodes 10 being further provided thereon. Each pixel electrode 10 is electrically connected to the corresponding drain pad 5P via an aperture in the interlayer insulating film 7 and an aperture in the gate insulating film 3. Since the pixel electrodes 10 in the (N/2)^{th} and (N/2+1)^{th} rows have overlaps with the capacitor-connecting wiring 8C1 and thus Cs increases accordingly, the capacitor electrodes 8 in the (N/2)^{th} and (N/2+)^{th} rows may be made smaller, as shown in Fig. 24(a), than the capacitor electrodes 8 in other rows, to maintain Cs to be equivalent.

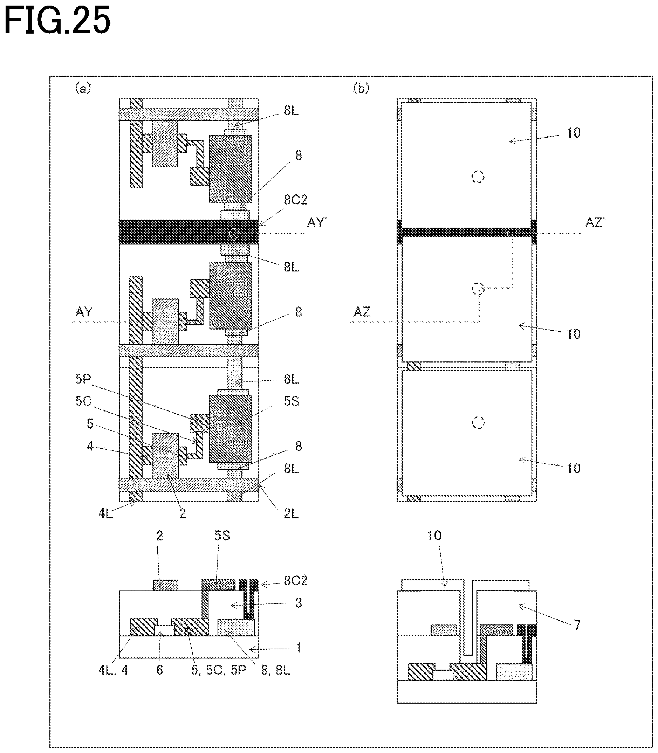

Fig. 25(a) shows a state of an array where there is an insulating substrate 1, on which there is a semiconductor pattern 6, on which there are source electrodes 4, column wirings 4L, drain electrodes 5, drain-connecting wirings 5C, and drain pads 5P, on which there is a gate insulating film 3, on which there are gate electrodes 2, row wirings 2L, drain sub-electrodes 5S, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+)^{th} row. The capacitor-connecting wiring 8C2 overlaps with neither the row wirings 2L nor the column wirings 4L. In the state shown in Fig. 25(a), a plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are electrically connected to the capacitor-connecting wiring 8C2 via apertures in the gate insulating film 3. The capacitor-connecting wiring 8C2 overlaps with neither the row wirings 2L nor the column wirings 4L.

Fig. 25(b) shows a structure in which an interlayer insulating film 7 is provided on the array in the state shown in Fig. 25(a), with pixel electrodes 10 being further provided thereon. Each pixel electrode 10 is electrically connected to the corresponding drain pad 5P via an aperture in the interlayer insulating film 7 and an aperture in the gate insulating film 3. Since the pixel electrodes 10 in the (N/2)^{th} and (N/2+1)^{th} rows have overlaps with the capacitor-connecting wiring 8C2 and thus Cs increases accordingly, the capacitor electrodes 8 in the (N/2)^{th} and (N/2+)^{th} rows may be made smaller, as shown in Fig. 25(a), than the capacitor electrodes 8 in other rows, to maintain Cs to be equivalent.

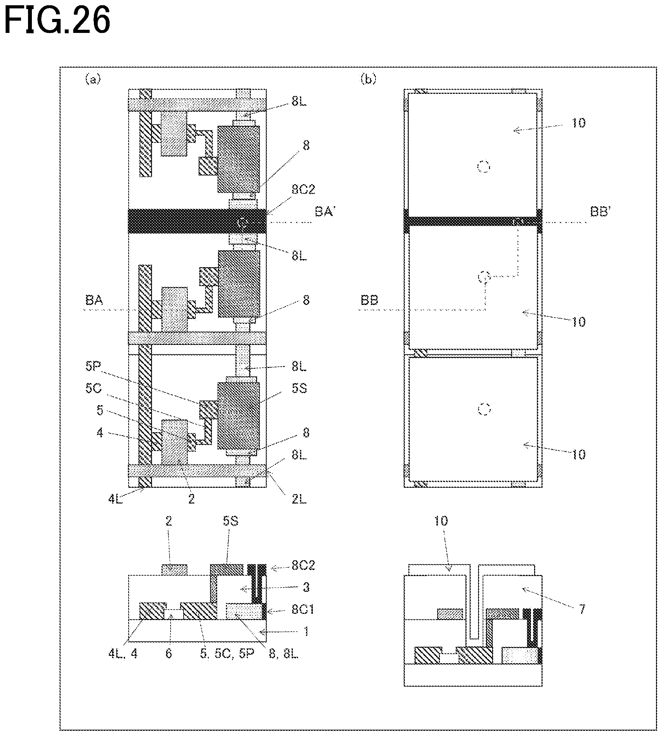

Fig. 26(a) shows a state of an array where there is an insulating substrate 1, on which there is a semiconductor pattern 6, on which there are source electrodes 4, column wirings 4L, drain electrodes 5, drain-connecting wirings 5C, drain pads 5P, and a capacitor-connecting wiring 8C1, on which there is a gate insulating film 3, on which there are gate electrodes 2, row wirings 2L, drain sub-electrodes 5S, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+)^{th} row. In the state shown in Fig. 26(a), a plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C1, so that the capacitor wiring middle parts 8L serve as parts of the capacitor-connecting wiring 8C1, i.e., the capacitor wiring middle parts 8L and the capacitor-connecting wiring 8C1 serve as a capacitor-connecting wiring 8C1 overall. The capacitor wiring middle parts 8L are electrically connected to the capacitor-connecting wiring 8C2 of the second electrically conductive layer via apertures in the gate insulating film. The capacitor-connecting wirings 8C1 and 8C2 overlap with neither the row wirings 2L nor the column wirings 4L.

Fig. 26(b) shows a structure in which an interlayer insulating film 7 is provided on the array in the state shown in Fig. 26(a), with pixel electrodes 10 being further provided thereon. Each pixel electrode 10 is electrically connected to the corresponding drain pad 5P via an aperture in the interlayer insulating film 7 and an aperture in the gate insulating film 3. Since the pixel electrodes 10 in the (N/2)^{th} and (N/2+1)^{th} rows have overlaps with the capacitor-connecting wiring 8C2 and thus Cs increases accordingly, the capacitor electrodes 8 in the (N/2)^{th} and (N/2+)^{th} rows may be made smaller, as shown in Fig. 26(a), than the capacitor electrodes 8 in other rows, to maintain Cs to be equivalent.

Examples of top contact in which source and drain electrodes 4 and 5 are provided above the semiconductor pattern 6 have been described above. However, bottom contact in which the source and drain electrodes 4 and 5 are provided below the semiconductor pattern 6 may be used, or coplanar arrangement in which the source and drain electrodes 4 and 5 are provided to the same layer as that of the semiconductor pattern 6 may be used.

Materials for the insulating substrate 1 may be inorganic materials such as glass, or organic materials such as polyethylene terephthalate (PET), polyethylene naphthalate (PEN), polyether sulfone (PES), polycarbonate, polyimide (PI), polyether imide (PEI), polystyrene (PS), polyvinyl chloride (PVC), polyethylene (PE), polypropylene (PP), nylon (Ny), and epoxy.

Materials for the first, second, third and fourth electrically conductive layers may be metals such as Al, Ag, Cu, Cr, Ni, Mo, Au, Pt and Nb, conductive oxides such as ITO, carbon, electrically conductive polymers, and the like. The first, second, third and fourth electrically conductive layers may be formed by printing and baking an ink, or by forming a film across a substrate by sputtering or the like, followed by photolithography, etching, and resist stripping. Alternatively, these layers may be formed by forming a film across a substrate by sputtering or the like, followed by resist-printing, etching, and resist stripping.

Materials for the gate insulating layer 3, the interlayer insulating film 7, and the capacitor insulating film 9 may be inorganic materials such as SiO₂, SiON and SiN, or organic materials such as polyvinyl phenol (PVP) and epoxy. The gate insulating layer 3, the interlayer insulating film 7, and the capacitor insulating film 9 may be formed by vacuum deposition such as sputtering or CVD, or by applying and baking a solution.

Materials for the semiconductor pattern 6 may be inorganic semiconductors such as amorphous Si and poly-Si, organic semiconductors such as polythiophene-, acene- or allylamine-based organic semiconductors, or oxide semiconductors such as In₂O₃-, Ga₂O₃-, ZnO-, SnO₂-, InGaZnO-, InGaSnO- or InSnZnO-based oxide semiconductors. The semiconductor pattern 6 may be formed by forming a film by plasma CVD or the like, followed by photolithography, etching, and resist stripping. Alternatively, the semiconductor 6 may be formed by printing and baking a solution, using ink jetting, a method using a dispenser, relief printing, or the like.

The structures shown in Figs. 5A to 5D double the required number of source driver output terminals 150, compared to the structure shown in Fig. 37 or 39. However, since the number of pixels assigned to each source driver output terminal 150 is halved, the electrical power consumption of the source driver will be less than doubled and will be substantially the same even when the number of the source driver output terminals 150 is doubled. Furthermore, the electrical power consumption of the source driver is smaller than the reduction in electrical power consumption of the wirings. Therefore, if the electrical power consumption of the source driver increases, the entire electrical power consumption decreases.

### (Details of second embodiment)

In the thin film transistor array according to the second embodiment, electrical power can be supplied by connecting gate feed lines 11 to first ends of at least a part of the plurality of row wirings 2L, by connecting first source feed lines 12 to first ends of the column wirings 4L formed in a first area of the two areas, on the opposite side to a second area of the two areas, by connecting second source feed lines 12 to first ends of the column wirings 4L formed in the second area, on the opposite side to the first area, and by connecting a capacitor feed line 13 to first and/or second ends of the capacitor wirings 8L. Furthermore, gate intermediate lines 11M may be connected to second ends of the row wirings 2L whose first ends are connected to the gate feed lines 11, so that electrical connection can be established, via the gate intermediate lines 11M, between the gate feed lines 11 and the row wirings 2L to which no gate feed lines 11 are connected.

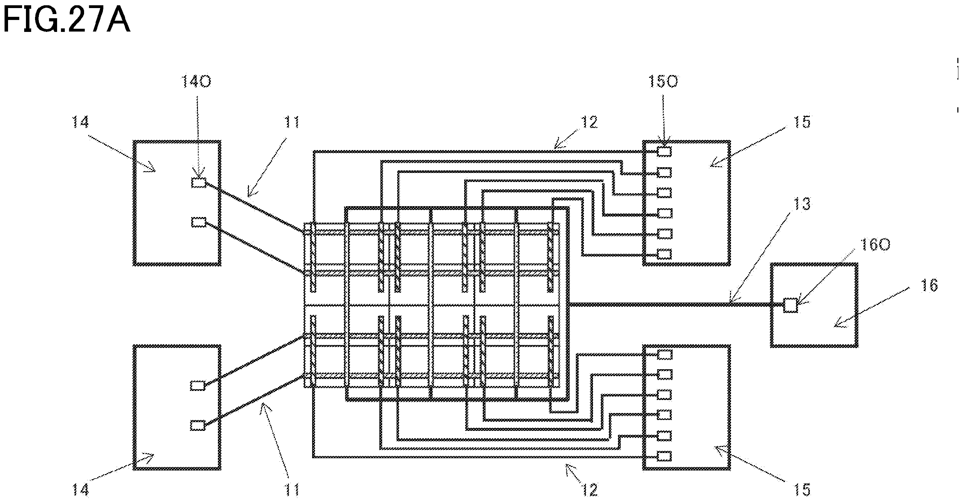

Specifically, in the structure shown in Fig. 2A, electrical power can be supplied, as in Fig. 27A, for example, by connecting gate feed lines 11 to left or right ends of the row wirings 2L, by connecting source feed lines 12 to upper ends of the upper area column wirings 4L, by connecting another set of feed lines 12 to lower ends of the lower area column wirings 4L, and by connecting a capacitor feed line 13 to upper and lower ends of the capacitor wirings 8L. The gate feed lines 11 are connected to respective output terminals 140 of a gate driver 14, the source feed lines 12 are connected to respective output terminals 150 of a source driver 15, and the capacitor feed line 13 is connected to a common electrode potential, or an output terminal 160 of a capacitor power supply 16, or a GND terminal. (The common electrode potential refers to a potential applied to counter electrodes in a display device with a structure in which a display medium is sandwiched between a thin film transistor array and a counter substrate including the counter electrodes. The common electrode potential is preferably used when the display medium is liquid crystal. When the display media are electrophoretic particles, a capacitor power potential, GND potential, or common electrode potential is preferably used.)

In the case of Fig. 27A, there is little overlap between wirings in a region outside the effective region, and thus electrical power consumption can be minimized in the region outside the effective region. In Fig. 27A, the wirings overlap only at intersections (2(M-1) points) between the source feed lines 12 and the capacitor feed line 13, outside the effective region. In Fig. 27A, input terminals of the gate driver 14, the source driver 15 and the capacitor power supply 16 are omitted. In Fig. 27A, two separate gate drivers 14 and two separate source drivers 15 are provided, however, the configuration is not limited to this. For example, one gate driver and two source drivers may be used, or one or two gate-source integrated drivers may be used.

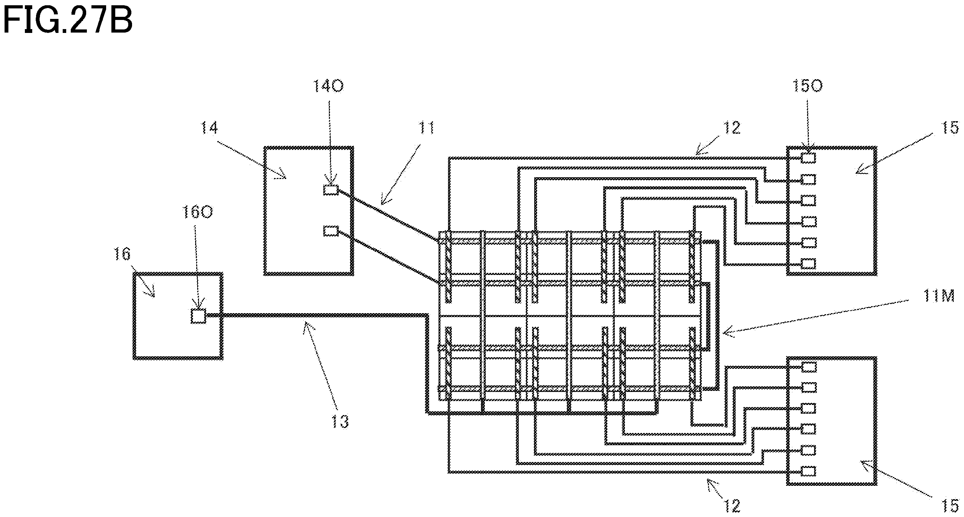

Alternatively, in the structure shown in Fig. 2A, as shown in Fig. 27B, for example, electrical power can be supplied with gate feed lines 11 being connected to first left or right ends of first upper or lower area row wirings 2L, with first ends of gate intermediate lines 11M being connected to second left or right ends of the first upper or lower area row wirings 2L, with second ends of the gate intermediate lines 11M being connected to left or right ends of second upper or lower area row wirings 2L, with source feed lines 12 being connected to upper ends of the upper area column wirings 4L, with another set of source feed lines 12 being connected to lower ends of the lower area column wirings 4L, and with a capacitor feed line 13 being connected to lower or upper ends of the capacitor wirings 8L. The gate feed lines 11 are connected to respective output terminals 140 of a gate driver 14, the source feed lines 12 are connected to respective output terminals 150 of a source driver 15, and the capacitor feed line 13 is connected to a common electrode potential, or an output terminal 160 of a capacitor power supply 16, or a GND terminal.

In this case, there is little overlap between wirings in a region outside the effective region, and thus electrical power consumption can be minimized in the region outside the effective region. In Fig. 27B, the wirings overlap only at intersections ((M-1) points) between the source feed lines 12 and the capacitor feed line 13, outside the effective region. In Fig. 27B, input terminals of the gate driver 14, the source driver 15 and the capacitor power supply 16 are omitted. In Fig. 27B, one gate driver 14 and two separate source drivers 15 are provided, however, the configuration is not limited to this. For example, one gate driver and one source driver may be used, or one gate-source integrated driver may be used.

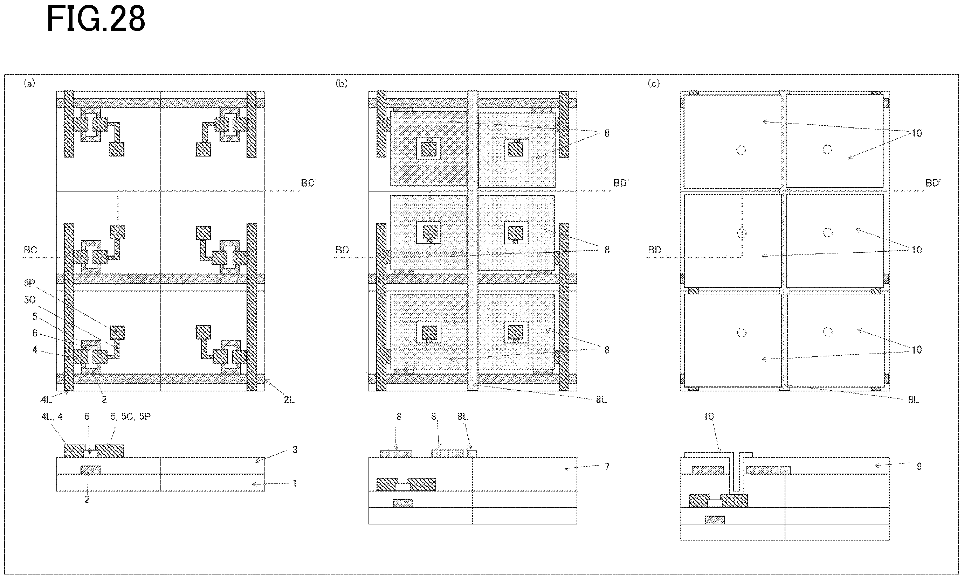

Figs. 28(a) to 28(c) each show a process of producing a thin film transistor array in which the TFTs include, as does the TFT shown in Fig. 27A, an insulating substrate 1 on which a first electrically conductive layer, a gate insulating film 3, a second electrically conductive layer, an interlayer insulating film 7, a third electrically conductive layer, a capacitor insulating film 9, and a fourth electrically conductive layer are provided in this order. The first electrically conductive layer includes gate electrodes 2 and row wirings 2L. The second electrically conductive layer includes source electrodes 4, column wirings 4L, and drain electrodes 5. The third electrically conductive layer includes capacitor electrodes 8, and capacitor wirings 8L. The fourth electrically conductive layer includes pixel electrodes 10. The upper plan views each show two columns of pixels in the (N/2)^{th}, (N/2+1)^{th} and (N/2+2)^{th} rows from the top of the effective region, and the lower cross-sectional views each show a cross section taken along the broken line of the corresponding plan view.

Fig. 28(a) shows a state of the array where there is the insulating substrate 1, on which there are the gate electrodes 2 and the row wirings 2L, on which there is the gate insulating film 3, on which there is the semiconductor pattern 6, on which there are the source electrodes 4, the column wirings 4L, the drain electrodes 5, and the drain pads 5P. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+)^{th} row. In the state shown in Fig. 28(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 28(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 28(b) shows a state where the interlayer insulating film 7 is provided on the array in the state shown in Fig. 28(a), with the capacitor electrodes 8 and the capacitor wirings 8L being further provided thereon. In the state shown in Fig. 28(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L.

Fig. 28(c) shows a structure in which the capacitor insulating film 9 is provided on the array in the state shown in Fig. 28(b), with the pixel electrodes 10 being further provided thereon. Each pixel electrode 10 is electrically connected to the corresponding drain pad 5P via an aperture in the capacitor insulating film 9 and an aperture in the interlayer insulating film 7.

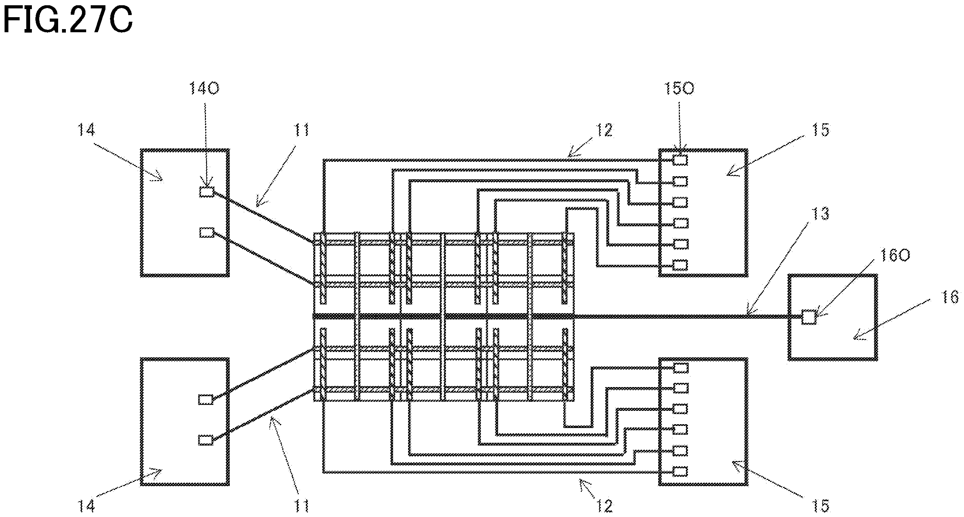

In the structure shown in Fig. 2B, electrical power can be supplied, as in Fig. 27C, for example, by connecting gate feed lines 11 to left or right ends of the row wirings 2L, by connecting source feed lines 12 to upper ends of the upper area column wirings 4L, by connecting another set of feed lines 12 to lower ends of the lower area column wirings 4L, and by connecting a capacitor feed line 13 to a left or right end of the capacitor-connecting wiring 8L. The gate feed lines 11 are connected to respective gate driver output terminals 140, the source feed lines 12 are connected to respective source driver output terminals 150, and the capacitor feed line 13 is connected to a common voltage output terminal, or a capacitor output terminal 160, or a GND terminal.

In this case, overlaps between wirings in a region outside the effective region can be completely eliminated, and thus electrical power consumption can be minimized in the region outside the effective region. In Fig. 27C, input terminals of the gate driver 14, the source driver 15 and the capacitor power supply 16 are omitted. In Fig. 27C, two separate gate drivers and two separate source drivers are provided, however, the configuration is not limited to this. For example, one gate driver and two source drivers may be used, or one or two gate-source integrated drivers may be used.

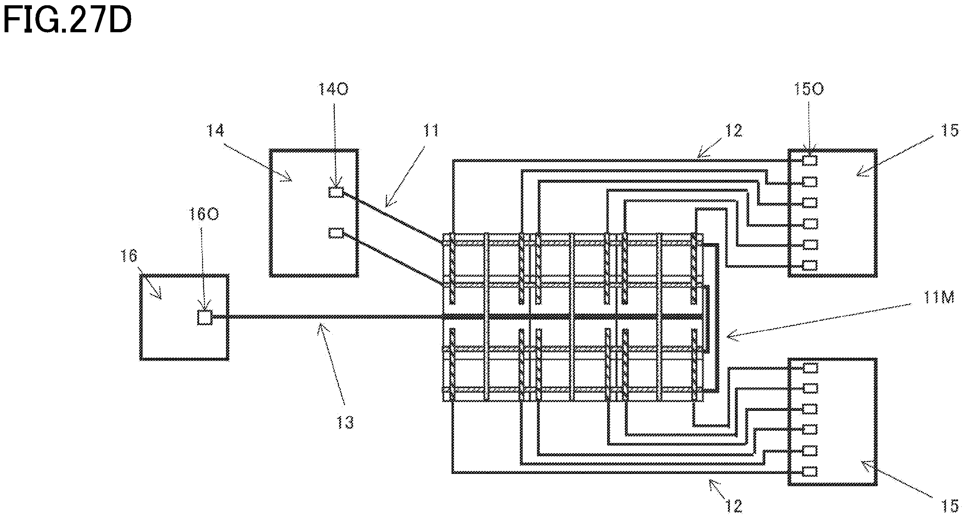

Alternatively, in the structure shown in Fig. 2B, as shown in Fig. 27D, electrical power can be supplied with gate feed lines 11 being connected to first left or right ends of first upper or lower area row wirings 2L, with first ends of gate intermediate lines 11M being connected to second left or right ends of the first upper or lower area row wirings 2L, with second ends of the gate intermediate lines 11M being connected to left or right ends of second upper or lower area, with source feed lines 12 being connected to upper ends of the upper area column wirings 4L, with another set of source feed lines 12 being connected to lower ends of the lower area column wirings 4L, and with a capacitor feed line 13 being connected to a left or right end of the capacitor-connecting wiring 8L. The gate feed lines 11 are connected to respective gate driver output terminals 140, the source feed lines 12 are connected to respective source driver output terminals 150, and the capacitor feed line 13 is connected to a common voltage output terminal, or a capacitor output terminal 160, or a GND terminal.

In this case, overlaps between wirings in a region outside the effective region can be completely eliminated, and thus electrical power consumption can be minimized in the region outside the effective region. In Fig. 27D, input terminals of the gate driver 14, the source driver 15 and the capacitor power supply 16 are omitted. In Fig. 27D, one gate driver and two separate source drivers are provided, however, the configuration is not limited to this. For example, one gate driver and one source driver may be used, or one gate-source integrated driver may be used.

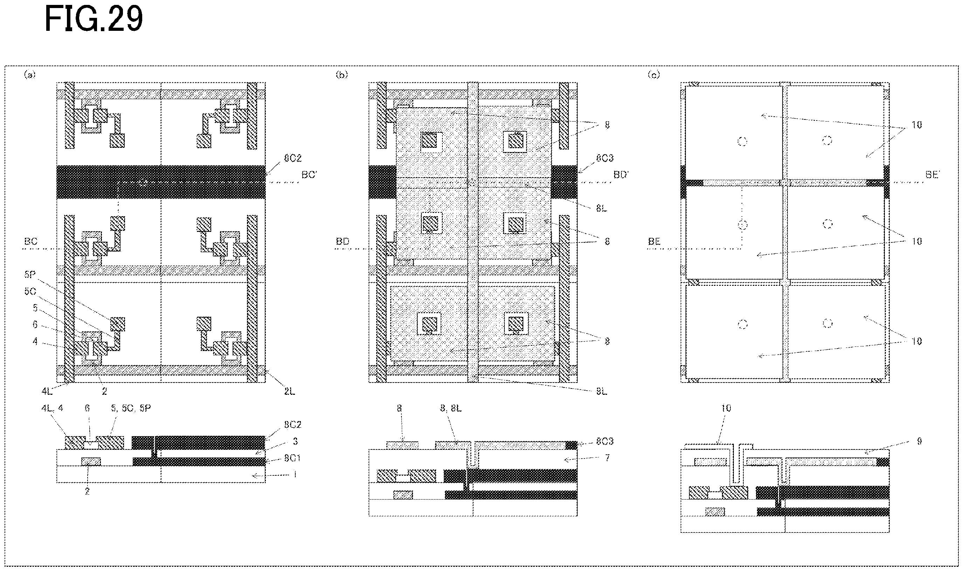

Figs. 29(a) to 29(c) each show a process of producing a thin film transistor array in which the TFTs include, as does the TFT shown in Fig. 4A, an insulating substrate 1 on which a first electrically conductive layer, a gate insulating film 3, a second electrically conductive layer, an interlayer insulating film 7, a third electrically conductive layer, a capacitor insulating film 9, and a fourth electrically conductive layer are provided in this order. The first electrically conductive layer includes gate electrodes 2, and row wirings 2L. The second electrically conductive layer includes source electrodes 4, column wirings 4L, and drain electrodes 5. The third electrically conductive layer includes capacitor electrodes 8, and capacitor wirings 8L. The fourth electrically conductive layer includes pixel electrodes 10. The upper plan views each show two columns of pixels in the (N/2)^{th}, (N/2+1)^{th} and (N/2+2)^{th} rows from the top of the effective region, and the lower cross-sectional views each show a cross section taken along the broken line of the corresponding plan view.

Fig. 29(a) shows a state of the array where there is the insulating substrate 1, on which there are the gate electrodes 2, the row wirings 2L, and a capacitor-connecting wiring 8C1, on which there is the gate insulating film 3, on which there is a semiconductor pattern 6, on which there are the source electrodes 4, the column wirings 4L, the drain electrodes 5, drain-connecting wirings 5C, drain pads 5P, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+)^{th} row. The capacitor-connecting wiring 8C2 of the second electrically conductive layer is electrically connected to the capacitor-connecting wiring 8C1 of the first electrically conductive layer via apertures in the gate insulating film 3. The capacitor-connecting wirings 8C1 and 8C2 overlap with neither the row wirings 2L nor the column wirings 4L. In the state shown in Fig. 29(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 29(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 29(b) shows a state where an interlayer insulating film 7 is provided on the array in the state shown in Fig. 29(a), with capacitor electrodes 8, capacitor wirings 8L, and a capacitor-connecting wiring 8C3 being further provided thereon. In the state shown in Fig. 29(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C3, so that the capacitor wiring middle parts 8L serve as parts of the capacitor-connecting wiring 8C3, i.e., the capacitor wiring middle parts 8L and the capacitor-connecting wiring 8C3 serve as a capacitor-connecting wiring 8C3 overall. The capacitor wiring middle parts 8L are electrically connected to the capacitor-connecting wiring 8C2 of the second electrically conductive layer via apertures in the interlayer insulating film 7.

Fig. 29(c) shows a structure in which a capacitor insulating film 9 is provided on the array in the state shown in Fig. 29(b), with pixel electrodes 10 being further provided thereon. Each pixel electrode 10 is electrically connected to the corresponding drain pad 5P via an aperture in the capacitor insulating film 9 and an aperture in the interlayer insulating film 7. Since the pixel electrodes 10 in the (N/2)^{th} and (N/2+1)^{th} rows have overlaps with the capacitor-connecting wiring 8C3 and thus Cs increases accordingly, the capacitor electrodes 8 in the (N/2)^{th} and (N/2+1)^{th} rows may be made smaller, as shown in Fig. 29(b), than the capacitor electrodes 8 in other rows, to maintain Cs to be equivalent.

Alternatively, as specifically shown in the first embodiment, the capacitor-connecting wiring 8C may be provided to one or two layers, i.e., the array may be provided with one or two of the capacitor-connecting wiring 8C1 of the first electrically conductive layer, the capacitor-connecting wiring 8C2 of the second electrically conductive layer, and the capacitor-connecting wiring 8C3 of the third electrically conductive layer. Furthermore, as in the TFT shown in Fig. 4B, the capacitor-connecting wiring 8C may be provided to a TFT array including a first electrically conductive layer, a gate insulating film 3, a second electrically conductive layer, an interlayer insulating film 7, a third electrically conductive layer, a capacitor insulating film 9, and a fourth electrically conductive layer in this order. In this case, the first electrically conductive layer includes source electrodes 4, column wirings 4L, and drain electrodes 5. The second electrically conductive layer includes gate electrodes 2, and row wirings 2L. The third electrically conductive layer includes capacitor electrodes 8, and capacitor wirings 8L. The fourth electrically conductive layer includes pixel electrodes 10. As in the TFT shown in Fig. 4C, the capacitor-connecting wiring 8C may be provided to a TFT array including a first electrically conductive layer, a gate insulating film 3, a second electrically conductive layer, an interlayer insulating film 7, and a third electrically conductive layer in this order. In this case, the first electrically conductive layer includes gate electrodes 2, row wirings 2L, and drain sub-electrodes 5S. The second electrically conductive layer includes source electrodes 4, column wirings 4L, drain electrodes 5, capacitor electrodes 8, and capacitor wirings 8L. The third electrically conductive layer includes pixel electrodes 10. As in the TFT shown in Fig. 4D, the capacitor-connecting wiring 8C may be provided to a TFT array including a first electrically conductive layer, a gate insulating film 3, a second electrically conductive layer, an interlayer insulating film 7, and a third electrically conductive layer in this order. In this case, the first electrically conductive layer includes source electrodes 4, column wirings 4L, drain electrodes 5, capacitor electrodes 8, and capacitor wirings 8L. The second electrically conductive layer includes gate electrodes 2, row wirings 2L, and drain sub-electrodes 5S. The third electrically conductive layer includes pixel electrodes 10.

Examples of top contact in which source and drain electrodes 4 and 5 are provided above the semiconductor pattern 6 have been described above. However, bottom contact in which the source and drain electrodes 4 and 5 are provided below the semiconductor pattern 6 may be used, or coplanar arrangement in which the source and drain electrodes 4 and 5 are provided to the same layer as that of the semiconductor pattern 6 may be used.

The thin film transistor array of the second embodiment can be formed using the same materials and the same method as those used for the thin film transistor array of the first embodiment.

The structures shown in Figs. 27A to 27D double the required number of source driver output terminals 150, compared to the structure shown in Fig. 37 or 39. However, since the number of pixels assigned to each source driver output terminal 150 is halved, the electrical power consumption of the source driver will be less than doubled and will be substantially the same even when the number of the source driver output terminals 150 is doubled. Furthermore, the electrical power consumption of the source driver is smaller than the reduction in electrical power consumption of the wirings. Therefore, if the electrical power consumption of the source driver increases, the entire electrical power consumption decreases.

### (Details of third embodiment)

In the thin film transistor array according to the third embodiment, electrical power can be supplied by connecting gate feed lines 11 to first ends of at least a part of the plurality of row wirings 2L, by connecting first source feed lines 12 to first ends of the column wirings 4L formed in a first area of the two areas, on the opposite side to a second area of the two areas, by connecting second source feed lines 12 to first ends of the column wirings 4L formed in the second area, on the opposite side to the first area, and by connecting a capacitor feed line 13 to first and/or second ends of the capacitor wirings 8L. Furthermore, gate intermediate lines 11M may be connected to second ends of the row wirings 2L whose first ends are connected to the gate feed lines 11, so that electrical connection can be established, via the gate intermediate lines 11M, between the gate feed lines 11 and the row wirings 2L to which no gate feed lines 11 are connected.

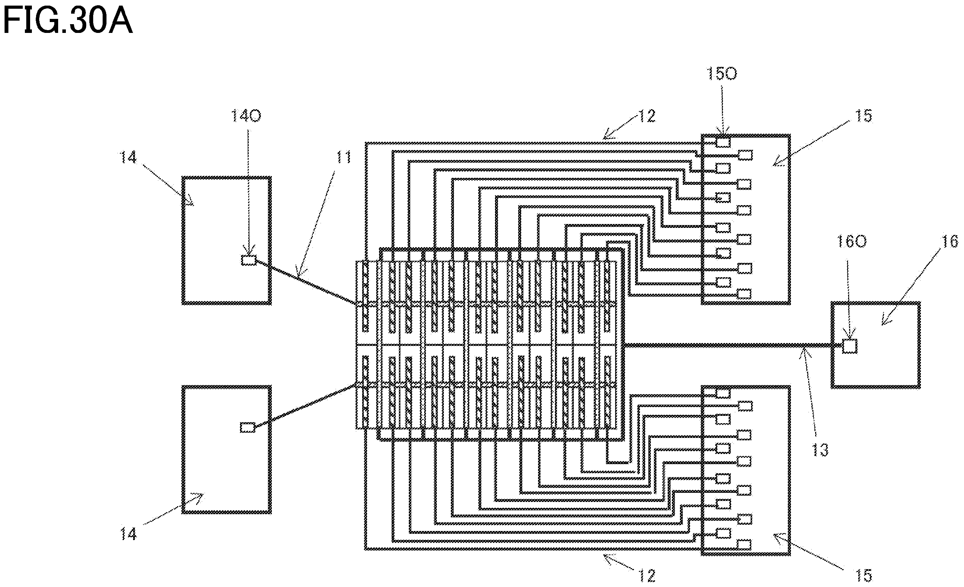

Specifically, in the structure shown in Fig. 3A, electrical power can be supplied, as in Fig. 30A, for example, by connecting gate feed lines 11 to left or right ends of the row wirings 2L, by connecting source feed lines 12 to upper ends of the upper area column wirings 4L, by connecting another set of feed lines 12 to lower ends of the lower area column wirings 4L, and by connecting a capacitor feed line 13 to upper and lower ends of the capacitor wirings 8L. The gate feed lines 11 are connected to respective output terminals 140 of a gate driver 14, the source feed lines 12 are connected to respective output terminals 150 of a source driver 15, and the capacitor feed line 13 is connected to a common electrode potential, or an output terminal 160 of a capacitor power supply 16, or a GND terminal. (The common electrode potential refers to a potential applied to counter electrodes in a display device with a structure in which a display medium is sandwiched between a thin film transistor array and a counter substrate including the counter electrodes. The common electrode potential is preferably used when the display medium is liquid crystal. When the display media are electrophoretic particles, a capacitor power potential, GND potential, or common electrode potential is preferably used.)

In the case of Fig. 30A, there is little overlap between wirings in a region outside the effective region, and thus electrical power consumption can be minimized in the region outside the effective region. In Fig. 30A, the wirings overlap only at intersections (4(M-2) points) between the source feed lines 12 and the capacitor feed line 13, outside the effective region. In Fig. 30A, input terminals of the gate driver 14, the source driver 15 and the capacitor power supply 16 are omitted. In Fig. 30A, two separate gate drivers 14 and two separate source drivers 15 are provided, however, the configuration is not limited to this. For example, one gate driver and two source drivers may be used, or one or two gate-source integrated drivers may be used.

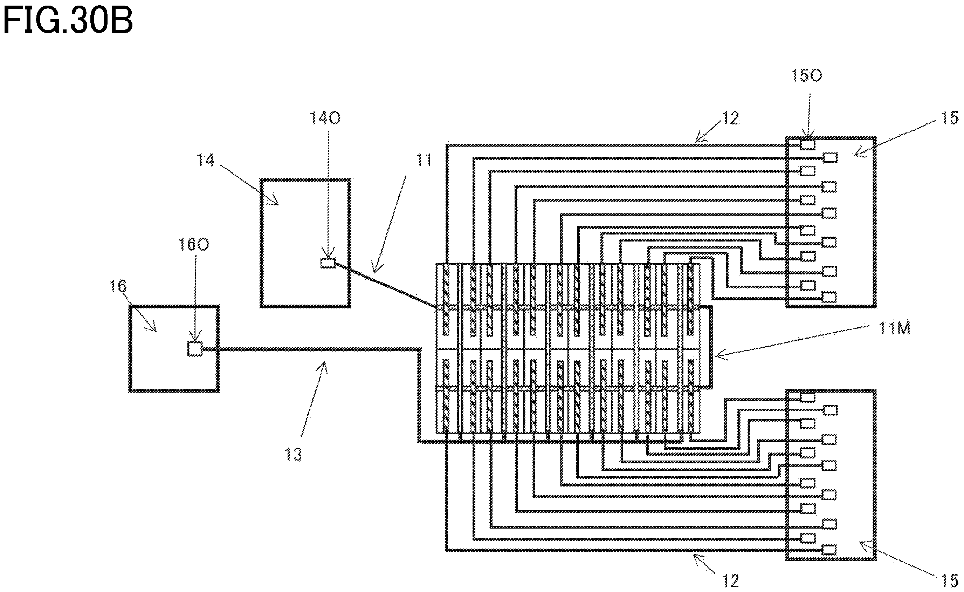

Alternatively, in the structure shown in Fig. 3A, as shown in Fig. 30B, for example, electrical power can be supplied with a gate feed line 11 being connected to a first left or right end of a first upper or lower area row wiring 2L, with a first end of a gate intermediate line 11M being connected to a second left or right end of the first upper or lower area row wiring 2L, with a second end of the gate intermediate line 11M being connected to a left or right end of a second upper or lower area row wiring 2L, with source feed lines 12 being connected to upper ends of the upper area column wirings 4L, with another set of source feed lines 12 being connected to lower ends of the lower area column wirings 4L, and with a capacitor feed line 13 being connected to lower or upper ends of the capacitor wirings 8L. The gate feed lines 11 are connected to respective output terminals 140 of a gate driver 14, the source feed lines 12 are connected to respective output terminals 150 of a source driver 15, and the capacitor feed line 13 is connected to a common electrode potential, or an output terminal 160 of a capacitor power supply 16, or a GND terminal.

In this case, there is little overlap between wirings in a region outside the effective region, and thus electrical power consumption can be minimized in the region outside the effective region. In Fig. 30B, the wirings overlap only at intersections ((2M-1) points) between the source feed lines 12 and the capacitor feed line 13, outside the effective region. In Fig. 30B, input terminals of the gate driver 14, the source driver 15 and the capacitor power supply 16 are omitted. In Fig. 30B, one gate driver 14 and two separate source drivers 15 are provided, however, the configuration is not limited to this. For example, one gate driver and one source driver may be used, or one gate-source integrated driver may be used.

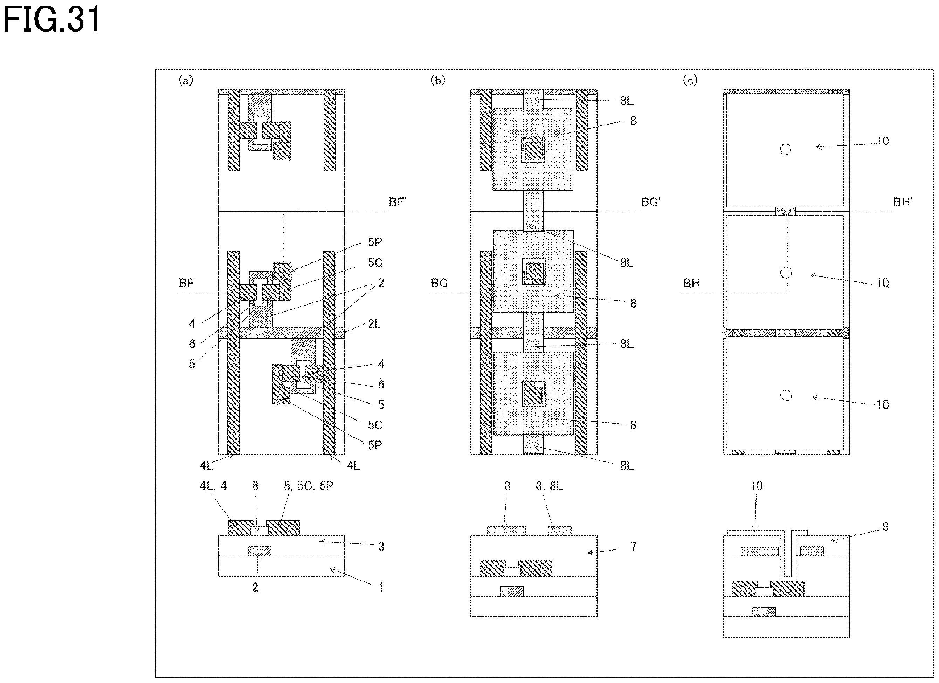

Figs. 31(a) to 31(c) each show a process of producing a thin film transistor array in which the TFTs include, as does the TFT shown in Fig. 4A, an insulating substrate 1 on which a first electrically conductive layer, a gate insulating film 3, a second electrically conductive layer, an interlayer insulating film 7, a third electrically conductive layer, a capacitor insulating film 9, and a fourth electrically conductive layer are provided in this order. The first electrically conductive layer includes gate electrodes 2, and row wirings 2L. The second electrically conductive layer includes source electrodes 4, column wirings 4L, and drain electrodes 5. The third electrically conductive layer includes capacitor electrodes 8, and capacitor wirings 8L. The fourth electrically conductive layer includes pixel electrodes 10. The upper plan views each show one column of pixels in the (N/2)^{th}, (N/2+1)^{th} and (N/2+2)^{th} rows from the top of the effective region, and the lower cross-sectional views each show a cross section taken along the broken line of the corresponding plan view.

Fig. 31(a) shows a state of the array where there is the insulating substrate 1, on which there are the gate electrodes 2 and the row wirings 2L, on which there is the gate insulating film 3, on which there is a semiconductor pattern 6, on which there are the source electrodes 4, the column wirings 4L, the drain electrodes 5, and drain pads 5P. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+)^{th} row. In the state shown in Fig. 31(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 31(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 31(b) shows a state where the interlayer insulating film 7 is provided on the array in the state shown in Fig. 31(a), with the capacitor electrodes 8 and the capacitor wirings 8L being further provided thereon. In the state shown in Fig. 31(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L.

Fig. 31(c) shows a structure in which the capacitor insulating film 9 is provided on the array in the state shown in Fig. 3 1(b), with the pixel electrodes 10 being further provided thereon. Each pixel electrode 10 is electrically connected to the corresponding drain pad 5P via an aperture in the capacitor insulating film 9 and an aperture in the interlayer insulating film 7.

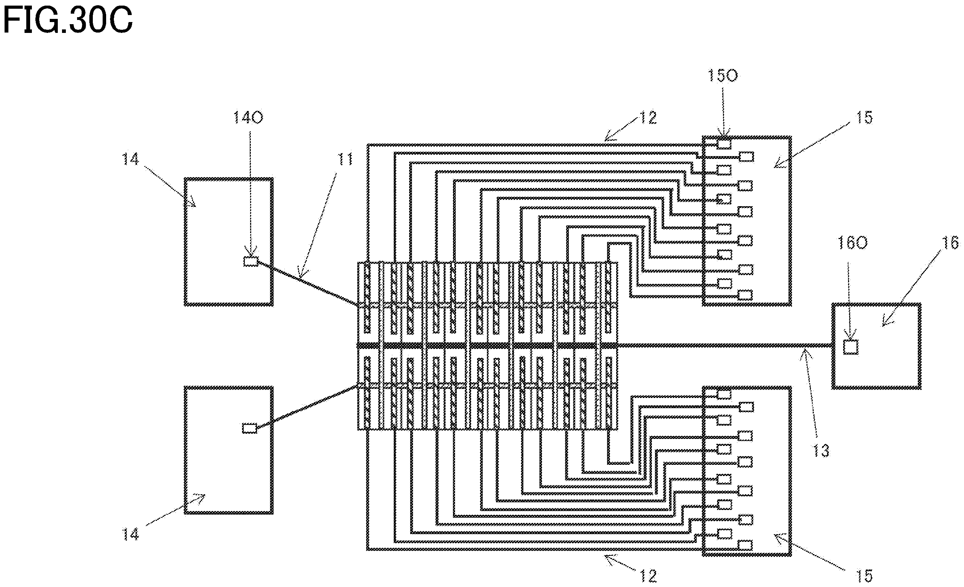

In the structure shown in Fig. 3B, electrical power can be supplied, as in Fig. 30C, with gate feed lines 11 being connected to left or right ends of the row wirings 2L, with source feed lines 12 being connected to upper ends of the upper area column wirings 4L, with another set of feed lines 12 being connected to lower ends of the lower area column wirings 4L, and with a capacitor feed line 13 being connected to a left or right end of the capacitor-connecting wiring 8L. The gate feed lines 11 are connected to respective gate driver output terminals 140, the source feed lines 12 are connected to respective source driver output terminals 150, and the capacitor feed line 13 is connected to a common voltage output terminal, or a capacitor output terminal 160, or a GND terminal.

In this case, overlaps between wirings in a region outside the effective region can be completely eliminated, and thus electrical power consumption can be minimized in the region outside the effective region. In Fig. 30C, input terminals of the gate driver 14, the source driver 15 and the capacitor power supply 16 are omitted. In Fig. 30C, two separate gate drivers and two separate source drivers are provided, however, the configuration is not limited to this. For example, one gate driver and two source drivers may be used, or one or two gate-source integrated drivers may be used.

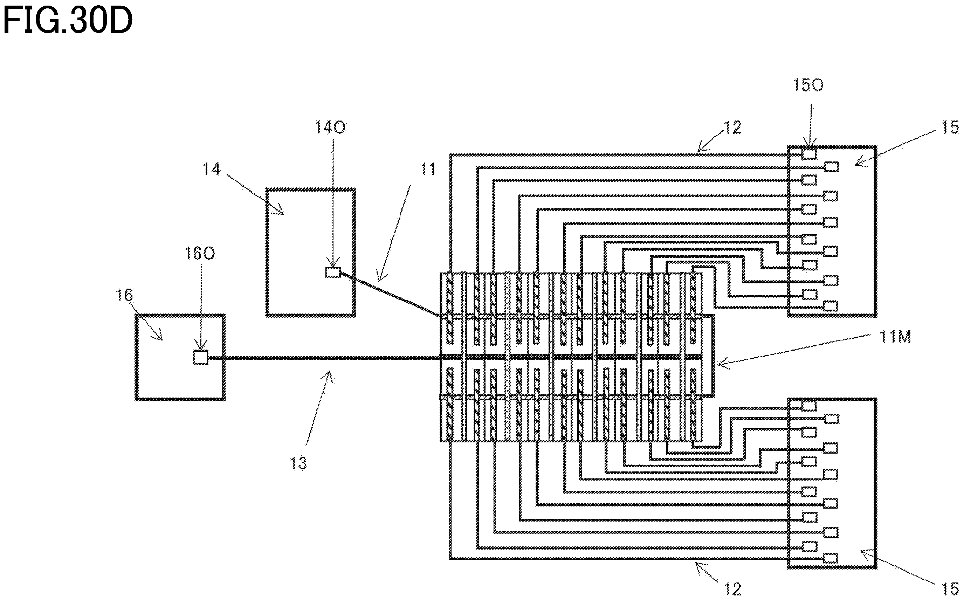

Alternatively, in the structure shown in Fig. 3B, as shown in Fig. 30D, electrical power can be supplied with a gate feed line 11 being connected to a first left or right end of a first upper or lower area row wiring 2L, with a first end of a gate intermediate line 11M being connected to a second left or right end of the first upper or lower area row wiring 2L, with a second end of the gate intermediate line 11M being connected to a left or right end of a second upper or lower area, with source feed lines 12 being connected to upper ends of the upper area column wirings 4L, with another set of source feed lines 12 being connected to lower ends of the lower area column wirings 4L, and with a capacitor feed line 13 being connected to a left or right end of the capacitor-connecting wiring 8L. The gate feed lines 11 are connected to respective gate driver output terminals 140, the source feed lines 12 are connected to respective source driver output terminals 150, and the capacitor feed line 13 is connected to a common voltage output terminal, or a capacitor output terminal 160, or a GND terminal.

In this case, overlaps between wirings in a region outside the effective region can be completely eliminated, and thus electrical power consumption can be minimized in the region outside the effective region. In Fig. 30D, input terminals of the gate driver 14, the source driver 15 and the capacitor power supply 16 are omitted. In Fig. 30D, one gate driver and two separate source drivers are provided, however, the configuration is not limited to this. For example, one gate driver and one source driver may be used, or one gate-source integrated driver may be used.

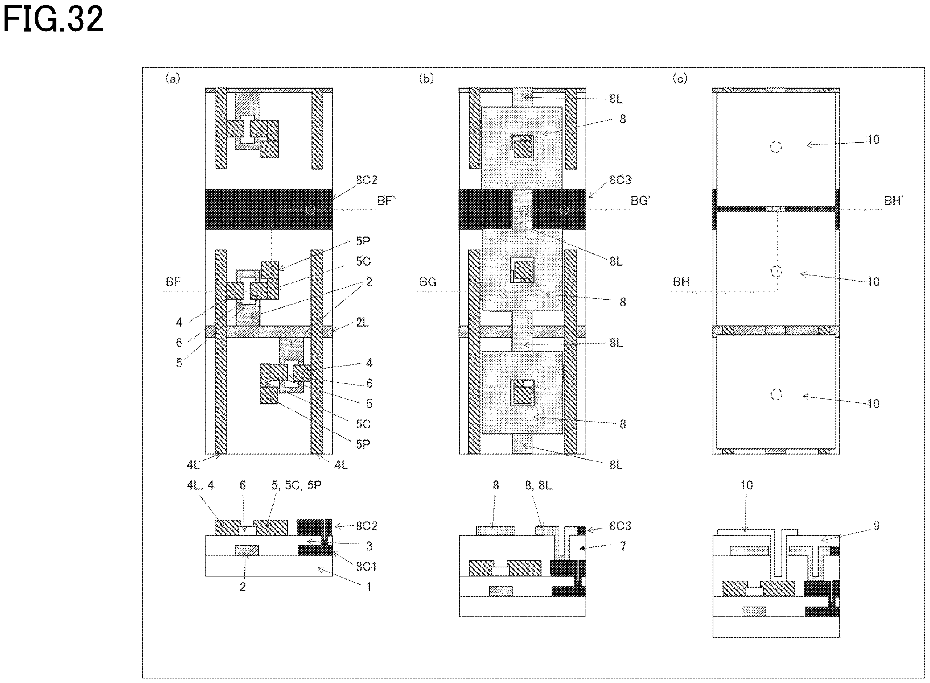

Figs. 32(a) to 32(c) each show a process of producing a thin film transistor array in which the TFTs include, as does the TFT shown in Fig. 4A, an insulating substrate 1 on which a first electrically conductive layer, a gate insulating film 3, a second electrically conductive layer, an interlayer insulating film 7, a third electrically conductive layer, a capacitor insulating film 9, and a fourth electrically conductive layer are provided in this order. The first electrically conductive layer includes gate electrodes 2, and row wirings 2L. The second electrically conductive layer includes source electrodes 4, column wirings 4L, and drain electrodes 5. The third electrically conductive layer includes capacitor electrodes 8, and capacitor wirings 8L. The fourth electrically conductive layer includes pixel electrodes 10. The upper plan views each show one column of pixels in the (N/2)^{th}, (N/2+1)^{th} and (N/2+2)^{th} rows from the top of the effective region, and the lower cross-sectional views each show a cross section taken along the broken line of the corresponding plan view.

Fig. 32(a) shows a state of the array where there is the insulating substrate 1, on which there are the gate electrodes 2, the row wirings 2L, and a capacitor-connecting wiring 8C1, on which there is the gate insulating film 3, on which there is a semiconductor pattern 6, on which there are the source electrodes 4,the column wirings 4L, the drain electrodes 5, drain-connecting wirings 5C, drain pads 5P, and a capacitor-connecting wiring 8C2. The row wirings 2L extend in the lateral direction. The column wirings 4L extend in the longitudinal direction. Each column wiring 4L in the upper area ends halfway through the pixels in the (N/2)^{th} row, and each column wiring 4L in the lower area ends halfway through the pixels in the (N/2+)^{th} row. The capacitor-connecting wiring 8C2 of the second electrically conductive layer is electrically connected to the capacitor-connecting wiring 8C1 of the first electrically conductive layer via apertures in the gate insulating film 3. The capacitor-connecting wirings 8C1 and 8C2 overlap with neither the row wirings 2L nor the column wirings 4L. In the state shown in Fig. 32(a), the gate electrodes 2 are branched from a continuous row wiring 2L. However, the plurality of gate electrodes 2 may be connected by a row wiring 2L, so that the gate electrodes 2 serve as parts of the row wiring 2L, i.e., the gate electrodes 2 and the row wiring 2L serve as serve as a row wiring 2L overall. In the state shown in Fig. 32(a), the source electrodes 4 are branched from a continuous column wiring 4L. However, the plurality of source electrodes 4 may be connected by a column wiring 4L, so that the source electrodes 4 serve as parts of the column wiring 4L, i.e., the source electrodes 4 and the column wiring 4L serve as a column wiring 4L overall.

Fig. 32(b) shows a state where the interlayer insulating film 7 is provided on the array in the state shown in Fig. 32(a), with the capacitor electrodes 8, the capacitor wirings 8L, and a capacitor-connecting wiring 8C3 being further provided thereon. In the state shown in Fig. 32(b), the plurality of capacitor electrodes 8 are connected by a capacitor wiring 8L, so that the capacitor electrodes 8 serve as parts of the capacitor wiring 8L, i.e., the capacitor electrodes 8 and the capacitor wiring 8L serve as a capacitor wiring overall. However, the capacitor electrodes 8 may be branched from a continuous capacitor wiring 8L. Capacitor electrodes 8 and a capacitor wiring 8L connecting therebetween, when the entirety thereof is taken to be a capacitor wiring, include capacitor wiring middle parts 8L. These capacitor wiring middle parts 8L are connected by a capacitor-connecting wiring 8C3, so that the capacitor wiring middle parts 8L serve as parts of the capacitor-connecting wiring 8C3, i.e., the capacitor wiring middle parts 8L and the capacitor-connecting wiring 8C3 serve as a capacitor-connecting wiring 8C3 overall. The capacitor wiring middle parts 8L are electrically connected to the capacitor-connecting wiring 8C2 of the second electrically conductive layer via apertures in the interlayer insulating film 7.

Fig. 32(c) shows a structure in which the capacitor insulating film 9 is provided on the array in the state shown in Fig. 32(b), with the pixel electrodes 10 being further provided thereon. Each pixel electrode 10 is electrically connected to the corresponding drain pad 5P via an aperture in the capacitor insulating film 9 and an aperture in the interlayer insulating film 7. Since the pixel electrodes 10 in the (N/2)^{th} and (N/2+)^{th} rows have overlaps with the capacitor-connecting wiring 8C3 and thus Cs increases accordingly, the capacitor electrodes 8 in the (N/2)^{th} and (N/2+1)^{th} rows may be made smaller, as shown in Fig. 32(b), than the capacitor electrodes 8 in other rows, to maintain Cs to be equivalent.

Alternatively, as specifically shown in the first embodiment, the capacitor-connecting wiring 8C may be provided to one or two layers, i.e., the array may be provided with one or two of the capacitor-connecting wiring 8C1 of the first electrically conductive layer, the capacitor-connecting wiring 8C2 of the second electrically conductive layer, and the capacitor-connecting wiring 8C3 of the third electrically conductive layer. Furthermore, as in the TFT shown in Fig. 4B, the capacitor-connecting wiring 8C may be provided to a TFT array including a first electrically conductive layer, a gate insulating film 3, a second electrically conductive layer, an interlayer insulating film 7, a third electrically conductive layer, a capacitor insulating film 9, and a fourth electrically conductive layer in this order. In this case, the first electrically conductive layer includes source electrodes 4, column wirings 4L, and drain electrodes 5. The second electrically conductive layer includes gate electrodes 2, and row wirings 2L. The third electrically conductive layer includes capacitor electrodes 8, and capacitor wirings 8L. The fourth electrically conductive layer includes pixel electrodes 10. As in the TFT shown in Fig. 4C, the capacitor-connecting wiring 8C may be provided to a TFT array including a first electrically conductive layer, a gate insulating film 3, a second electrically conductive layer, an interlayer insulating film 7, and a third electrically conductive layer in this order. In this case, the first electrically conductive layer includes gate electrodes 2, row wirings 2L, and drain sub-electrodes 5S. The second electrically conductive layer includes source electrodes 4, column wirings 4L, drain electrodes 5, capacitor electrodes 8, and capacitor wirings 8L. The third electrically conductive layer includes pixel electrodes 10. As in the TFT shown in Fig. 4D, the capacitor-connecting wiring 8C may be provided to a TFT array including a first electrically conductive layer, a gate insulating film 3, a second electrically conductive layer, an interlayer insulating film 7, and a third electrically conductive layer in this order. In this case, the first electrically conductive layer includes source electrodes 4, column wirings 4L, drain electrodes 5, capacitor electrodes 8, and capacitor wirings 8L. The second electrically conductive layer includes gate electrodes 2, row wirings 2L, and drain sub-electrodes 5S. The third electrically conductive layer includes pixel electrodes 10.

Examples of top contact in which source and drain electrodes 4 and 5 are provided above the semiconductor pattern 6 have been described above. However, bottom contact in which the source and drain electrodes 4 and 5 are provided below the semiconductor pattern 6 may be used, or coplanar arrangement in which the source and drain electrodes 4 and 5 are provided to the same layer as that of the semiconductor pattern 6 may be used.

The thin film transistor array of the third embodiment can also be formed using the same materials and the same method as those used for the thin film transistor array of the first embodiment.

The structures shown in Figs. 30A to 30D quadruple the required number of source driver output terminals 150, compared to the structure shown in Fig. 37 or 39. However, since the number of pixels assigned to each source driver output terminal 150 is reduced to a quarter, the electrical power consumption of the source driver will be less than quadrupled and will be substantially the same even when the number of the source driver output terminals 150 is quadrupled. Furthermore, the electrical power consumption of the source driver is smaller than the reduction in electrical power consumption of the wirings. Therefore, if the electrical power consumption of the source driver increases, the entire electrical power consumption decreases.

### [Examples]

### (Example 1)

TFTs as shown in Fig. 1B were prepared. The number of column wirings was 2M=690, and the number or row wirings was N/2=96. The connection shown in Fig. 5D was established. Using images of single-row stripes, writing of +15 V and writing of -15V were alternately performed row by row. The current waveform of the power supply of the source driver IC could be observed using a current probe of an oscilloscope (Infinivision DSO-X4024A manufactured by Keysight Technologies). An average current of the positive power supply during writing was 0.7 mA, while an average current of the negative power supply was -0.7 mA. Multiplying by the voltage ±15 V gave a power consumption of 21 mW in total, and multiplying by the frame time 20 ms gave a power consumption of 0.42 mJ per frame. This is the power consumption of the column wirings. The current waveform of the power supply of the gate driver IC was attempted to be observed using the current probe of the oscilloscope, however, it was too small to observe. In other words, the power consumption of the row wirings is smaller than the power consumption of the column wirings. Power consumption of the logic power supply of the driver IC was 0.06 mJ or less per frame.

### (Example 2)

TFTs as shown in Fig. 2B were prepared. The number of column wirings was 2M=690, and the number or row wirings was N/2=96. The connection shown in Fig. 27D was established. Using images of single-row stripes, writing of +15 V and writing of -15V were alternately performed row by row. The current waveform of the power supply of the source driver IC could be observed using a current probe of an oscilloscope. An average current of the positive power supply during writing was 0.7 mA, while an average current of the negative power supply was -0.7 mA. Multiplying by the voltage ±15 V gave a power consumption of 21 mW in total, and multiplying by the frame time 20 ms gave a power consumption of 0.42 mJ per frame. This is the power consumption of the column wirings. The current waveform of the power supply of the gate driver IC was attempted to be observed using the current probe of the oscilloscope, however, it was too small to observe. In other words, the power consumption of the row wirings is smaller than the power consumption of the column wirings. Power consumption of the logic power supply of the driver IC was 0.06 mJ or less per frame.

### (Example 3)

TFTs as shown in Fig. 3B were prepared. The number of column wirings was 4M=1,380, and the number or row wirings was N/4=48. The connection shown in Fig. 30D was established. Using images of single-row stripes, writing of +15 V and writing of -15V were alternately performed row by row. The current waveform of the power supply of the source driver IC could be observed using a current probe of an oscilloscope. An average current of the positive power supply during writing was 0.4 mA, while an average current of the negative power supply was -0.4 mA. Multiplying by the voltage ±15 V gave a power consumption of 12 mW in total, and multiplying by the frame time 20 ms gave a power consumption of 0.24 mJ per frame. This is the power consumption of the column wirings. The current waveform of the power supply of the gate driver IC was attempted to be observed using the current probe of the oscilloscope, however, it was too small to observe. In other words, the power consumption of the row wirings is smaller than the power consumption of the column wirings. Power consumption of the logic power supply of the driver IC was 0.06 mJ or less per frame.

In the above, measurements were carried out using the examples provided with capacitor-connecting wirings. However, the same results are obtained in embodiments in which no capacitor-connecting wirings are provided at the center of the effective region shown in Fig. 1A, 2A or 3A.

### (Comparative Example)

TFTs as shown in Fig. 38 were prepared. The number of column wirings was M=345, and the number or row wirings was N=192. The connection shown in Fig. 39 was established. Using images of single-row stripes, writing of +15 V and writing of -15V were alternately performed row by row. The current waveform of the power supply of the source driver IC could be observed using a current probe of an oscilloscope. An average current of the positive power supply during writing was 1.4 mA, while an average current of the negative power supply was -1.4 mA. Multiplying by the voltage ±15 V gave a power consumption of 42 mW in total, and multiplying by the frame time 20 ms gave a power consumption of 0.84 mJ per frame. This is the power consumption of the column wirings. The current waveform of the power supply of the gate driver IC was attempted to be observed using the current probe of the oscilloscope, however, it was too small to observe. In other words, the power consumption of the row wirings is smaller than the power consumption of the column wirings. Power consumption of the logic power supply of the driver IC was 0.06 mJ or less per frame.

### [Industrial Applicability]

The present invention can be used for display devices, such as electronic paper.

### [Reference Signs List]

- 1: Insulating substrate
- 2: Gate electrode
- 2L: Row wiring
- 3: Gate insulating film
- 4: Source electrode
- 4L: Column wiring
- 5: Drain electrode
- 5C: Drain-connecting wiring
- 5P: Drain pad
- 5S: Drain sub-electrode
- 6: Semiconductor pattern
- 6C: Channel
- 7: Interlayer insulating film
- 8: Capacitor electrode
- 8L: Capacitor wiring
- 8C: Capacitor-connecting wiring
- 8C1: Capacitor-connecting wiring (first electrically conductive layer)
- 8C2: Capacitor-connecting wiring (second electrically conductive layer)
- 8C3: Capacitor-connecting wiring (third electrically conductive layer)
- 9: Capacitor insulating film
- 10: Pixel electrode
- 11: Gate feed line
- 11M: Gate intermediate line
- 12: Source feed line
- 13: Capacitor feed line
- 14: Gate driver
- 140: Gate driver output terminal
- 15: Source driver
- 150: Source driver output terminal
- 16: Capacitor power supply
- 160: Capacitor voltage output terminal

## Claims

1. A thin film transistor array comprising:
an insulating substrate;
a plurality of column wirings extending in a first direction on the insulating substrate, a plurality of row wirings extending in a second direction that is perpendicular to the first direction, and a plurality of capacitor wirings extending in the first direction; and
a plurality of pixels arranged in a matrix in the first direction and the second direction, the pixels including respective thin film transistors, pixel electrodes, and capacitor electrodes, wherein
the plurality of pixels form a rectangular effective region of an M column by N row (M and M are natural numbers) matrix structure in which N pixels are arranged in the first direction and M pixels are arranged in the second direction;
the thin film transistors include respective gate electrodes, source electrodes, and drain electrodes;
the source electrodes are connected to the respective column wirings;
the gate electrodes are connected to the respective row wirings;
the drain electrodes are connected to the respective pixel electrodes;
the capacitor electrodes are connected to the respective capacitor wirings;
the row wirings each have a length extending across the M pixels arranged in the second direction in the effective region;
the column wirings each have a length extending across the N/2 pixels arranged in the first direction in the effective region; and
the capacitor wirings each have a length extending across the N pixels arranged in the first direction in the effective region, the length being different from the length of each of the column wirings.

2. The thin film transistor array according to claim 1, wherein
the thin film transistor array further comprises a capacitor-connecting wiring extending in the second direction; and
the capacitor-connecting wiring connects between all the plurality of capacitor wirings arranged in the second direction in the effective region, through midpoints in the overall length thereof to define two areas in the first direction in the effective region, the capacitor-connecting wiring having overlaps neither with the row wirings nor with the column wirings.

3. The thin film transistor array according to claim 1 or 2, wherein the M column by N row matrix of the effective region satisfies M≥N/2.

4. The thin film transistor array according to any one of claims 1 to 3, wherein the pixels adjacent to each other in the first direction have a constant pitch.

5. The thin film transistor array according to any one of claims 1 to 4, wherein
the column wirings are arranged at a ratio of one per column of the N/2 pixels arranged in the first direction, so that M column wirings are provided to each of the two areas, totaling 2M column wirings in the entire effective region;
the row wirings are arranged at a ratio of one per row of the M pixels arranged in the second direction, so that N/2 row wirings are provided to each of the two areas, totaling N row wirings in the entire effective region; and
the capacitor wirings are arranged at a ratio of one per column of the N pixels arranged in the first direction, so that M capacitor wirings are provided in the entire effective region.

6. The thin film transistor array according to any one of claims 1 to 4, wherein
the column wirings are arranged at a ratio of one per column of the N/2 pixels arranged in the first direction, so that M column wirings are provided to each of the two areas, totaling 2M column wirings in the entire effective region;
the row wirings are arranged at a ratio of one per row of the M pixels arranged in the second direction, so that N/2 row wirings are provided to each of the two areas, totaling N row wirings in the entire effective region; and
the capacitor wirings are arranged at a ratio of one per two columns of the N pixels arranged in the first direction, so that M/2 capacitor wirings are provided in the entire effective region.

7. The thin film transistor array according to any one of claims 1 to 4, wherein
the column wirings are arranged at a ratio of two per column of the N/2 pixels arranged in the first direction, so that 2M column wirings are provided to each of the two areas, totaling 4M column wirings in the entire effective region;
the row wirings are arranged at a ratio of one per two rows of the M pixels arranged in the second direction, so that N/4 row wirings are provided to each of the two areas, totaling N/2 row wirings in the entire effective region; and
the capacitor wirings are arranged at a ratio of one per column of the N pixels arranged in the first direction, so that M capacitor wirings are provided in the entire effective region.

8. The thin film transistor array according to any one of claims 1 to 7, wherein
at least a part of the plurality of row wirings has first ends to which gate feed lines are connected;
the column wirings formed in a first area of the two areas have first ends to which first source feed lines are connected on the opposite side to a second area of the two areas;
the column wirings formed in the second area of the two areas have first ends to which second source feed lines are connected on the opposite side to the first area of the two areas; and
the capacitor-connecting wiring has at least one end to which a capacitor feed line is connected.

9. The thin film transistor array according to claim 8, wherein the row wirings having the first ends to which the gate feed lines are connected have second ends to which gate intermediate lines are connected so that connection is established, via the gate intermediate lines, between the gate feed lines and the row wirings to which no gate feed lines are connected.

10. The thin film transistor array according to claim 8 or 9, wherein
the gate feed lines are connected to respective gate driver output terminals;
the source feed lines are connected to respective source driver output terminals; and
the capacitor feed line is connected to any one of a common voltage output terminal, a capacitor voltage output terminal, and a GND terminal.

11. The thin film transistor array according to any one of claims 1 to 10, wherein
the thin film transistor array sequentially comprises at least:
a layer including the gate electrodes, and the row wirings,
a gate insulating film,
a layer including the source electrodes, the column wirings, and the drain electrodes,
an interlayer insulating film,
a layer including the capacitor electrodes, and the capacitor wirings,
a capacitor insulating film, and
a layer including the pixel electrodes;
the capacitor-connecting wiring is present in at least any one of:
the layer including the capacitor electrodes, and the capacitor wirings,
the layer including the source electrodes, the column wirings, and the drain electrodes, and
the layer including the gate electrodes, and the row wirings; and
the capacitor connecting-line is connected to the capacitor wirings.

12. The thin film transistor array according to claim 11, wherein the capacitor-connecting wiring is connected to the capacitor wirings via apertures formed in at least either of the interlayer insulating film and the gate insulating film.

13. The thin film transistor array according to any one of claims 1 to 10, wherein
the thin film transistor array sequentially comprises at least:
a layer including the source electrodes, the column wirings, and the drain electrodes,
a gate insulating film,
a layer including the gate electrodes and the row wirings,
an interlayer insulating film,
a layer including the capacitor electrodes, and the capacitor wirings,
a capacitor insulating film, and
a layer including the pixel electrodes;
the capacitor-connecting wiring is present in at least any one of:
the layer including the capacitor electrodes, and the capacitor wirings,
the layer including the source electrodes, the column wirings, and the drain electrodes, and
the layer including the gate electrodes, and the row wirings; and
the capacitor connecting-line is connected to the capacitor wirings.

14. The thin film transistor array according to claim 13, wherein a capacitor-connecting wiring is connected to capacitor wirings via apertures formed in at least either of the interlayer insulating film and the gate insulating film.

15. The thin film transistor array according to any one of claims 1 to 10, wherein
the thin film transistor array sequentially comprises at least:
a layer including the gate electrodes, the row wirings, and drain sub-electrodes connected to the respective drain electrodes,
a gate insulating film,
a layer including the source electrodes, the column wirings, the drain electrodes, the capacitor electrodes, and the capacitor wirings,
an interlayer insulating film, and
a layer including the pixel electrodes;
the capacitor-connecting wiring is present in at least either one of:
the layer including the source electrodes, the column wirings, the drain electrodes, the capacitor electrodes, and the capacitor wirings, and
the layer including the gate electrodes, the row wirings, and the drain sub-electrodes; and
the capacitor connecting-line is connected to the capacitor wirings.

16. The thin film transistor array according to claim 15, wherein the capacitor-connecting wiring is connected to the capacitor wirings via apertures formed in the gate insulating film.

17. The thin film transistor array according to any one of claims 1 to 10, wherein
the thin film transistor array sequentially comprises at least:
a layer including the source electrodes, the column wirings, the drain electrodes, the capacitor electrodes, and the capacitor wirings,
a gate insulating film,
a layer including the gate electrodes, the row wirings, and drain sub-electrodes connected to the respective drain electrodes,
an interlayer insulating film, and
a layer including the pixel electrodes;
the capacitor-connecting wiring is present in at least either of:
the layer including the source electrodes, the column wirings, the drain electrodes, the capacitor electrodes, and the capacitor wirings, and
the layer including the gate electrodes, the row wirings, and the drain sub-electrodes; and
the capacitor connecting-line is connected to the capacitor wirings.

18. The thin film transistor array according to claim 17, wherein the capacitor-connecting wiring is connected to the capacitor wirings via apertures formed in the gate insulating film.
